# EUROPEAN PATENT SPECIFICATION

(11) **EP 4 362 647 B1**
(45) Date of publication and mention of the grant of the patent: **26.11.2025**
(21) Application number: 23206424.6
(22) Date of filing: 27.10.2023
(51) Int. Cl.: H10K 85/60, H10K 50/16

(54) **LIGHT EMITTING DEVICE AND DISPLAY DEVICE INCLUDING THE SAME**
LICHTEMITTIERENDE VORRICHTUNG UND ANZEIGEVORRICHTUNG DAMIT
DISPOSITIF ÉLECTROLUMINESCENT ET DISPOSITIF D'AFFICHAGE LE COMPRENANT

(30) Priority: 31.10.2022 KR 20220142048
(43) Date of publication of application: 01.05.2024
(60) Divisional application: 25209225.9
(73) Proprietor: Samsung Display Co., Ltd., Yongin-si, Gyeonggi-do 17113 (KR)
(72) Inventor: HUR, Jaeweon, Yongin-si 17113 (KR); KO, Heejoo, Yongin-si 17113 (KR); SUN, Jin-Won, Yongin-si 17113 (KR); SOHN, Yoojin, Yongin-si 17113 (KR); SONG, Eunhye, Yongin-si 17113 (KR); JEON, Pyungeun, Yongin-si 17113 (KR); CHU, Changwoong, Yongin-si 17113 (KR)
(74) Representative: Crow, Martin

(56) References cited:
- KR-A- 20200 145 762
- US-A1- 2018 040 843
- US-A1- 2022 336 755

## Description

This application claims priority to and the benefit of Korean Patent Application No. 10-2022-0142048, filed on October 31, 2022.

### BACKGROUND

One or more aspects of embodiments of the present disclosure relate to a light emitting device and a display device comprising the same, for example, a light emitting device with improved light emitting efficiency and device lifespan, and a display device comprising the light emitting device.

Recently, the development of organic electroluminescence display (OLED) devices to be utilized as an image display device has been actively conducted. An organic electroluminescence display device is unlike a liquid crystal display device and/or the like because the OLED is a self-luminescence display device. For example, the OLED device realizes display of images by recombining holes and electrons injected from a first electrode and a second electrode in a light emitting layer that comprises a light emitting material comprising an organic compound which is configured to emit light from the light emitting layer. An OLED comprising an electron transport layer with a mixture of a triazine derivative and a phenanthroline derivative is disclosed in US2022/336755.

Implementation of the organic electroluminescence device in a display device requires (or there is a desire) that the OLED possess a high light emitting efficiency and a long lifespan. Therefore, the need exists for development of a material for a light emitting device which is capable of stably (or suitably) implementing these two properties. For example, in an effort to implement a light emitting device having high efficiency and long lifespan, the development of materials for an electron transport region and having excellent or suitable electron transport properties and stability is being pursued.

### SUMMARY

One or more aspects of embodiments of the present disclosure are directed toward a light emitting device with improved light emitting efficiency and device lifespan.

One or more aspects of embodiments of the present disclosure are directed toward a display device comprising a light emitting device with improved light emitting efficiency and device lifespan.

The invention concerns a light emitting device comprising a first electrode, a hole transport region on the first electrode, a light emitting layer on the hole transport region, an electron transport region on the light emitting layer, and a second electrode on the electron transport region, wherein the electron transport region comprises a mixed layer comprising a first compound represented by Formula 1 and a second compound different from the first compound and represented by Formula 2.2.

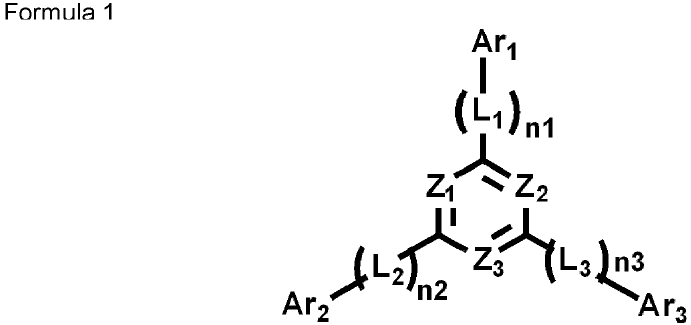

In Formula 1, Z₁ to Z₃ are independently CRₐ or N, wherein at least one selected from among Z₁ to Z₃ is N, and Rₐ is a hydrogen atom, a deuterium atom, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms; Ar₁ to Ar₃ are each independently a substituted or unsubstituted aryl group having 6 to 30 ring-forming carbon atoms, or a substituted or unsubstituted heteroaryl group having 2 to 30 ring-forming carbon atoms, wherein at least one selected from among Ar₁ to Ar₃ is substituted with a cyano group; L₁ to L₃ are each independently a direct linkage, a substituted or unsubstituted arylene group having 6 to 30 ring-forming carbon atoms, or a substituted or unsubstituted heteroarylene group having 2 to 30 ring-forming carbon atoms; and n1 to n3 are each independently an integer of 1 to 3, wherein when each of n1 to n3 is an integer of 2 or greater, the plurality of L₁ to L₃ are each independently a substituted or unsubstituted arylene group having 6 to 30 ring-forming carbon atoms, or a substituted or unsubstituted heteroarylene group having 2 to 30 ring-forming carbon atoms.

In one or more embodiments, in the mixed layer, a weight ratio of the first compound and the second compound may be 5:95 to 95:5.

In one or more embodiments, the electron transport region may comprise an electron transport layer on the light emitting layer, and the mixed layer on the electron transport layer.

In one or more embodiments, the electron transport region may further comprise an additional layer between the mixed layer and the second electrode.

In one or more embodiments, the additional layer may comprise the second compound represented by Formula 2.

In one or more embodiments, the mixed layer may be directly on the electron transport layer, and the additional layer may be directly on the mixed layer.

In one or more embodiments, the mixed layer may be composed of (e.g., may comprise or may consist essentially of) the first compound and the second compound.

In one or more embodiments, the thickness of the mixed layer may be approximately 1 angstrom (Å) to approximately 30 Å.

In one or more embodiments, the first compound may be represented by Formula 1-1.

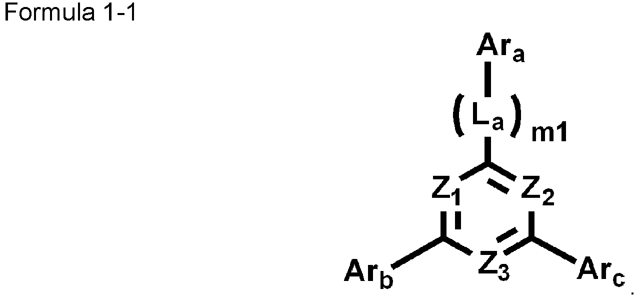

In Formula 1-1, Arₐ to Ar_{c} may each independently be a substituted or unsubstituted phenyl group, a substituted or unsubstituted naphthyl group, a substituted or unsubstituted biphenyl group, a substituted or unsubstituted phenylnaphthyl group, or a substituted or unsubstituted phenylpyridine group, wherein at least one selected from among Arₐ to Ar_{c} is substituted with a cyano group; Lₐ is a direct linkage, a substituted or unsubstituted phenylene group, a substituted or unsubstituted divalent naphthyl group, a substituted or unsubstituted divalent pyridine group, a substituted or unsubstituted divalent isoquinoline group, or a substituted or unsubstituted divalent phthalazine group; m1 is an integer of 1 to 3;, and when m1 is an integer of 2 or greater, a plurality of Lₐ may each independently be a substituted or unsubstituted phenylene group, a substituted or unsubstituted divalent naphthyl group, a substituted or unsubstituted divalent pyridine group, a substituted or unsubstituted divalent isoquinoline group, or a substituted or unsubstituted divalent phthalazine group.

In Formula 1-1, Z₁ to Z₃ may be as described with reference to Formula 1.

In Formula 1, any one selected from among Ar₁ to Ar₃ may be a phenyl group substituted with a cyano group, and the other two selected from among Ar₁ to Ar₃ may each be an unsubstituted aryl group having 6 to 30 ring-forming carbon atoms, or an unsubstituted heteroaryl group having 2 to 30 ring-forming carbon atoms.

The second compound is represented by Formula 2-2.

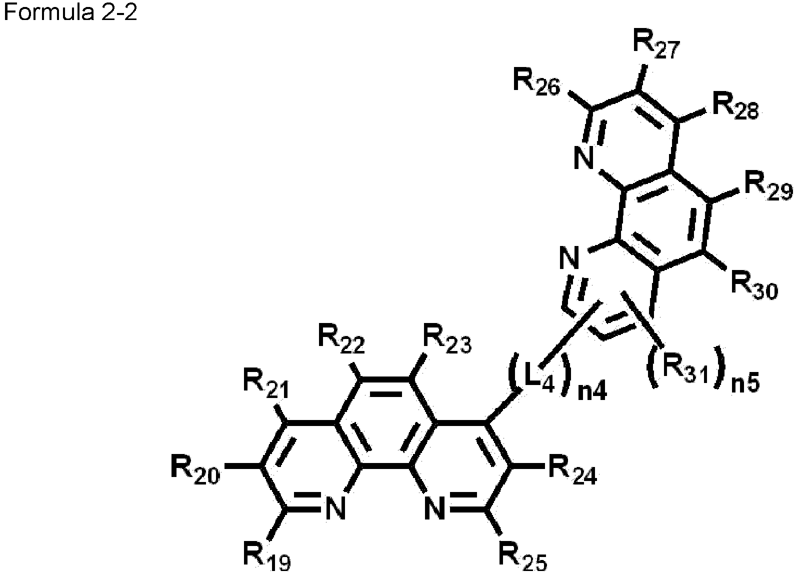

In Formula 2-2, R₁₉ to R₃₁ are each independently a hydrogen atom, a deuterium atom, a substituted or unsubstituted amine group, a substituted or unsubstituted methyl group, a substituted or unsubstituted phenyl group, a substituted or unsubstituted naphthyl group, a substituted or unsubstituted pyrrole group, a substituted or unsubstituted pyrazole group, a substituted or unsubstituted imidazole group, a substituted or unsubstituted pyrrolidine group, a substituted or unsubstituted isoindoline group, a substituted or unsubstituted carbazole group, or a substituted or unsubstituted triazine group; L₄ is a substituted or unsubstituted phenylene group; n4 is an integer of 1 to 3; and n5 is an integer of 0 to 2.

In an embodiment not forming part of the invention, the second compound may be represented by Formula 2-3 or Formula 2-4.

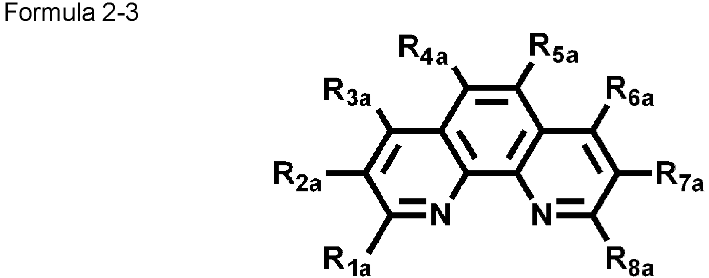

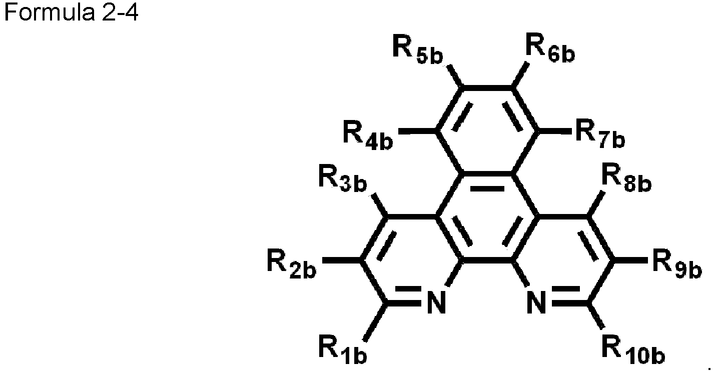

In Formula 2-3 and Formula 2-4, R₁ₐ to R₈ₐ and R_{1b} to R_{10b} may each independently be a hydrogen atom, a deuterium atom, a substituted or unsubstituted amine group, a substituted or unsubstituted alkyl group having 1 to 20 carbons atoms, a substituted or unsubstituted alkenyl group having 2 to 20 carbon atoms, a substituted or unsubstituted hydrocarbon ring group having 5 to 20 or ring-forming carbon atoms, a substituted or unsubstituted aliphatic heterocyclic group having 2 to 30 ring-forming carbon atoms, a substituted or unsubstituted aryl group having 6 to 30 ring-forming carbon atoms, or a substituted or unsubstituted heteroaryl group having 2 to 30 ring-forming carbon atoms.

In one or more embodiments, the light emitting layer may be to emit blue light.

In one or more embodiments of the present disclosure , a light emitting device comprises a first electrode, a hole transport region on the first electrode, a light emitting layer on the hole transport region, an electron transport region on the light emitting layer, and a second electrode on the electron transport region, wherein the electron transport region comprises an electron transport layer on the light emitting layer, and a mixed layer on the electron transport layer, wherein the mixed layer comprises: a first compound comprising a core having a nitrogen-containing hexagonal heteroaryl moiety, a first linker connected to the core, and a cyano group connected to the first linker; and a second compound different from the first compound, the second compound comprising a phenanthroline moiety.

In one or more embodiments, the first linker may comprise at least one selected from among a phenylene group, a divalent naphthyl group, a divalent pyridine group, a divalent isoquinoline group, and/or a divalent phthalazine group.

In one or more embodiments, molecular structure of the second compound may comprise 1 to 5 phenanthroline moieties.

In one or more embodiments of the present disclosure a display device comprises a base layer comprising a plurality of light emitting regions, and a non-light emitting region adjacent to the plurality of light emitting regions, and a plurality of light emitting devices on the base layer, and respectively corresponding to the plurality of light emitting regions, wherein at least some of the plurality of light emitting devices comprise a first electrode, a hole transport region on the first electrode, a light emitting layer on the hole transport region, an electron transport region on the light emitting layer, and a second electrode on the electron transport region, wherein the electron transport region comprises a mixed layer comprising a first compound represented by Formula 1 and a second compound different from the first compound and represented by Formula 2.2.

### BRIEF DESCRIPTION OF THE FIGURES

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:
FIG. 1 is a plan view of a display device according to one or more embodiments of the present disclosure;
FIG. 2 is a cross-sectional view of a display device according to one or more embodiments of the present disclosure;
FIG. 3 is a cross-sectional view schematically showing a light emitting device according to one or more embodiments of the present disclosure;
FIG. 4 is a cross-sectional view schematically showing a light emitting device according to one or more embodiments of the present disclosure;
FIG. 5 is a cross-sectional view schematically showing a light emitting device according to one or more embodiments of the present disclosure;
FIG. 6 is a cross-sectional view schematically showing a light emitting device according to one or more embodiments of the present disclosure;
FIG. 7 is a cross-sectional view schematically showing a light emitting device according to one or more embodiments of the present disclosure;
FIG. 8 and is a cross-sectional view of a display device according to one or more embodiments of the present disclosure;
FIG. 9 is a cross-sectional view of a display device according to one or more embodiments of the present disclosure;
FIG. 10 is a cross-sectional view of a display device according to one or more embodiments of the present disclosure; and
FIG. 11 is a cross-sectional view of a display device according to one or more embodiments of the present disclosure.

### DETAILED DESCRIPTION

The present disclosure may be modified in many alternate forms, and thus specific embodiments will be exemplified in the drawings and described in more detail. It should be understood, however, that it is not intended to limit the present disclosure to the particular forms disclosed, but rather, is intended to cover all modifications, equivalents, and alternatives falling within the spirit and scope of the present disclosure. Unless otherwise defined, all chemical names, technical and scientific terms, and terms defined in common dictionaries should be interpreted as having meanings consistent with the context of the related art, and should not be interpreted in an ideal or overly formal sense.

Like reference numerals are utilized to refer to like elements in describing each drawing. In the accompanying drawings, the dimensions of elements are exaggerated for clarity of the present disclosure. It will be understood that, although the terms "first," "second," etc. may be utilized herein to describe one or more suitable elements, these elements should not be limited by these terms. These terms are only utilized to distinguish one element from another. For example, a first element may be referred to as a second element, and a second element may also be referred to as a first element in a similar manner without departing the scope of rights of the present disclosure. The terms of a singular form may include plural forms unless the context clearly indicates otherwise.

In the present application, it should be understood that the terms "has," "have," "having," "comprises," "comprising," "includes," and/or "including," are intended to specify the presence of stated features, integers, steps, operations, elements, components, or combinations thereof in the disclosure, but do not preclude the presence or addition of one or more other features, integers, steps, operations, elements, components, or combinations thereof.

As used herein, the terms "use," "using," and "used" may be considered synonymous with the terms "utilize," "utilizing," and "utilized," respectively.

As used herein, expressions such as "at least one of," "one of," and "selected from," when preceding a list of elements, modify the entire list of elements and do not modify the individual elements of the list. For example, the expressions "at least one of a to c," "at least one of a, b or c," and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.

As used herein, the term "and/or" includes any and all combinations of one or more of the associated listed items.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Further, in this specification, the phrase "on a plane," or "plan view," means viewing a target portion from the top, and the phrase "on a cross-section" means viewing a cross-section formed by vertically cutting a target portion from the side

In the present disclosure, if a portion such as a layer, a film, a region, or a plate is referred to as being "on" or "above" the other portion, it comprises not only the case in which the portion is "directly on" the other portion (e.g., without any intervening portions therebetween), but also the case in which another portion is provided therebetween. Similarly, when a portion such as a layer, a film, a region, or a plate is referred to as being "under" or "below" the other portion, it comprises not only the case in which the portion is "directly under" the other portion (e.g., without any intervening portions therebetween), but also the case in which another portion is provided therebetween. In addition, in the present disclosure, being provided or located "on" not only comprises the case of being provided or located above, but also the case of being provided or located below.

In the present specification, "substituted or unsubstituted" may refer to a group that is unsubstituted or that is substituted with one or more substituents selected from the group consisting of a deuterium atom, a halogen atom, a cyano group, a nitro group, an amine group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, a hetero ring group, and combinations thereof. In some embodiments, each of the substituents illustrated above may be substituted or unsubstituted. For example, a biphenyl group may be interpreted as an aryl group, and may be interpreted as a phenyl group substituted with a phenyl group.

In the present specification, "forms a ring by being coupled to an adjacent group" may refer to forming a substituted or unsubstituted hydrocarbon ring or a substituted or unsubstituted hetero ring by being bonded to an adjacent group. The hydrocarbon ring comprises an aliphatic hydrocarbon ring and an aromatic hydrocarbon ring. The hetero ring comprises an aliphatic hetero ring and an aromatic hetero ring. The hydrocarbon ring and the hetero ring may be monocyclic or polycyclic. Also, a ring formed by being bonded to each other may be connected to another ring to form a spiro structure.

In the present specification, "an adjacent group" may refer to a pair of substituent groups where the first substituent is connected to an atom which is directly connected to another atom substituted with the second substituent; a pair of substituent groups connected to the same atom; or a pair of substituent groups where the first substituent is sterically positioned at the nearest position to the second substituent. For example, in 1,2-dimethylbenzene, two methyl groups may be interpreted as being "an adjacent group" to each other, and in 1,1-diethylcyclopentane, two ethyl groups may be interpreted as being "an adjacent group" to each other. In some embodiments, in 4,5-dimethylphenanthrene, two methyl groups may be interpreted as being "an adjacent group" to each other.

In the present specification, examples of the halogen atom comprise a fluorine atom, a chlorine atom, a bromine atom, and an iodine atom.

In the present specification, "alkyl group" refers to a hydrocarbon group comprised entirely of fully saturated C-H bonds and that may be linear, branched or cyclic. The number of carbon atoms of the alkyl group is not particularly limited, but may be 1 to 30, 1 to 20, 1 to 10, or 1 to 6. Examples of the alkyl group may comprise a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a cyclopentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, a cyclohexyl group, a 4-methylcyclohexyl group, a 4-t-butylcyclohexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group , a 2-hexyloctyl group, a 3,7-dimethyloctyl group, a cyclooctyl group, an n-nonyl group, an n-decyl group, an adamantly group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldodecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, and an n-triacontyl group, and/or the like, but are not limited thereto.

In the present specification, "alkenyl group" refers to a hydrocarbon group comprising one or more carbon double bonds in the middle and/or at a terminal of an alkyl group having 2 or more carbon atoms. The alkenyl group may be linear or branched. The number of carbon atoms of the alkenyl group is not particularly limited, but may be 2 to 30, 2 to 20, or 2 to 10. Examples of the alkenyl group may comprise a vinyl group, a 1-butenyl group, a 1-pentenyl group, a 1,3-butadienylaryl group, a styrenyl group, a styryl vinyl group, and/or the like, but are not limited thereto.

In the present specification, "alkynyl group" refers to a hydrocarbon group comprising one or more carbon triple bonds in the middle and/or at a terminal of an alkyl group having 2 or more carbon atoms. The alkynyl group may be linear or branched. The number of carbon atoms of the alkynyl group is not particularly limited, but may be 2 to 30, 2 to 20, or 2 to 10. Examples of the alkynyl group may comprise an ethynyl group, a propynyl group, and/or the like, but are not limited thereto.

In the present specification, "hydrocarbon ring group" refers to any functional group or substituent derived from an aliphatic hydrocarbon ring. The hydrocarbon ring group may be a saturated hydrocarbon ring group having a ring-forming carbon atoms of 5 to 20.

In the present specification, "aryl group" refers to any functional group or substituent derived from an aromatic hydrocarbon ring. The aryl group may be a monocyclic aryl group or a polycyclic aryl group. The number of ring-forming carbon atoms of the aryl group may be 6 to 60, 6 to 30, 6 to 20, or 6 to 15. Examples of the aryl group may comprise a phenyl group, a naphthyl group, a fluorenyl group, an anthracenyl group, a phenanthryl group, a biphenyl group, a terphenyl group, a quaterphenyl group, a quinquephenyl group, a sexiphenyl group, a biphenylene group, a triphenylene group, a pyrenyl group, a benzofluoranthenyl group, a chrysenyl group, and/or the like, but are not limited thereto.

In the present specification, a fluorenyl group may be substituted, and two substituents may be bonded to each other to form a spiro structure. Examples in which a fluorenyl group is substituted are as follows. However, the embodiments of the present disclosure are not limited thereto.

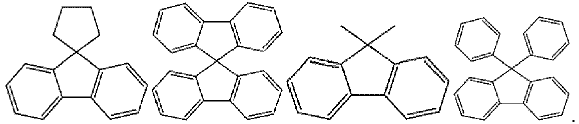

In the present specification, a "heterocyclic group" refers to any functional group or substituent derived from a ring comprising one or more selected from among B, O, N, P, Si, and S as a hetero atom. The heterocyclic group comprises an aliphatic heterocyclic group and an aromatic heterocyclic group. The aromatic heterocyclic group may be a heteroaryl group. The aliphatic heterocyclic group and the aromatic heterocyclic group may be monocyclic or polycyclic.

In the present disclosure, when the heterocyclic group comprises two or more hetero atoms, the two or more hetero atoms may be the same or different from each other. The heterocyclic group may be a monocyclic heterocyclic group or a polycyclic heterocyclic group, and is a concept comprising a heteroaryl group. The number of ring-forming carbon atoms of the heterocyclic group may be 2 to 30, 2 to 30, 2 to 20, or 2 to 10.

In the present specification, the aliphatic heterocyclic group may comprise one or more selected from among B, O, N, P, Si, and S as a hetero atom. The number of ring-forming carbon atoms of the aliphatic heterocyclic group may be 2 to 30, 2 to 20, or 2 to 10. Examples of the aliphatic heterocyclic group may be an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but are not limited thereto.

In the present specification, the heteroaryl group may comprise one or more selected from among B, O, N, P, Si, and S as a hetero atom. When the heteroaryl group comprises two or more hetero atoms, the two or more hetero atoms may be the same or different from each other. The heteroaryl group may be a monocyclic heterocyclic group or a polycyclic heterocyclic group. The number of ring-forming carbon atoms of the heteroaryl group may be 2 to 60, 2 to 30, 2 to 20, or 2 to 10. Examples of the heteroaryl group may comprise a thiophene group, a furan group, a pyrrole group, an imidazole group, a pyridine group, a bipyridine group, a pyrimidine group, a triazine group, a triazole group, an acridyl group, a pyridazinyl group, a pyrazinyl group, a quinoline group, a quinazoline group, a quinoxaline group, a phenothiazine group, a phthalazine group, a pyrido pyrimidine group, a pyrido pyrazine group, a pyrazino pyrazine group, an isoquinoline group, an indole group, a carbazole group, an N-arylcarbazol group, an N-heteroarylcarbazole group, an N-alkylcarbazol group, a benzooxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilol group, a dibenzofuran group, and/or the like, but are not limited thereto.

In the present specification, the description of an aryl group included herein may be applied to an arylene group, except that the arylene group is a divalent group. The above-described description of a heteroaryl group may be applied to a heteroarylene group, except that the heteroarylene group is a divalent group.

Depending on context, a divalent group may refer to or be a polyvalent group (e.g., trivalent, tetravalent, etc., and not just divalent) per, e.g., the structure of a formula in connection with which of the terms are utilized.

In the present specification, the silyl group comprises an alkylsilyl group and an arylsilyl group. Examples of the silyl group may comprise a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but are not limited thereto.

In the present specification, the number of carbon atoms of the carbonyl group is not particularly limited, but may be 1 to 40, 1 to 30, or 1 to 20. For example, the carbonyl group may have the following structure, but is not limited thereto.

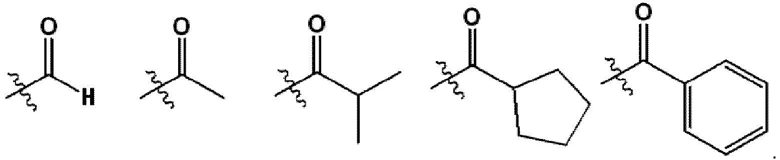

In the present specification, the number of carbon atoms of the sulfinyl group and the sulfonyl group is not particularly limited, but may be 1 to 30. The sulfinyl group may comprise an alkyl sulfinyl group and an aryl sulfinyl group. The sulfonyl group may comprise an alkyl sulfonyl group and an aryl sulfonyl group.

In the present specification, the thio group may comprise an alkyl thio group and an aryl thio group. The thio group may refer to that a sulfur atom is bonded to the alkyl group or the aryl group. Examples of the thio group may comprise a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, and/or the like, but are not limited thereto.

In the present specification, the oxy group may refer to that an oxygen atom is bonded to the alkyl group or the aryl group. The oxy group may comprise an alkoxy group and an aryl oxy group. In the present specification, the alkoxy group may be linear, branched or cyclic. The number of carbon atoms of the alkoxy group is not particularly limited, but may be, for example, 1 to 20 or 1 to 10. Examples of the oxy group may comprise methoxy, ethoxy, n-propoxy, isopropoxy, butoxy, pentyloxy, hexyloxy, octyloxy, nonyloxy, decyloxy, benzyloxy, and/or the like, but are not limited thereto.

In the present specification, the boron group may refer to that a boron atom is bonded to the alkyl group or the aryl group. The boron group comprises an alkyl boron group and an aryl boron group. Examples of the boron group may comprise a dimethylboron group, a diethylboron group, a t-butylmethylboron group, a diphenylboron group, a phenylboron group, and/or the like, but are not limited thereto.

In the present specification, the alkenyl group may be linear or branched. The number of carbon atoms of the alkenyl group is not particularly limited, but may be 2 to 30, 2 to 20, or 2 to 10. Examples of the alkenyl group may comprise a vinyl group, a 1-butenyl group, a 1-pentenyl group, a 1,3-butadienylaryl group, a styrenyl group, a styryl vinyl group, and/or the like, but are not limited thereto.

In the present specification, the number of carbon atoms of the amine group is not particularly limited, but may be 1 to 30. The amine group may comprise an alkylamine group and an arylamine group. Examples of the amine group may comprise a methylamine group, a dimethylamine group, a phenylamine group, a diphenylamine group, a naphthylamine group, a 9-methyl-anthracenylamine group, a triphenylamine group, and/or the like, but are not limited thereto. In some embodiments, in the present disclosure, the amine group may refer to a chain-type or kind amine, which is not condensed to form a ring. For example, a cyclic amine group, such as a pyrrole group, an imidazole group, a pyridine group, a bipyridine group, a pyrimidine group, a triazine group, an indole group, and/or a carbazole group, is defined herein as a heteroaryl group, and the amine group may refer to the amine group that does not form a ring.

In the present specification, an alkyl group in an alkylthio group, an alkylsulfoxy group, an alkylaryl group, an alkylamino group, an alkyl boron group, an alkyl silyl group, and alkyl amine group is the same as the examples of the alkyl group described above.

In the present specification, an aryl group in an aryloxy group, an arylthio group, an arylsulfoxy group, an arylamino group, an aryl boron group, an aryl silyl group, and an aryl amine group is the same as the examples of the aryl group described above.

In the present specification, a direct linkage may refer to a chemical bond (e.g., a single bond).

In some embodiments, in the present specification, 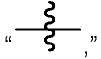 "-*" indicates a position to be connected (e.g., a binding site).

### Display Device

Hereinafter, embodiments of the present disclosure will be described with reference to the accompanying drawings.

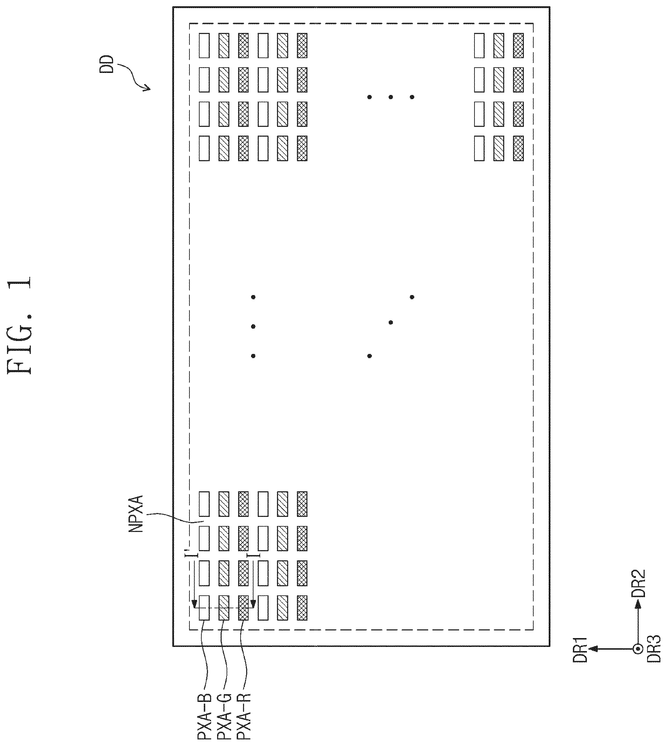

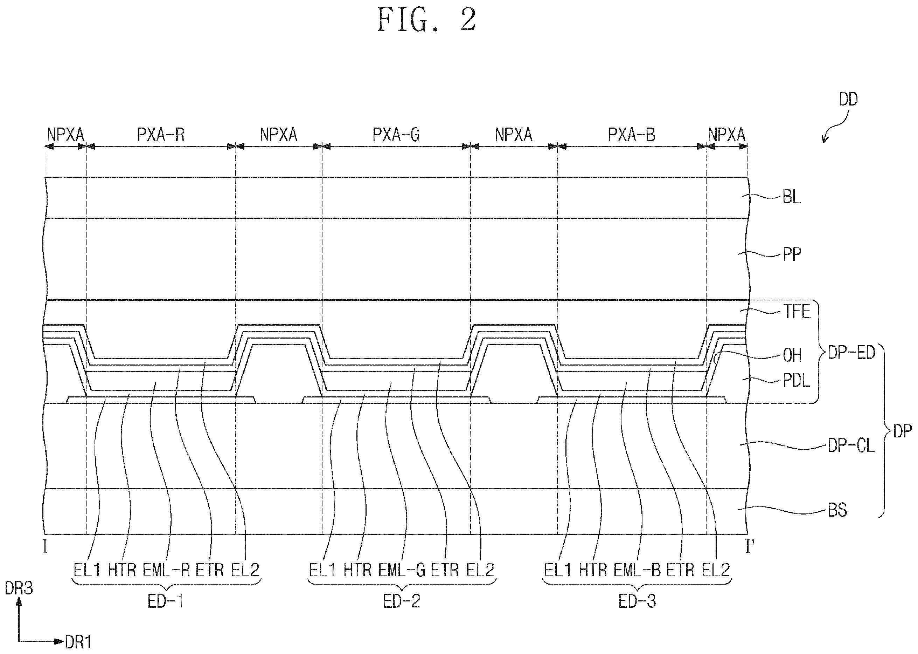

FIG. 1 is a plan view showing one or more embodiments of a display device DD. FIG. 2 is a cross-sectional view of the display device DD of one or more embodiments showing a portion corresponding to line I-I' of FIG. 1.

The display device DD may comprise a display panel DP and an optical layer PP located at (e.g., on), the display panel DP. The display panel DP comprises light emitting devices ED-1, ED-2, and ED-3. The display device DD may comprise a plurality of the light emitting devices ED-1, ED-2, and ED-3. The optical layer PP may be located at (e.g., on), the display panel DP to suitably control reflective light in the display panel DP caused by external light. The optical layer PP may comprise, for example, a polarizing layer and/or a color filter layer. In some embodiments, the optical layer PP may not be comprised in (e.g., may be omitted from) the display device DD of one or more embodiments.

On the optical layer PP, a base substrate BL may be provided. The base substrate BL may be a member which provides a base surface on which the optical layer PP is located. The base substrate BL may be a glass substrate, a metal substrate, a plastic substrate, and/or the like. However, the embodiment of the present disclosure is not limited thereto, and the base substrate BL may be an inorganic layer, an organic layer, and/or a composite material layer. In some embodiments, the base substrate BL may not be included (e.g., may be omitted).

The display device DD according to one or more embodiments may further comprise a filling layer. The filling layer may be located between a display element layer DP-ED and the base substrate BL. The filling layer may be an organic material layer. The filling layer may comprise at least one selected from among an acrylic resin, a silicone-based resin, and/or an epoxy resin.

The display panel DP may comprise a base layer BS, a circuit layer DP-CL provided on the base layer BS, and the display element layer DP-ED. The display element layer DP-ED may comprise pixel definition film PDL, the light emitting devices ED-1, ED-2, and ED-3 located between portions of the pixel definition film PDL, and an encapsulation layer TFE located at (e.g., on), the light emitting devices ED-1, ED-2, and ED-3.

The base layer BS may be a member which provides a base surface on which the display element layer DP-ED is located. The base layer BS may be a glass substrate, a metal substrate, a plastic substrate, and/or the like. However, the embodiment of the present disclosure is not limited thereto, and the base layer BS may be an inorganic layer, an organic layer, and/or a composite material layer.

In one or more embodiments, the circuit layer DP-CL is located on the base layer BS, and the circuit layer DP-CL may comprise a plurality of transistors. Each of the transistors may comprise a control electrode, an input electrode, and an output electrode. For example, the circuit layer DP-CL may comprise a switching transistor and a driving transistor for driving the light emitting devices ED-1, ED-2, and ED-3 of the display element layer DP-ED.

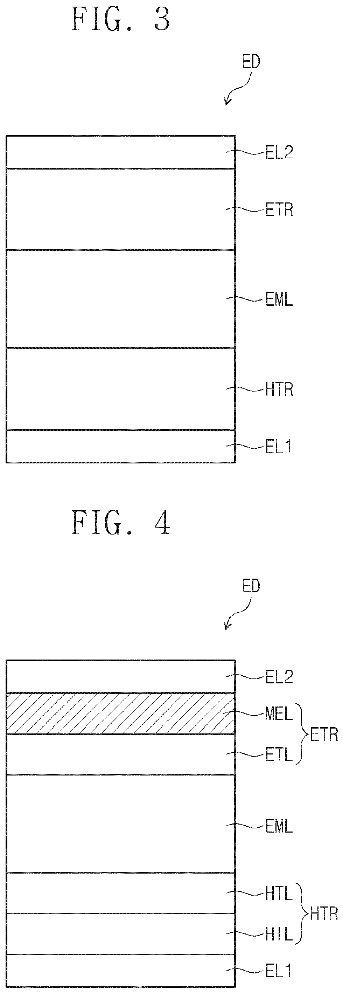

Each of the light emitting devices ED-1, ED-2, and ED-3 may have a structure of the light emitting device ED of one or more embodiments in accordance with FIG. 3 to FIG. 6 as described in more detail herein. For example, each of the light emitting devices ED-1, ED-2, and ED-3 may comprise a first electrode EL1, a hole transport region HTR, light emitting layers EML-R, EML-G, and EML-B, respectively, an electron transport region ETR, and a second electrode EL2.

FIG. 2 illustrates one or more embodiments in which the light emitting layers EML-R, EML-G, and EML-B of the light emitting devices ED-1, ED-2, and ED-3 are located in an opening OH defined in the pixel definition film PDL, and the hole transport region HTR, the electron transport region ETR, and the second electrode EL2 are provided as a common layer throughout the light emitting devices ED-1, ED-2, and ED-3. However, the embodiment of the present disclosure is not limited thereto. In some embodiments, the hole transport region HTR and the electron transport region ETR may be patterned and located inside the opening OH defined in the pixel definition film PDL. For example, in one or more embodiments, the hole transport region HTR, the light emitting layers EML-R, EML-G, and EML-B, the electron transport region ETR, and/or the like of the light emitting devices ED-1, ED-2, and ED-3 may be patterned and placed by an ink-jet printing method.

The encapsulation layer TFE may cover the light emitting devices ED-1, ED-2, and ED-3. The encapsulation layer TFE may seal the display element layer DP-ED. The encapsulation layer TFE may be a thin film encapsulation layer. The encapsulation layer TFE may be a single layer or a plurality of laminated layers. The encapsulation layer TFE comprises at least one insulation layer. The encapsulation layer TFE according to one or more embodiments may comprise at least one inorganic film (hereinafter, an encapsulation inorganic film). In some embodiments, the encapsulation layer TFE according to one or more embodiments may comprise at least one organic film (hereinafter, an encapsulation organic film) and at least one encapsulation inorganic film.

The encapsulation inorganic film protects the display element layer DP-ED from moisture and/or oxygen, and the encapsulation organic film protects the display element layer DP-ED from foreign materials such as dust particles. The encapsulation inorganic film may comprise silicon nitride, silicon oxynitride, silicon oxide, titanium oxide, aluminum oxide, and/or the like, but is not limited thereto. The encapsulation organic film may comprise an acrylic compound, an epoxy-based compound, and/or the like. The encapsulation organic film may comprise a photopolymerizable organic material, but is not limited thereto.

The encapsulation layer TFE is located at (e.g., on), the second electrode EL2, and may fill and/or be located at (e.g., on), the opening OH.

Referring to FIG. 1 and FIG. 2, the display device DD may comprise a non-light emitting region NPXA and light emitting regions PXA-R, PXA-G, and PXA-B. Each of the light emitting regions PXA-R, PXA-G, and PXA-B may be a region in which light generated from each of the light emitting devices ED-1, ED-2, and ED-3 is emitted. The light emitting regions PXA-R, PXA-G, and PXA-B may be spaced from each other on a plane (e.g., in plan view).

Each of the light emitting regions PXA-R, PXA-G, and PXA-B may be a region separated by the pixel definition film PDL. The non-light emitting regions NPXA are regions between the light emitting regions PXA-R, PXA-G, and PXA-B, and may be regions corresponding to the pixel defining film PDL. In some embodiments, in the present disclosure, each of the light emitting regions PXA-R, PXA-G, and PXA-B may correspond to a pixel. The pixel definition film PDL may separate the light emitting devices ED-1, ED-2, and ED-3. The light emitting layers EML-R, EML-G, and EML-B of the light emitting devices ED-1, ED-2, and ED-3 may be located and separated in the opening OH defined in the pixel definition film PDL.

The light emitting regions PXA-R, PXA-G, and PXA-B may be separated into a plurality of groups according to the color of light generated by the light emitting devices ED-1, ED-2, and ED-3. In the display device DD of one or more embodiments illustrated in FIG. 1 and FIG. 2, three light emitting regions PXA-R, PXA-G, and PXA-B which respectively are to emit red light, green light, and blue light are illustrated. For example, the display device DD of one or more embodiments may comprise a red light emitting region PXA-R, a green light emitting region PXA-G, and a blue light emitting region PXA-B separated from each other.

In the display device DD according to one or more embodiments, the plurality of light emitting devices ED-1, ED-2, and ED-3 may be to emit light of different wavelength regions. For example, in one or more embodiments, the display device DD may comprise a first light emitting device ED-1 which is to emit red light, a second light emitting device ED-2 which is to emit green light, and a third light emitting device ED-3 which is to emit blue light. For example, the red light emitting region PXA-R, the green light emitting region PXA-G, and the blue light emitting region PXA-B of the display device DD may respectively correspond to the first light emitting device ED-1, the second light emitting device ED-2, and the third light emitting device ED-3.

However, the embodiment of the present disclosure is not limited thereto. The first to third light emitting devices ED-1, ED-2, and ED-3 may be to emit light of the same wavelength region, or at least one thereof may be to emit light of a different wavelength region. For example, the first to third light emitting devices ED-1, ED-2, and ED-3 may all emit blue light.

In the display device DD according to one or more embodiments, the light emitting regions PXA-R, PXA-G, and PXA-B may be arranged in a stripe shape. Referring to FIG. 1, a plurality of red light emitting regions PXA-R may be aligned with each other along the second direction axis DR2, a plurality of green light emitting regions PXA-G may be aligned with each other along the second direction axis DR2, and a plurality of blue light emitting regions PXA-B may be aligned with each other along the second direction axis DR2. In some embodiments, the red light emitting region PXA-R, the green light emitting region PXA-G, and the blue light emitting region PXA-B may be alternately arranged with each other in the order of the red light emitting region PXA-R, the green light emitting region PXA-G, and the blue light emitting region PXA-B along the first direction axis DR1.

FIG. 1 and FIG. 2 illustrate that areas of the light emitting regions PXA-R, PXA-G, and PXA-B are all similar, but the embodiment of the present disclosure is not limited thereto. The areas of the light emitting regions PXA-R, PXA-G, and PXA-B may be different from each other depending on the wavelength region of emitted light. In some embodiments, the areas of the light emitting regions PXA-R, PXA-G, and PXA-B may refer to areas when viewed on a plane defined by the first direction axis DR1 and the second direction axis DR2.

In some embodiments, the arrangement type or kind of the light emitting regions PXA-R, PXA-G, and PXA-B is not limited to what is illustrated in FIG. 1. The order in which the red light emitting region PXA-R, the green light emitting region PXA-G, and the blue light emitting region PXA-B are arranged may be provided in one or more suitable combinations depending on the characteristics of display quality required in the display device DD. For example, the arrangement form of the light emitting regions PXA-R, PXA-G, and PXA-B may have the PENTILE^{®} arrangement form, or the Diamond Pixel^{™} arrangement form (PENTILE^{®} is a registered trademark owned by Samsung Display Co., Ltd.).

In some embodiments, the areas of the light emitting regions PXA-R, PXA-G, and PXA-B may be different from each other. For example, in one or more embodiments, the area of the green light emitting region PXA-G may be smaller than the area of the blue light emitting region PXA-B, but the embodiment of the present disclosure is not limited thereto.

### Light Emitting Device

FIG. 3 to FIG. 7 are each a cross-sectional view schematically showing a light emitting device according to one or more embodiments of the present disclosure. For example, a light emitting device ED according to one or more embodiments may comprise a first electrode EL1, a second electrode EL2 facing the first electrode EL1, and at least one functional layer located between the first electrode EL1 and the second electrode EL2. The light emitting device ED of one or more embodiments may comprise a first compound and a second compound as described in more detail herein in the at least one functional layer. The at least one functional layer comprised in the light emitting device ED may be a mixed layer in which the first compound and the second compound are mixed.

As illustrated in FIG. 3, the light emitting device ED according to one or more embodiments may comprise the first electrode EL1, a hole transport region HTR, a light emitting layer EML, an electron transport region ETR, and the second electrode EL2 which are sequentially laminated.

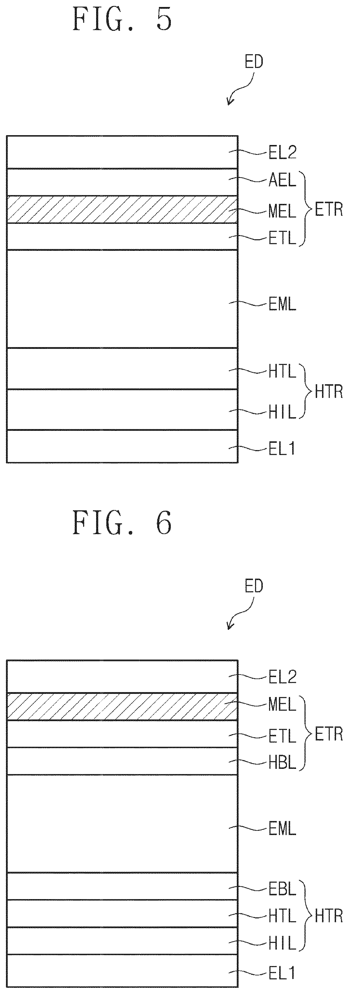

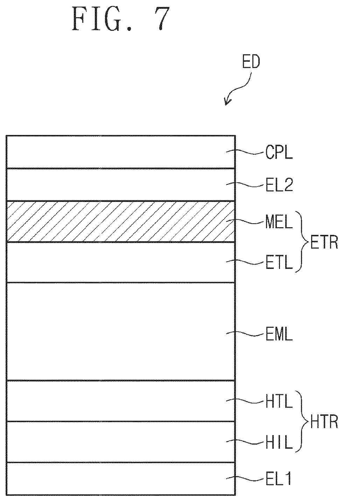

Compared to FIG. 3, FIG. 4 shows a cross-sectional view of the light emitting device ED of one or more embodiments in which the hole transport region HTR comprises a hole injection layer HIL and a hole transport layer HTL, and the electron transport region ETR comprises an electron transport layer ETL and a mixed layer MEL. Compared to FIG. 4, FIG. 5 shows a cross-section of the light emitting device ED of one or more embodiments in which the electron transport region ETR further comprises an additional layer AEL located between the mixed layer MEL and the second electrode EL2. Compared to FIG. 4, FIG. 6 shows a cross-sectional view of the light emitting device ED of one or more embodiments in which the hole transport region HTR further comprises an electron blocking layer EBL, and the electron transport region ETR further comprises a hole blocking layer HBL. Compared to FIG. 4, FIG. 7 shows a cross-sectional view of the light emitting device ED of one or more embodiments in which a capping layer CPL located on the second electrode EL2 is further included.

The first electrode EL1 has conductivity (e.g., is a conductor). The first electrode EL1 may be formed of a metal material, a metal alloy, and/or a conductive compound. The first electrode EL1 may be an anode or a cathode. However, the embodiment of the present disclosure is not limited thereto. In some embodiments, the first electrode EL1 may be a pixel electrode. The first electrode EL1 may be a transmissive electrode, a transflective electrode, or a reflective electrode. The first electrode EL1 may comprise at least one selected from Ag, Mg, Cu, Al, Pt, Pd, Au, Ni, Nd, Ir, Cr, Li, Ca, LiF, Mo, Ti, W, In, Sn, Zn, a compound of two or more selected therefrom, a mixture of two or more selected therefrom, and/or an oxide thereof.

When the first electrode EL1 is a transmissive electrode, the first electrode EL1 may comprise a transparent metal oxide, for example, indium tin oxide (ITO), indium zinc oxide (IZO), zinc oxide (ZnO), indium tin zinc oxide (ITZO), and/or the like. When the first electrode EL1 is a transflective electrode or reflective electrode, the first electrode EL1 may comprise Ag, Mg, Cu, Al, Pt, Pd, Au, Ni, Nd, Ir, Cr, Li, Ca, LiF/Ca (stacking structure of LiF and Ca), LiF/Al (stacking structure of LiF and Al), Mo, Ti, W, or a compound or mixture thereof (for example, a mixture of Ag and Mg). In some embodiments, the first electrode EL1 may have a multi-layered structure comprising a reflective film or transflective film formed of any of the above exemplified materials, and a transparent conductive film formed of indium tin oxide (ITO), indium zinc oxide (IZO), zinc oxide (ZnO), indium tin zinc oxide (ITZO), and/or the like. For example, the first electrode EL1 may have a three-layered structure of ITO/Ag/ITO, but is not limited thereto. In some embodiments, the embodiment of the present disclosure is not limited thereto. The first electrode EL1 may comprise any one of the above-described metal materials, a combination of two or more selected from the above-described metal materials, an oxide of any one of the above-described metal materials, and/or the like. The thickness of the first electrode EL1 may be about 700 angstroms (Å) to about 10000 Å. For example, the thickness of the first electrode EL1 may be about 1000 Å to about 3000 Å.

A hole transport region HTR is located at (e.g., on), the first electrode EL1. The hole transport region HTR may comprise at least one selected from among the hole injection layer HIL, the hole transport layer HTL, a buffer layer or a light emitting auxiliary layer, and/or the electron blocking layer EBL. The thickness of the hole transport region HTR may be, for example, about 50 Å to about 15,000 Å.

The hole transport region HTR may have a single-layered structure having a single layer formed of a single material, a single-layered structure having a single layer formed of a plurality of different materials, or a multi-layered structure having a plurality of layers formed of a plurality of different materials.

For example, the hole transport region HTR may have a single-layered structure having a single layer of the hole injection layer HIL or the hole transport layer HTL, or a single-layered structure having a single layer formed of a hole injection material and a hole transport material. In some embodiments, the hole transport region HTR may have a single-layered structure having a single layer formed of a plurality of different materials, or have a structure of the hole injection layer HIL/the hole transport layer HTL, the hole injection layer HIL/the hole transport layer HTL/the buffer layer, the hole injection layer HIL/the buffer layer, the hole transport layer HTL/the buffer layer, or the hole injection layer HIL/the hole transport layer HTL/the electron blocking layer EBL, sequentially laminated from the first electrode EL1, but the embodiment of the present disclosure is not limited thereto.

The hole transport region HTR may be formed utilizing one or more suitable methods such as vacuum deposition, spin coating, casting, Langmuir-Blodgett (LB), inkjet printing, laser printing, and/or laser induced thermal imaging (LITI).

The transport region HTR may comprise a compound represented by Formula H-2.

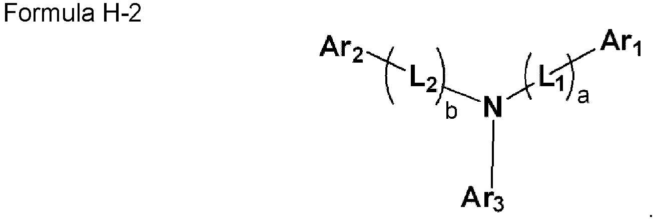

In Formula H-2, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. In some embodiments, a and b may each independently be an integer of 0 to 10. In some embodiments, when a or b is an integer of 2 or greater, respective ones of a plurality of L₁ and L₂ may each independently be a substituted or unsubstituted arylene group having 6 to 30 ring-forming carbon atoms, or a substituted or unsubstituted heteroarylene group having 2 to 30 ring-forming carbon atoms.

In Formula H-2, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In some embodiments, in Formula H-2, Ar₃ may be a substituted or unsubstituted aryl group having 6 to 30 ring-forming carbon atoms, or a substituted or unsubstituted heteroaryl group having 2 to 30 ring-forming carbon atoms.

The compound represented by Formula H-2 may be a monoamine compound. In some embodiments, the compound represented by Formula H-2 may a diamine compound in which at least one selected from among Ar₁ to Ar₃ contains an amine group as a substituent. In some embodiments, the compound represented by Formula H-2 may be a carbazole-based compound containing a substituted or unsubstituted carbazole group in at least one selected from among Ar₁ and Ar₂, or a fluorene-based compound containing a substituted or unsubstituted fluorene group in at least one selected from among Ar₁ and Ar₂.

The compound represented by Formula H-2 may be represented by any one selected from among compounds of Compound Group H. However, the compounds listed in Compound Group H are only examples and the compound represented by Formula H-2 is not limited to what is listed in Compound Group H.

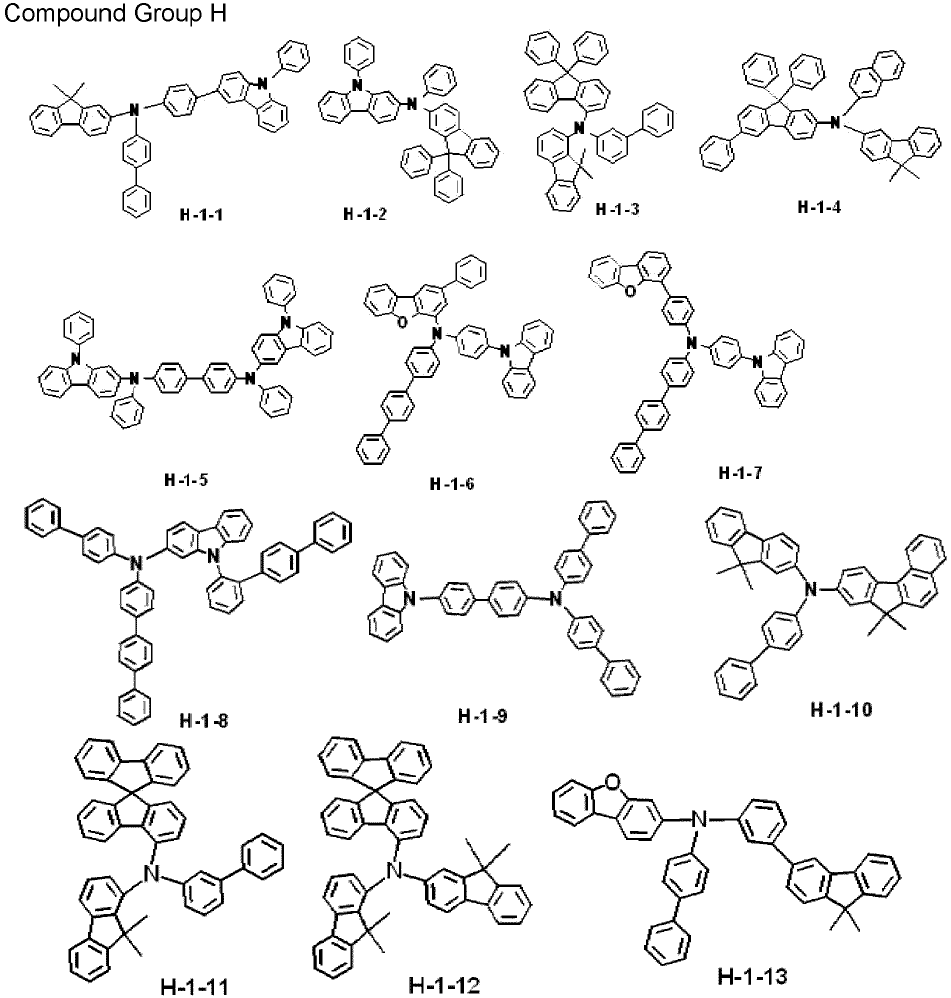

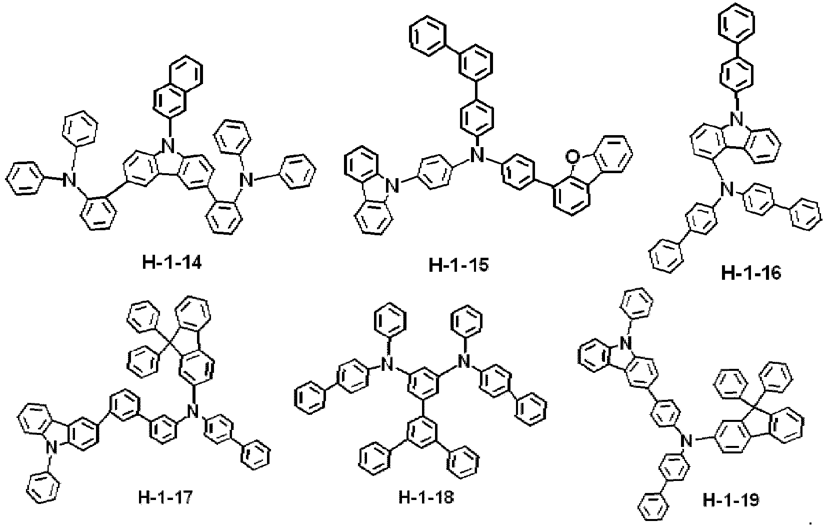

The hole transport region HTR may comprise a phthalocyanine compound such as copper phthalocyanine, N¹,N^{1'}-([1,1'-biphenyl]-4,4'-diyl)bis(N¹-phenyl-N⁴,N⁴-dim-tolylbenzene-1,4-diamine) (DNTPD), 4,4',4"-[tris(3-methylphenyl)phenylamino] triphenylamine (m-MTDATA), 4,4'4"-Tris(N,N-diphenylamino)triphenylamine (TDATA), 4,4',4"-tris[N(2-naphthyl)-N-phenylamino]-triphenylamine (2-TNATA), Poly(3,4-ethylenedioxythiophene)/Poly(4-styrenesulfonate) (PEDOT/PSS), Polyaniline/Dodecylbenzenesulfonic acid (PANI/DBSA), Polyaniline/Camphor sulfonicacid (PANI/CSA), Polyaniline/Poly(4-styrenesulfonate) (PANI/PSS), N,N'-di(naphthalene-1-yl)-N,N'-diphenyl-benzidine (NPB), triphenylamine-containing polyether ketone (TPAPEK), 4-Isopropyl-4'-methyldiphenyliodonium [Tetrakis(pentafluorophenyl)borate], dipyrazino[2,3-f: 2',3'-h] quinoxaline-2,3,6,7,10,11-hexacarbonitrile (HATCN), and/or the like.

The hole transport region HTR may comprise a carbazole-based derivative such as N-phenylcarbazole and/or polyvinylcarbazole, a fluorene-based derivative, a triphenylamine-based derivative such as N,N'-bis(3-methylphenyl)-N,N'-diphenyl-[1,1-biphenyl]-4,4'-diamine (TPD) and/or 4,4',4"-tris(N-carbazolyl)triphenylamine (TCTA), N,N'-di(naphthalene-1-yl)-N,N'-diplienyl-benzidine (NPB), 4,4'-Cyclohexylidene bis[N,N-bis(4-methylphenyl)benzenamine] (TAPC), 4,4'-Bis[N,N'-(3-tolyl)amino]-3,3'-dimethylbiphenyl (HMTPD), (1,3-Bis(N-carbazolyl)benzene (mCP), and/or the like.

In some embodiments, the hole transport region HTR may comprise 9-(4-tert-Butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may comprise the above-described compounds of the hole transport region in at least one selected from among the hole injection layer HIL, the hole transport layer HTL, and/or the electron blocking layer EBL.

The thickness of the hole transport region HTR may be about 100 Å to about 10000 Å, for example, about 100 Å to about 5000 Å. When the hole transport region HTR comprises the hole injection layer HIL, the thickness of the hole injection layer HIL may be, for example, about 30 Å to about 1000 Å. When the hole transport region HTR comprises the hole transport layer HTL, the thickness of the hole transport layer HTL may be about 30 Å to about 1000 Å. When the hole transport region HTR comprises the electron blocking layer EBL, the thickness of the electron blocking layer EBL may be about 10 Å to about 1000 Å. When the thicknesses of the hole transport region HTR, the hole injection layer HIL, the hole transport layer HTL, and the electron blocking layer EBL satisfy any of their above-described respective ranges, satisfactory or suitable hole transport properties may be obtained without (i.e., in the absence of) a substantial increase in driving voltage.

The hole transport region HTR may further comprise a charge generating material to improve conductivity, in addition to the above-mentioned materials. The charge generating material may be substantially uniformly or substantially non-uniformly dispersed in the hole transport region HTR. The charge generation material may be, for example, a p-dopant. The p-dopant may comprise at least one selected from among a halogenated metal compound, a quinone derivative, a metal oxide, and/or a cyano group-containing compound, but the embodiment of the present disclosure is not limited thereto. For example, the p-dopant may be a halogenated metal compound such as Cul and/or Rbl, a quinone derivative such as tetracyanoquinodimethane (TCNQ) and/or 2,3,5,6-tetrafluoro-7,7',8,8'-tetracyanoquinodimethane (F4-TCNQ), a metal oxide such as a tungsten oxide and/or a molybdenum oxide, a cyano group-containing compound such as dipyrazino[2,3-f: 2',3'-h] quinoxaline-2,3,6,7,10,11-hexacarbonitrile (HATCN) and/or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, but the embodiment of the present disclosure is not limited thereto.

As described above, the hole transport region HTR may further comprise at least one selected from among the buffer layer and the electron blocking layer EBL, in addition to the hole injection layer HIL and the hole transport layer HTL. The buffer layer may enhance or increase light emitting efficiency by compensating for a resonance distance according to the wavelength of light emitted from the light emitting layer EML. As for materials which may be included in the buffer layer, material(s) which may be included in the hole transport region HTR may be utilized. The electron blocking layer EBL is a layer serving to prevent or reduce electron injection from the electron transporting region ETR to the hole transporting region HTR.

The light emitting layer EML is located at (e.g., on), the hole transport region HTR. The light emitting layer EML may have a thickness of about 100 Å to about 1000 Å, or about 100 Å to about 300 Å. The light emitting layer EML may have a single-layered structure having a single layer formed of a single material, a single-layered structure having a single layer formed of a plurality of different materials, or a multi-layered structure having a plurality of layers formed of a plurality of different materials.

In the light emitting device ED one or more embodiments, the light emitting layer EML may be to emit blue light. The light emitting device ED of one or more embodiments comprises a first compound and a second compound of one or more embodiments, as described in more detail herein, which are included in the mixed layer MEL of the electron transport region ETR, so that high efficiency and long lifespan properties may be exhibited in a blue light emitting region. However, the embodiment of the present disclosure is not limited thereto, and the light emitting layer EML may be to emit green light or red light.

In the light emitting device ED of one or more embodiments, the light emitting layer EML may comprise an anthracene derivative, a pyrene derivative, a fluoranthene derivative, a chrysene derivative, a dihydrobenzene anthracene derivative, and/or a triphenylene derivative. For example, the light emitting layer EML may comprise an anthracene derivative and/or a pyrene derivative.

In the light emitting device ED of one or more embodiments illustrated in FIG. 3 to FIG. 7, the light emitting layer EML may comprise a host and a dopant, and the light emitting layer EML may comprise a compound represented by Formula E-1. The compound represented by Formula E-1 above may be utilized as a fluorescent host material.

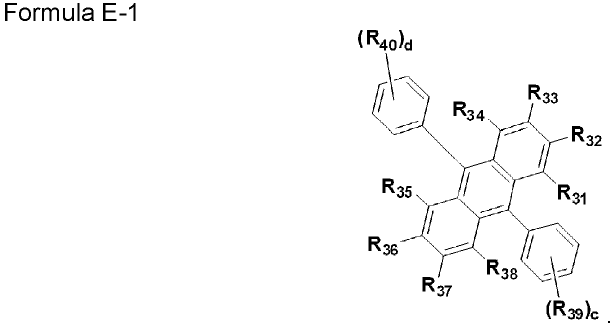

In Formula E-1, R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted an alkenyl group having 2 to 10 carbon atoms, a substituted or unsubstituted aryl group having 6 to 30 ring carbon atoms, or a substituted or unsubstituted heteroaryl group having 2 to 30 ring carbon atoms, and/or may form a ring by being coupled to an adjacent group. In some embodiments, R₃₁ to R₄₀ may be bonded to an adjacent group to form a saturated hydrocarbon ring, an unsaturated hydrocarbon ring, a saturated hetero ring, or an unsaturated hetero ring.

In Formula E-1, c and d may each independently be an integer of 0 to 5.

Formula E-1 may be represented by any one selected from among Compound E1 to Compound E19.

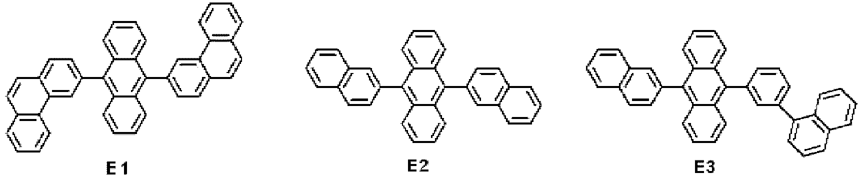

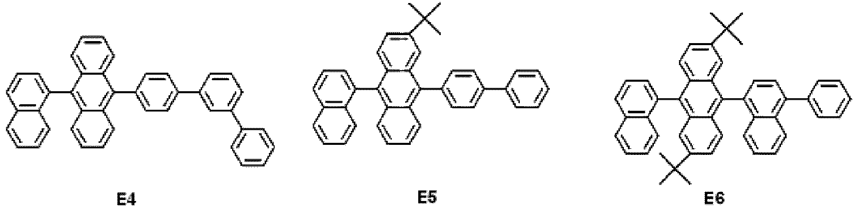

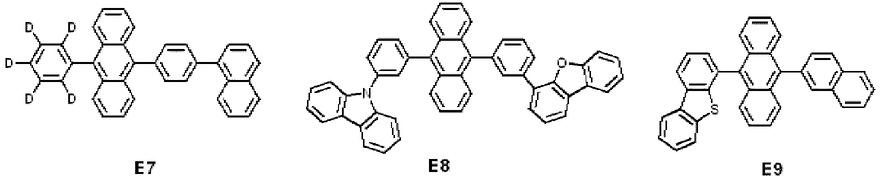

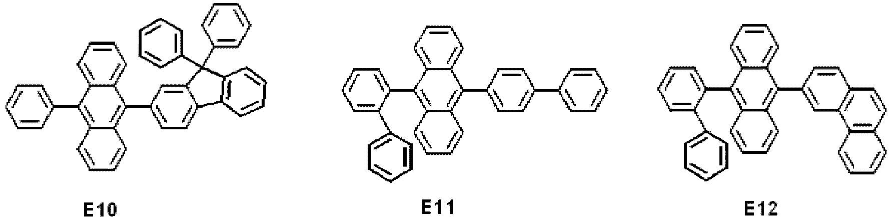

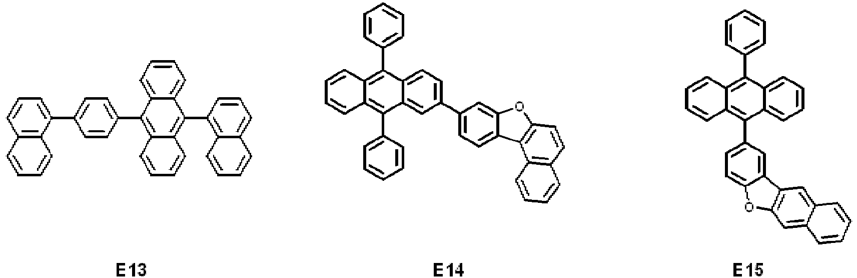

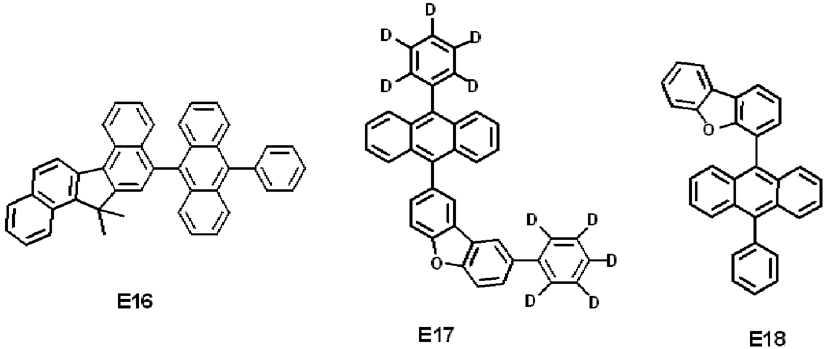

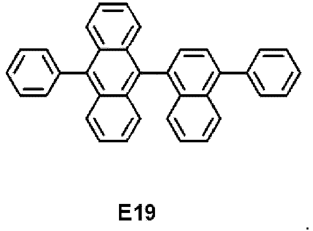

In one or more embodiments, the light emitting layer EML may comprise a compound represented by Formula E-2a or Formula E-2b. The compound represented by Formula E-2a or Formula E-2b may be utilized as a phosphorescent host material.

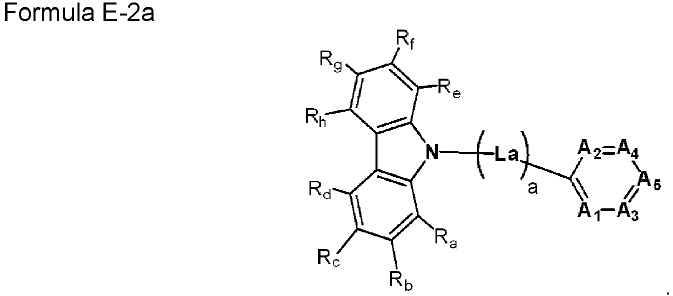

In Formula E-2a, a may be an integer of 0 to 10, Lₐ may be a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a is an integer of 2 or greater, a plurality of Lₐs may each independently be a substituted or unsubstituted arylene group having 6 to 30 ring-forming carbon atoms, or a substituted or unsubstituted heteroarylene group having 2 to 30 ring-forming carbon atoms.

In some embodiments, in Formula E-2a, A₁ to A₅ may each independently be N or CRᵢ. Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 10 carbons, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may form a ring by being coupled to an adjacent group. Rₐ to Rᵢ may be bonded to an adjacent group to form a hydrocarbon ring and/or a hetero ring containing N, O, S, and/or the like as a ring-forming atom.

In some embodiments, in Formula E-2a, two or three selected from A₁ to A₅ may be N, and the rest thereof may be CRi.

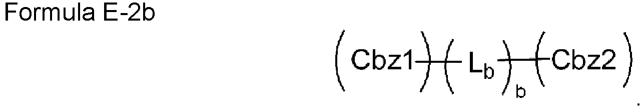

In Formula E-2b, Cbz1 and Cbz2 may each independently be an unsubstituted carbazole group, or a carbazole group substituted with an aryl group having 6 to 30 ring-forming carbon atoms. L_{b} may be a direct linkage, a substituted or unsubstituted arylene group having 6 to 30 ring-forming carbon atoms, or a substituted or unsubstituted heteroarylene group having 2 to 30 ring-forming carbon atoms. b is an integer of 0 to 10, wherein when b is an integer of 2 or greater, a plurality of L_{b}s may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be represented by any one selected from among compounds of Compound Group E-2. However, the compounds listed in Compound Group E-2 are only examples and the compound represented by Formula E-2a or Formula E-2b is not limited to what is listed in Compound Group E-2.

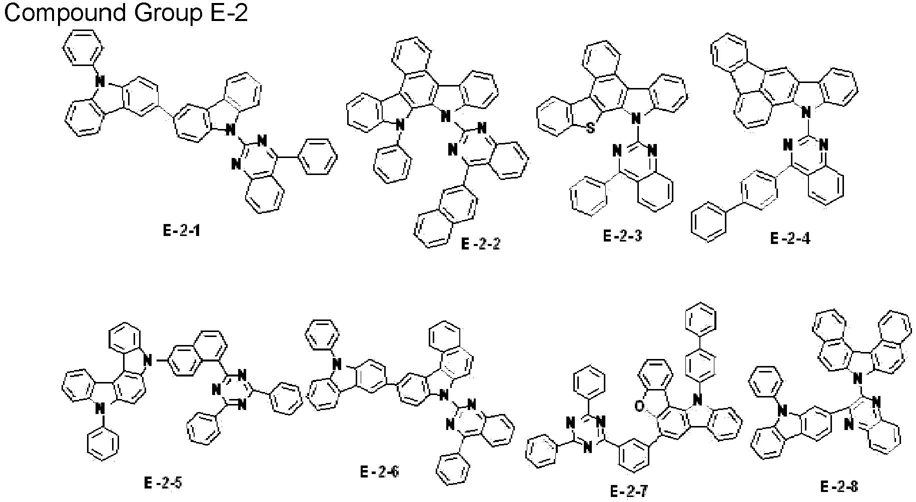

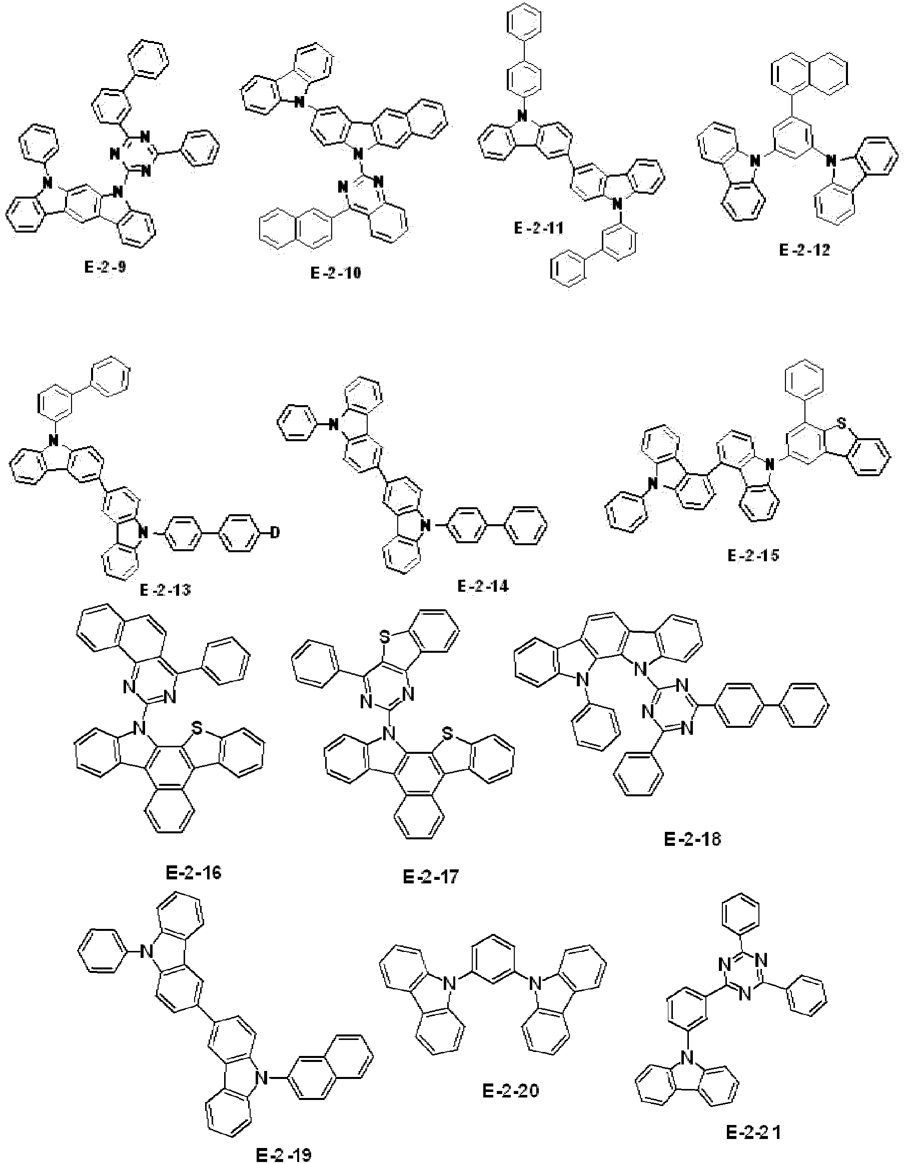

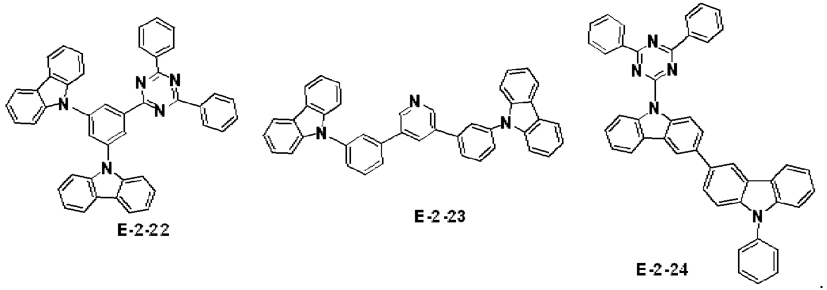

The light emitting layer EML may further comprise a material suitable in the art as a host material. For example, the light emitting layer EML may comprise, as a host material, at least one selected from among bis(4-(9H-carbazol-9-yl)phenyl)diphenylsilane) (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-Bis(carbazol-9-yl)benzene (mCP), 2,8-bis(diphenylphosphoryl)dibenzo[b,d]furan (PPF), 4,4',4"-Tris(carbazol-9-yl)-triphenylamine (TCTA), and/or 1,3,5-tris(1-phenyl-1H-benzo[d]imidazole-2-yl)benzene (TPBi). However, the embodiment of the present disclosure is not limited thereto. For example, tris(8-hydroxyquinolino)aluminum (Alq₃), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetra siloxane (DPSiO₄), and/or the like may be utilized as a host material.

The light emitting layer EML may comprise a compound represented by Formula M-a or Formula M-b. The compound represented by Formula M-a or Formula M-b may be utilized as a phosphorescent dopant material. In some embodiments, the compound represented by Formula M-a or Formula M-b in one or more embodiments may be utilized as an auxiliary dopant material.

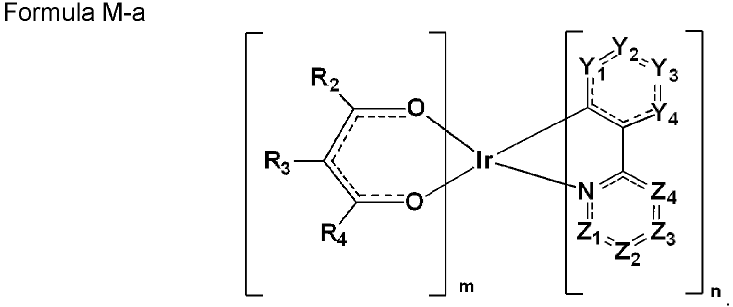

In Formula M-a , Y₁ to Y₄ and Z₁ to Z₄ may each independently be CR₁ or N, and R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbons, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may form a ring by being coupled to an adjacent group. In Formula M-a, m is 0 or 1, and n is 2 or 3. In Formula M-a, when m is 0, n is 3, and when m is 1, n is 2.

The compound represented by Formula M-a may be utilized as a phosphorescent dopant.

The compound represented by Formula M-a may be represented by any one selected from among Compounds M-a1 to M-a25. However, Compounds M-a1 to Ma25 are only examples and the compound represented by Formula M-a is not limited to ones represented by Compounds M-a1 to M-a25.

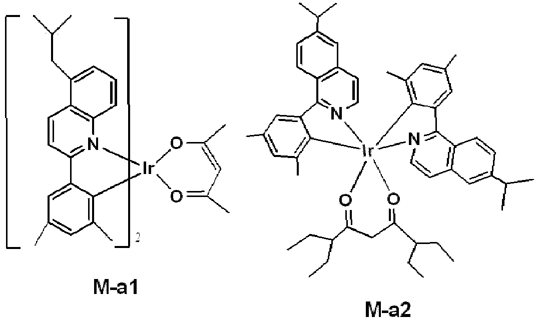

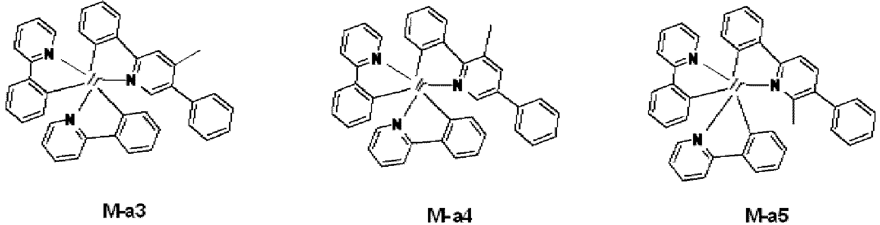

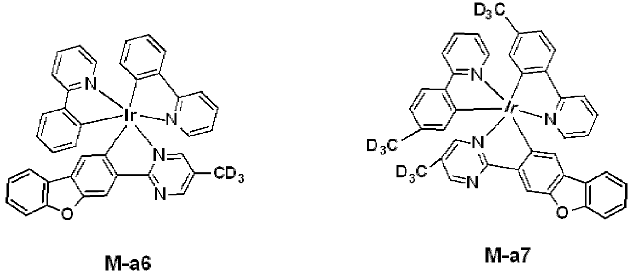

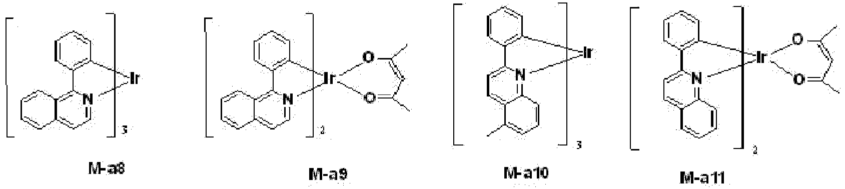

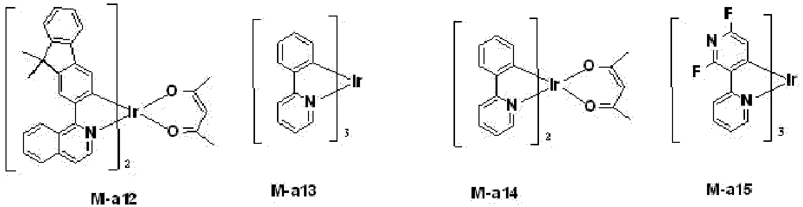

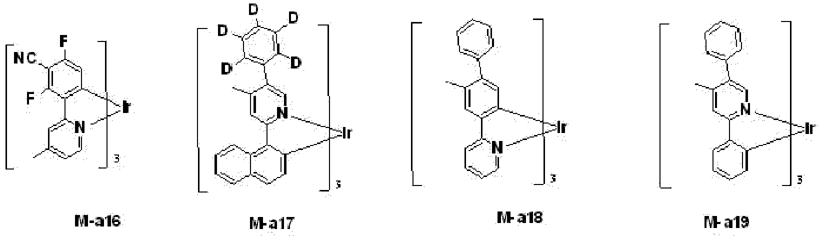

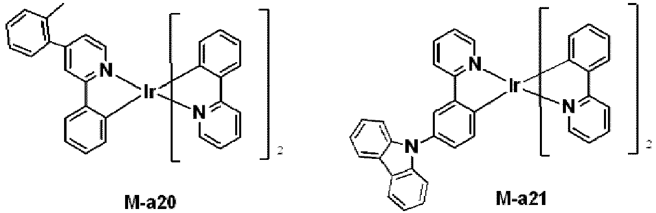

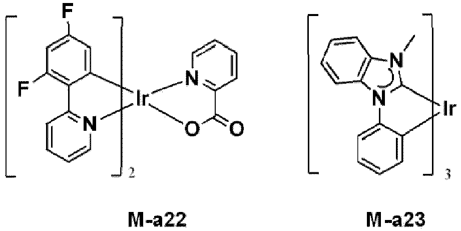

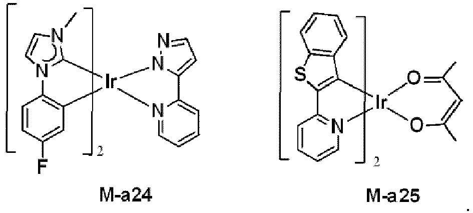

The compound M-a1 and the compound M-a2 may be utilized as a red dopant material, and the compound M-a3 to the compound M-a7 may be utilized as a green dopant material.

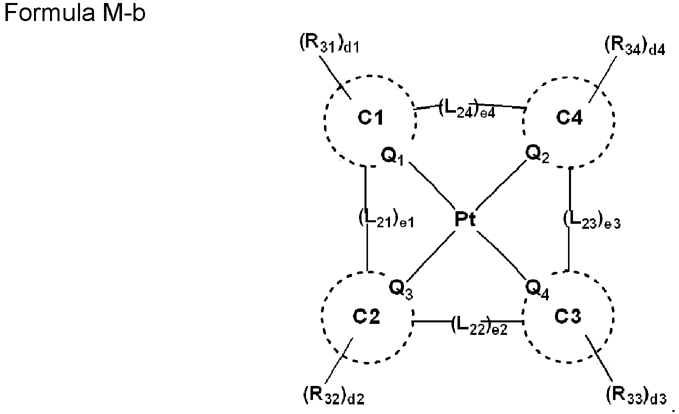

In Formula M-b, Q₁ to Q₄ may each independently be C or N, and C1 to C4 may each independently be a substituted or unsubstituted hydrocarbon ring having 5 to 30 ring-forming carbon atoms, or a substituted or unsubstituted hetero ring having 2 to 30 ring-forming carbon atoms. L₂₁ to L₂₄ may each independently be a direct linkage, *-O-*, *-5-*, 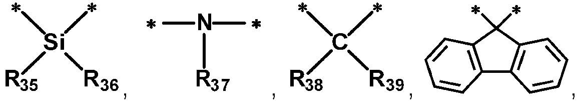 a substituted or unsubstituted alkyl group having 1 to 20 carbons, a substituted or unsubstituted arylene group having 6 to 30 ring-forming carbon atoms, or a substituted or unsubstituted heteroarylene group having 2 to 30 ring-forming carbon atoms. In one or more embodiments, e1 to e4 may each independently be 0 or 1. In one or more embodiments, R₃₁ to R₃₉ may each independently be a hydrogen atom, a deuterium atom, a halogen atom, a cyano group, a substituted or unsubstituted amine group, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms, and/or may form a ring by being coupled to an adjacent group. In one or more embodiments, d1 to d4 may each independently be an integer of 0 to 4.

The compound represented by Formula M-b may be utilized as a blue phosphorescent dopant or a green phosphorescent dopant. In some embodiments, the compound represented by Formula M-b may further be included in the light emitting layer EML as an auxiliary dopant.

The compound represented by Formula M-b may be represented by any one selected from among compound M-b-1 to compound M-b-11. However, these compounds are only examples, and the compound represented by Formula M-b is not limited to the compound M-b-1 to the compound M-b-11.

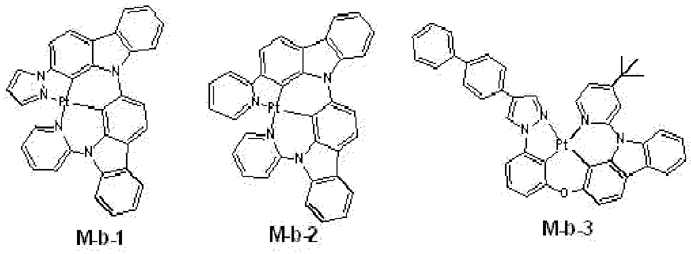

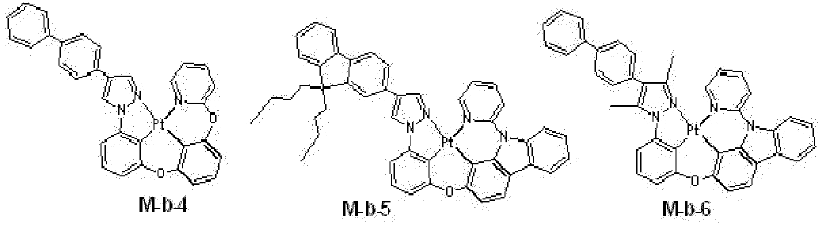

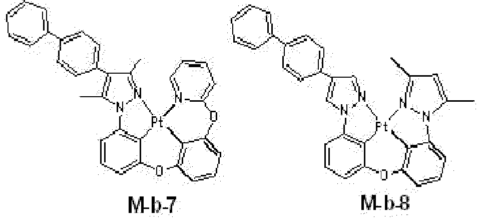

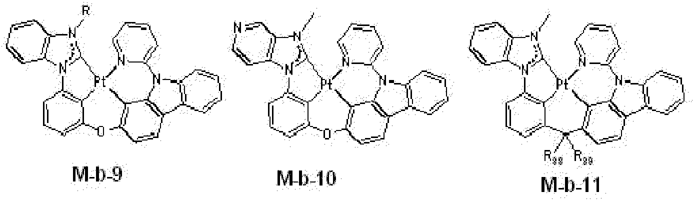

In one or more embodiments, R, R₃₈, and R₃₉ may each independently be a hydrogen atom, a deuterium atom, a halogen atom, a cyano group, a substituted or unsubstituted amine group, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms.

The light emitting layer EML may further comprise a compound represented by any one selected from among Formula F-a to Formula F-c. The compound represented by Formula F-a to Formula F-c may be utilized as a fluorescent dopant material.

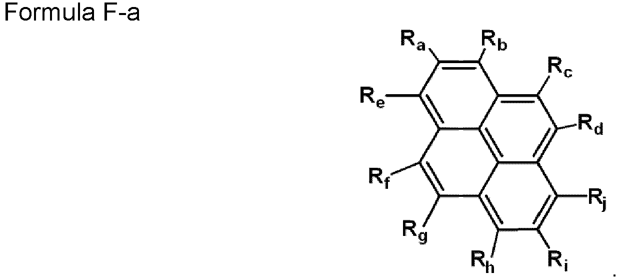

In Formula F-a, two selected from Rₐ to Rⱼ may each independently be substituted with *-NAr₁Ar₂. The rest of Rₐ to Rⱼ which are not substituted with *-NAr₁Ar₂ may each independently be a hydrogen atom, a deuterium atom, a halogen atom, a cyano group, a substituted or unsubstituted amine group, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms. In *-NA₁Ar₂, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. For example, at least one selected from among Ar₁ and Ar₂ may be a heteroaryl group containing O or S as a ring-forming atom.

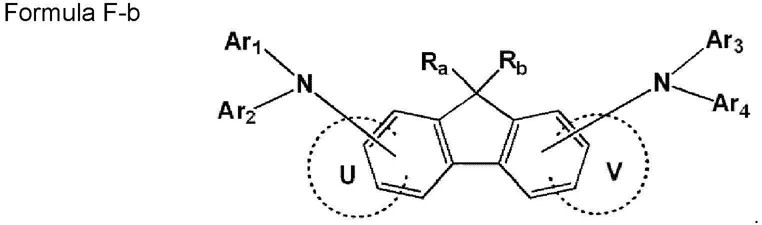

In Formula F-b, Rₐ and R_{b} may each independently be a hydrogen atom, a deuterium atom, a substituted or unsubstituted alkyl group having 1 to 20 carbons, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may form a ring by being coupled to an adjacent group.

In Formula F-b, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms, or a substituted or unsubstituted hetero ring having 2 to 30 ring-forming carbon atoms.

In Formula F-b, the number of rings represented by U and V may each independently be 0 or 1. For example, in Formula F-b, when the number of U or V is 1, one ring constitutes a condensed ring at a portion described as U or V, and when the number of U or V is 0, a ring described as U or V is not present. For example, when the number of U is 0 and the number of V is 1, or the number of U is 1 and the number of V is 0, a condensed ring having a fluorene core of Formula F-b may be a tetracyclic compound. In some embodiments, when the number of U and the number of V are all 0, a condensed ring of Formula F-b may be a tricyclic compound. In some embodiments, when the number of U and the number of V are all 1, the condensed ring having a fluorene core of Formula F-b may be a pentacyclic compound.

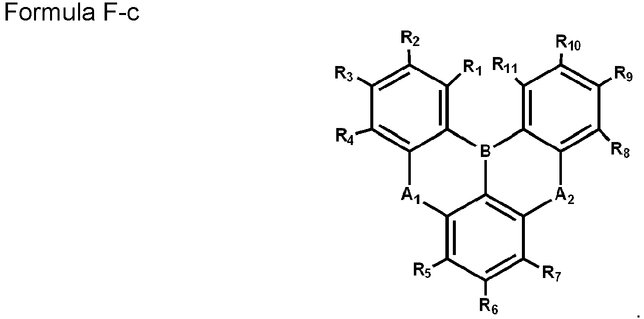

In Formula F-c, A₁ and A₂ may each independently be O, S, Se, or NRₘ, Rₘ may be a hydrogen atom, a deuterium atom, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms. R₁ to R₁₁ may each independently be a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms, and/or may form a ring by being coupled to an adjacent group.

In Formula F-c, A₁ and A₂ may each independently be bonded to substituents of adjacent rings to form a condensed ring. For example, when A₁ and A₂ are each independently NRₘ, A₁ may be bonded to R₄ or R₅ to form a ring. In some embodiments, A₂ may be bonded to R₇ or R₈ to form a ring.

In one or more embodiments, the light emitting layer EML may comprise, as a suitable dopant material, a styryl derivative (for example, 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi)), 4,4'-bis[2-(4-(N,N-diphenylamino)phenyl)vinyl]biphenyl (DPAVBi), perylene and/or a derivative thereof (for example, 2,5,8,11-tetra-t-butylperylene(TBP)), pyrene and/or a derivative thereof (for example, 1,1-dipyrene, 1,4-dipyrenylbenzene, and/or 1,4-bis(N, N-diphenylamino)pyrene), and/or the like.

When a plurality of light emitting layers EML are included in one or more embodiments, at least one light emitting layer EML may comprise a suitable phosphorescent dopant material. For example, as a phosphorescent dopant, a metal complex comprising iridium (Ir), platinum (Pt), osmium (Os), gold (Au), titanium (Ti), zirconium (Zr), hafnium (Hf), europium (Eu), terbium (Tb), and/or thulium (Tm) may be utilized. For example, iridium(III) bis(4,6-difluorophenylpyridinato-N,C2')picolinate (FIrpic), Bis(2,4-difluorophenylpyridinato)-tetrakis(1-pyrazolyl)borate iridium(III) (Fir6), and/or platinum octaethyl porphyrin (PtOEP) may be utilized as a phosphorescent dopant. However, the embodiment of the present disclosure is not limited thereto.

In one or more embodiments, the light emitting layer EML may comprise a hole transporting host and an electron transporting host. In some embodiments, the light emitting layer EML may comprise an auxiliary dopant and a light emitting dopant. In some embodiments, as the auxiliary dopant, a phosphorescent dopant material and/or a thermally activated delayed fluorescent dopant material may be comprised. For example, in one or more embodiments, the light emitting layer EML may comprise the hole transporting host, the electron transporting host, the auxiliary dopant, and/or the light emitting dopant.

In some embodiments, in the light emitting layer EML, an exciplex may be formed by the hole transporting host and the electron transporting host. For example, a triplet energy of the exciplex formed by the hole transporting host and the electron transporting host may correspond to T1, which is an interval between an LUMO energy level of the electron transporting host and a HOMO energy level of the hole transporting host.

In one or more embodiments, the triplet energy T1 of the exciplex formed by the hole transporting host and the electron transporting host may be 2.4 eV to 3.0 eV. In some embodiments, the triplet energy T1 of the exciplex may have a smaller value than the energy gap of each host material. Therefore, the exciplex may have a triplet energy T1 of 3.0 eV or less, which is an energy gap of the hole transporting host and the electron transporting host.

In some embodiments, at least one light emitting layer EML may comprise a quantum dot material. A core of the quantum dot may be selected from a Group II-VI compound, a Group III-VI compound, a Group I-III-VI compound, a Group III-V compound, a Group III-II-V compound, a Group IV-VI compound, a Group IV element, a Group IV compound, and a combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and mixtures thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and mixtures thereof.

The Group III-VI compound may comprise a binary compound such as In₂S₃, In₂Se₃, and/or the like, a ternary compound such as InGaS₃, InGaSe₃, and/or the like, or any combination thereof.

The Group I-III-VI compound may be selected from a ternary compound selected from the group consisting of AgInS, AgInS₂, CuInS, CuInS₂, AgGaS₂, CuGaS₂ CuGaO₂, AgGaO₂, AgAlO₂, and mixtures thereof, and a quaternary compound such as AgInGaS₂, CuInGaS₂, and/or the like.

The Group III-V compound may be selected from the group consisting of a binary compound selected from the group consisting of GaN, GaP, GaAs, GaSb, AIN, AlP, AlAs, AlSb, InN, InP, InAs, InSb, and mixtures thereof, a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and mixtures thereof, and a quaternary compound selected from the group consisting of GaAlNP, GaAINAs, GaAINSb, GaAlPAs, GaAlPSb, GaInNP, GaInNAs, GaInNSb, GaInPAs, GaInPSb, InAlNP, InAINAs, InAlNSb, InAlPAs, InAlPSb, and mixtures thereof. In some embodiments, the Group III-V compound may further comprise a Group II metal. For example, InZnP and/or the like may be selected as the Group III-II-V compound.

The Group IV-VI compound may be selected from the group consisting of a binary compound selected from the group consisting of SnS, SnSe, SnTe, PbS, PbSe, PbTe, and mixtures thereof, a ternary compound selected from the group consisting of SnSeS, SnSeTe, SnSTe, PbSeS, PbSeTe, PbSTe, SnPbS, SnPbSe, SnPbTe, and mixtures thereof, and a quaternary compound selected from the group consisting of SnPbSSe, SnPbSeTe, SnPbSTe, and mixtures thereof. The Group IV element may be selected from the group consisting of Si, Ge, and mixtures thereof. The Group IV compound may be a binary compound selected from the group consisting of SiC, SiGe, and mixtures thereof.

In one or more embodiments, a binary compound, a ternary compound, and/or a quaternary compound may be present in a particle at a substantially uniform concentration, or may be present in substantially the same particle with a partially different concentration distribution. In some embodiments, a binary compound, a ternary compound, and/or a quaternary compound may have a core/shell structure in which one quantum dot surrounds another quantum dot. In the core/shell structure, a binary compound, a ternary compound, or a quaternary compound may have a concentration gradient in which the concentration of an element present in the shell becomes lower toward the center of the core/shell structure.

In some embodiments, a quantum dot may have the above core-shell structure comprising a core having nano-crystals and a shell around (e.g., surrounding) the core. The shell of the quantum dot may be configured as a protection layer to prevent or reduce the chemical deformation of the core so as to maintain semiconductor properties, and/or a charging layer to impart electrophoresis properties to the quantum dot. The shell may be a single layer or multiple layers. An example of the shell of the quantum dot may be a metal oxide, a non-metal oxide, a semiconductor compound, or a combination thereof.

For example, the metal oxide and the non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, or a ternary compound such as MgAl₂O₄, CoFe₂O₄, NiFe₂O₄, and/or CoMn₂O₄. However, the embodiment of the present disclosure is not limited thereto.

In some embodiments, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like. However, the embodiment of the present disclosure is not limited thereto.

The quantum dot may have a full width of half maximum (FWHM) of a light emitting wavelength spectrum of about 45 nanometer (nm) or less, about 40 nm or less, or about 30 nm or less. In one or more embodiments, the color purity and/or color reproducibility of the quantum dot may be enhanced or improved in the above FWHM range. In some embodiments, light emitted by or through the quantum dot is emitted in all directions, so that a width of a viewing angle may be enhanced or improved.

In some embodiments, the form of the quantum dot is not particularly limited as long as it is a suitable form that may be utilized in the art. For example, a quantum dot in the form of spherical, pyramidal, multi-arm, and/or cubic nanoparticles, nanotubes, nanowires, nanofibers, nanoplate particles, and/or the like may be utilized.

The quantum dot may be configured to adjust the color of emitted light according to the particle size thereof, and accordingly, the quantum dot may have one or more suitable light emitting colors such as blue, red, green, and/or the like.

In the light emitting device ED of one or more embodiments illustrated in FIG. 3 to FIG. 7, the electron transport region ETR is located at (e.g., on), the light emitting layer EML. The light emitting device ED of one or more embodiments may comprise the first compound and the second compound of one or more embodiments, as described in more detail herein.

The electron transport region ETR comprises the mixed layer MEL comprising the first compound and the second compound, as described in more detail herein. In addition to the mixed layer MEL, the electron transport region ETR may comprise at least one selected from among the hole blocking layer HBL, the electron transport layer ETL, and/or the additional layer AEL, but the embodiment of the present disclosure is not limited thereto.

The electron transport region ETR may have a single-layered structure having a single layer formed of a plurality of different materials, or a multi-layered structure having a plurality of layers formed of a plurality of different materials. For example, the electron transport region ETR may have a single-layered structure having the mixed layer MEL in which the first compound and the second compound are mixed. In some embodiments, the electron transport region ETR may have an electron transport layer ETL/mixed layer (MEL) structure sequentially laminated from the light emitting layer EML. In some embodiments, the electron transport region ETR may have an electron transport layer ETL/mixed layer MEL/additional layer AEL structure, or a hole blocking layer HBL/electron transport layer ETL/mixed layer MEL structure, which are sequentially laminated from the light emitting layer EML, but the embodiment of the present disclosure is not limited thereto. The thickness of the electron transport region ETR may be, for example, about 1000 Å to about 1500 Å.

The light emitting device ED of one or more embodiments may comprise the first compound and the second compound of one or more embodiments comprised in the mixed layer MEL. The mixed layer MEL may be a layer in which the first compound and the second compound are mixed. The mixed layer MEL may be composed of the first compound and the second compound. The second compound comprised in the mixed layer MEL may be a compound different from the first compound.

The mixed layer MEL may be located at (e.g., on), the light emitting layer EML. The electron transport region ETR of one or more embodiments comprises the electron transport layer ETL located at (e.g., on), the light emitting layer EML, and the mixed layer MEL may be located at (e.g., on), the electron transport layer ETL. The mixed layer MEL may be directly located at (e.g., on), the electron transport layer ETL.

In one or more embodiments, the second electrode EL2 may be directly located at (e.g., on), the mixed layer MEL. However, the embodiment of the present disclosure is not limited thereto, and the additional layer AEL may be further located between the mixed layer MEL and the second electrode EL2. For example, as illustrated in FIG. 5, the additional layer AEL may be directly located at (e.g., on), the mixed layer MEL, and the second electrode EL2 may be directly located at (e.g., on), the additional layer AEL.

### First and Second Compounds

The first compound of one or more embodiments included in the mixed layer MEL comprises a core, a first linker connected to the core, and a cyano group connected to the first linker. The core is connected to one end of the first linker of the first compound, and the cyano group is connected to the other end of the first linker.

The core of the first compound comprises a nitrogen-containing hexagonal heteroaryl moiety. For example, the core of the first compound may comprise a pyridine moiety, a pyrimidine moiety, or a triazine moiety. The first linker of the first compound may be connected to a carbon atom of the core. The first linker may comprise at least one selected from among a phenylene group, a divalent naphthyl group, a divalent pyridine group, a divalent isoquinoline group, and/or a divalent phthalazine group. The first linker may comprise at least one aromatic ring, and when the first linker comprises a plurality of aromatic rings, each of the plurality of aromatic rings may be any one selected from among a phenylene group, a divalent naphthyl group, a divalent pyridine group, a divalent isoquinoline group, and/or a divalent phthalazine group. In the first compound, the cyano group may be connected to at least one aromatic ring comprised in the first linker.

The second compound of one or more embodiments included in the mixed layer MEL comprises two phenanthroline moieties. The second compound may comprise two or more phenanthroline moieties. In one or more embodiments, the number of phenanthroline moiety included in the second compound may be 2 or more and 5 or less. When a plurality of phenanthroline moieties is included in the second compound, each phenanthroline moiety may be connected through a second linker. The second linker may comprise a phenylene group, or a divalent biphenyl group.

In some embodiments, the first compound may not comprise (e.g., may exclude) a phenanthroline moiety. The first compound may be a compound which does not comprise a phenanthroline group in the molecular structure thereof. In some embodiments, the second compound may be a compound which does not comprise a cyano group in the molecular structure thereof.

The first compound is represented by Formula 1.

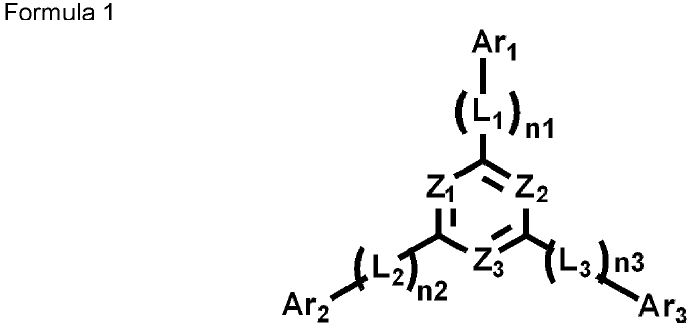

In Formula 1, Z₁ to Z₃ are each independently CRₐ or N. At least one selected from among Z₁ to Z₃ is N. For example, all of Z₁ to Z₃ may be N. In some embodiments, a hexagonal aromatic ring structure comprising Z₁ to Z₃ may correspond to the core of the first compound.

In Formula 1, Rₐ is a hydrogen atom, a deuterium atom, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms. For example, Rₐ may be a hydrogen atom or a deuterium atom.

In Formula 1, Ar₁ to Ar₃ are each independently a substituted or unsubstituted aryl group having 6 to 30 ring-forming carbon atoms, or a substituted or unsubstituted heteroaryl group having 2 to 30 ring-forming carbon atoms. For example, Ar₁ to Ar₃ may each independently be a substituted or unsubstituted phenyl group, a substituted or unsubstituted naphthyl group, or a substituted or unsubstituted pyridine group.

At least one selected from among Ar₁ to Ar₃ is substituted with a cyano group. For example, the first compound represented by Formula 1 may comprise a cyano group substituent in at least one selected from among the Ar₁ to Ar₃ substituents. In some embodiments, the combination of any one selected from among Ar₁ to Ar₃ to which the cyano group is connected, and any one structure of L₁ to L₃ connected thereto may correspond to the first linker of the first compound.

In one or more embodiments, any one selected from among Ar₁ to Ar₃ may be substituted with the cyano group. The first compound represented by Formula 1 may have one cyano group in the molecular structure thereof. In one or more embodiments, any one selected from among Ar₁ to Ar₃ may be a phenyl group substituted with a cyano group, and the other two of Ar₁ to Ar₃ may each be an unsubstituted aryl group having 6 to 30 ring-forming carbon atoms, or an unsubstituted heteroaryl group having 2 to 30 ring-forming carbon atoms. For example, any one selected from among Ar₁ to Ar₃ may be a phenyl group in which one cyano group is substituted, and the other two of Ar₁ to Ar₃ may be an unsubstituted phenyl group, an unsubstituted naphthyl group, or an unsubstituted pyridine group.

In Formula 1, L₁ to L₃ are each independently a direct linkage, a substituted or unsubstituted arylene group having 6 to 30 ring-forming carbon atoms, or a substituted or unsubstituted heteroarylene group having 2 to 30 ring-forming carbon atoms. For example, L₁ to L₃ may each be a direct linkage, a substituted or unsubstituted phenylene group, a substituted or unsubstituted divalent naphthyl group, a substituted or unsubstituted divalent pyridine group, a substituted or unsubstituted divalent isoquinoline group, or a substituted or unsubstituted divalent phthalazine group.

In Formula 1, n1 to n3 are each independently an integer of 1 to 3. In one or more embodiments, when each of n1 to n3 is an integer of 2 or greater, for example, when each of n1 to n3 2 or 3, respective ones of a plurality of L₁ to L₃ are each a substituted or unsubstituted arylene group having 6 to 30 ring-forming carbon atoms, or a substituted or unsubstituted heteroarylene group having 2 to 30 ring-forming carbon atoms. For example, when each of n1 to n3 is an integer of 2 or greater, it may exclude a case in which each of L₁ to L₃ is a direct linkage. When each of n1 to n3 is an integer of 2 or greater, each of L₁ to L₃ provided in a plurality may all be the same, or at least one selected from among the plurality of L₁ to L₃ may be different.

In one or more embodiments, the first compound may be represented by Formula 1-1.

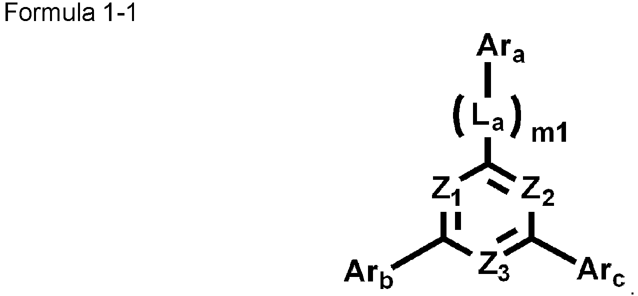

Formula 1-1 represents one or more embodiments of a substituent structure in Formula 1.

In Formula 1-1, Arₐ to Ar_{c} may each independently be a substituted or unsubstituted aryl group having 6 to 30 ring-forming carbon atoms, or a substituted or unsubstituted heteroaryl group having 2 to 30 ring-forming carbon atoms. Arₐ to Ar_{c} may each be independently a substituted or unsubstituted phenyl group, a substituted or unsubstituted naphthyl group, a substituted or unsubstituted biphenyl group, a substituted or unsubstituted phenylnaphthyl group, or a substituted or unsubstituted phenylpyridine group.

At least one selected from among Arₐ to Ar_{c} is substituted with a cyano group. In Formula 1-1, any one selected from among Arₐ to Ar_{c} may be substituted with the cyano group. The first compound represented by Formula 1-1 may have one cyano group in the molecular structure thereof. In one or more embodiments, any one selected from among Arₐ to Ar_{c} may be a phenyl group substituted with the cyano group, and the other two of Arₐ to Ar_{c} may be an unsubstituted phenyl group, an unsubstituted naphthyl group, an unsubstituted biphenyl group, an unsubstituted phenylnaphthyl group, or an unsubstituted phenylpyridine group.

In Formula 1-1, Lₐ is a direct linkage, a substituted or unsubstituted arylene group having 6 to 30 ring-forming carbon atoms, or a substituted or unsubstituted heteroarylene group having 2 to 30 ring-forming carbon atoms. Lₐ may be a direct linkage, a substituted or unsubstituted phenylene group, a substituted or unsubstituted divalent naphthyl group, a substituted or unsubstituted divalent pyridine group, a substituted or unsubstituted divalent isoquinoline group, or a substituted or unsubstituted divalent phthalazine group.

In Formula 1-1, m1 is an integer of 1 to 3. When m1 is an integer of 2 or greater, for example, when m1 is 2 or 3, a plurality of Lₐ are each independently a substituted or unsubstituted arylene group having 6 to 30 ring-forming carbon atoms, or a substituted or unsubstituted heteroarylene group having 2 to 30 ring-forming carbon atoms. For example, when m1 is an integer of 2 or greater, it may exclude a case in which Lₐ is a direct linkage. When m1 is an integer of 2 or greater, Lₐ provided in a plurality may all be the same, or at least one selected from among the plurality of Lₐ may be different.

In some embodiments of Formula 1-1, Z₁ to Z₃ are as described with reference to Formula 1.

In some embodiments of Formula 1, Ar₁ to Ar₃ may each independently be a substituent represented by Formula 1-a to Formula 1-d. In some embodiments, at least one selected from among Ar₁ to Ar₃ is a substituent represented by Formula 1-a.

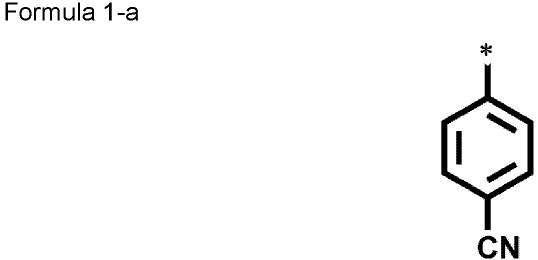

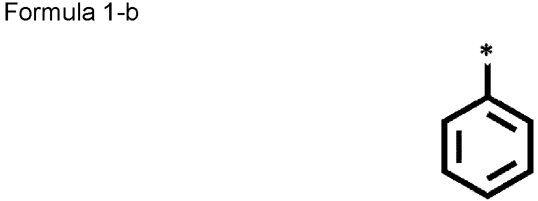

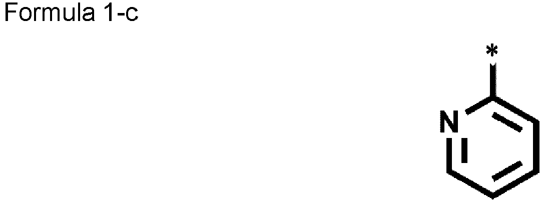

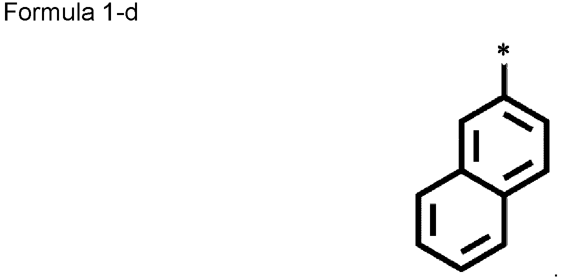

In Formula 1-a to Formula 1-d, ⁻ * is a position connected to a respective one of L₁ to L₃ of Formula 1.

In Formula 1, L₁ to L₃ may each independently be a direct linkage, or a substituent represented by Formula 1-e to Formula 1-q.

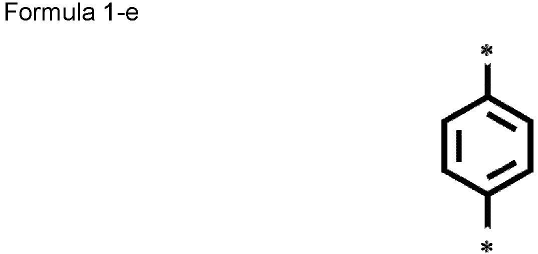

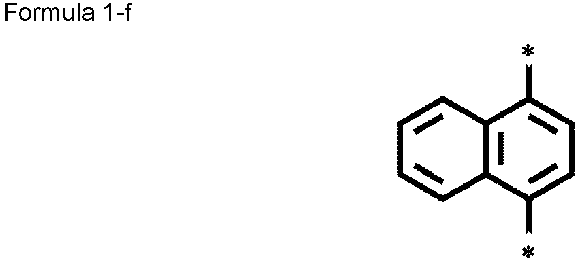

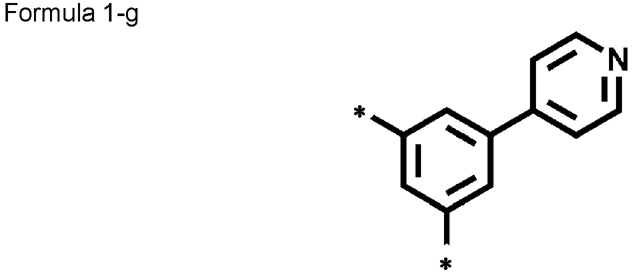

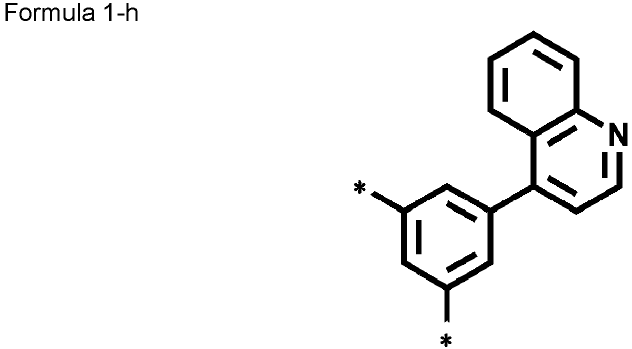

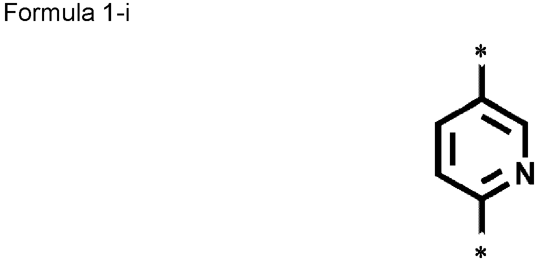

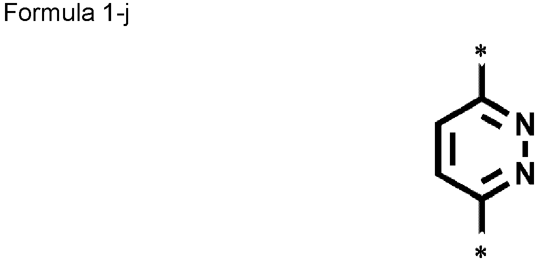

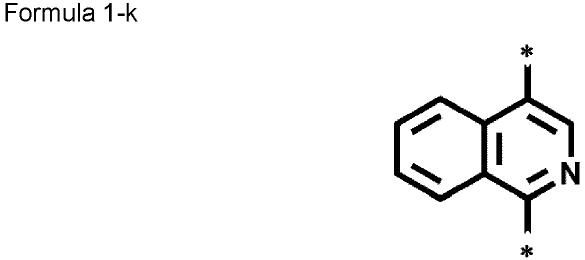

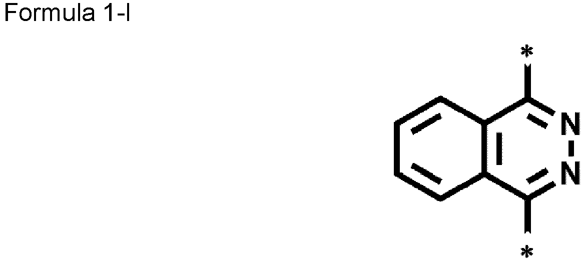

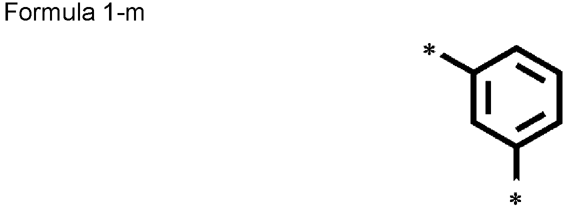

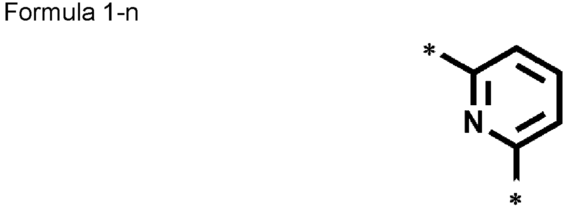

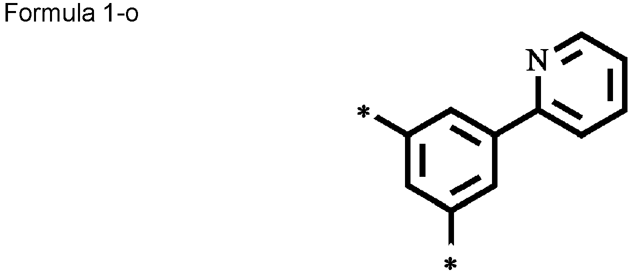

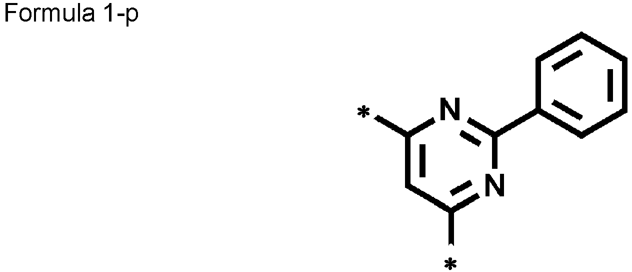

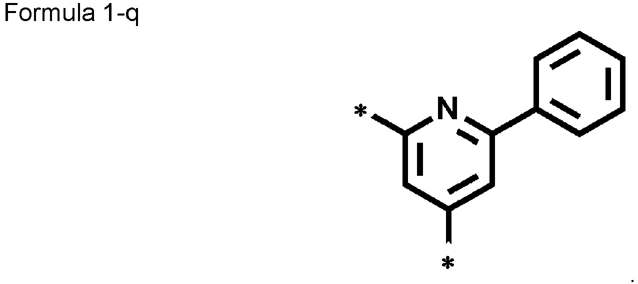

In Formula 1-e to Formula 1-q, ⁻ * is a position connected to a respective one of Ar₁ to Ar₃ of Formula 1 and the nitrogen-containing hexagonal heteroaryl core.

The first compound included in the mixed layer MEL of one or more embodiments may be represented by one selected from among compounds of Compound Group 1. The mixed layer MEL of the light emitting device ED according to one or more embodiments may comprise at least one selected from among the compounds disclosed in Compound Group 1.

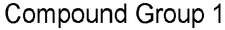

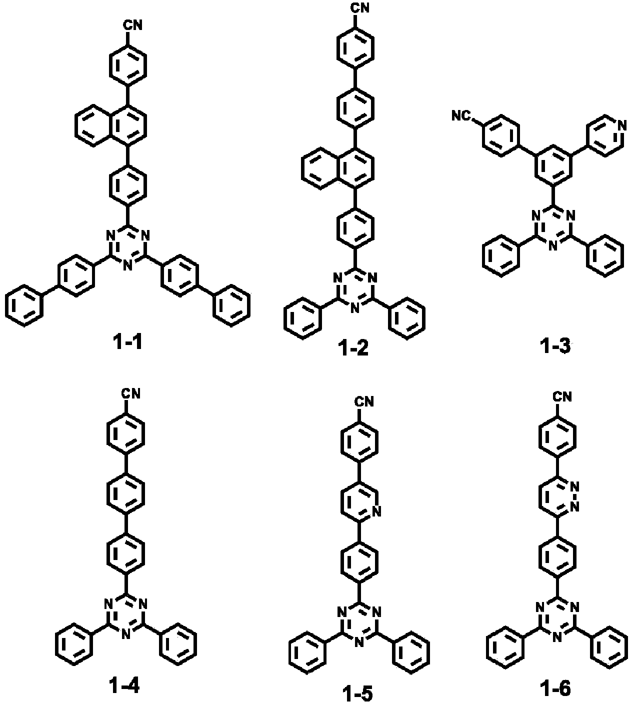

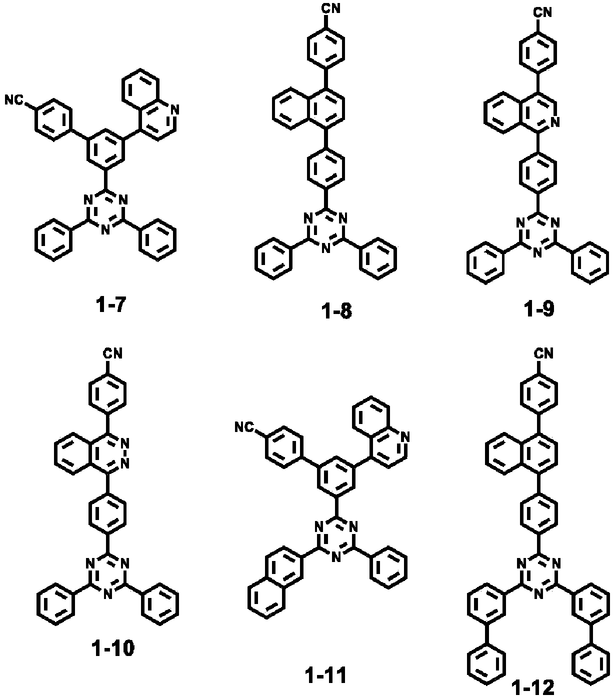

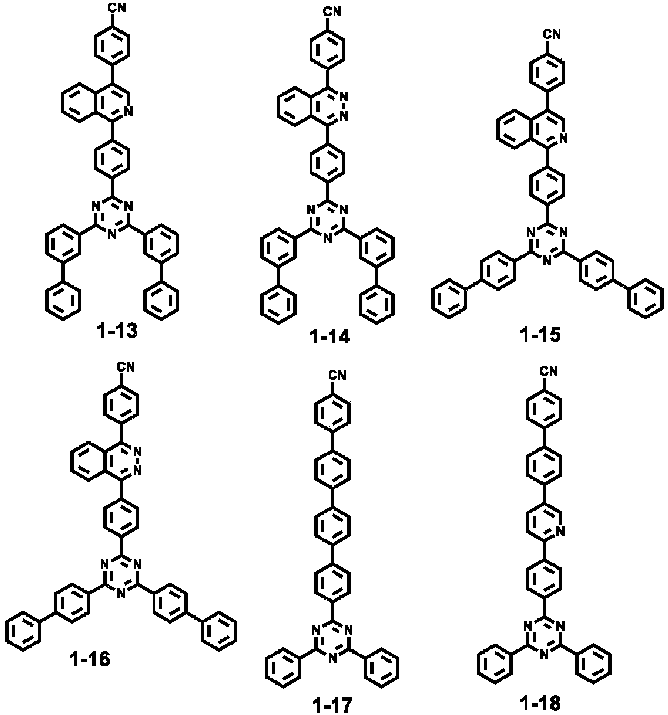

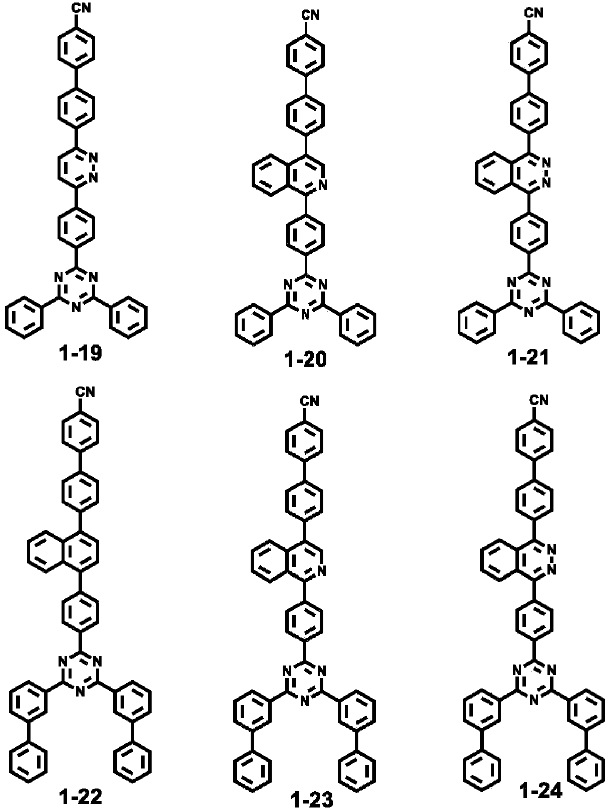

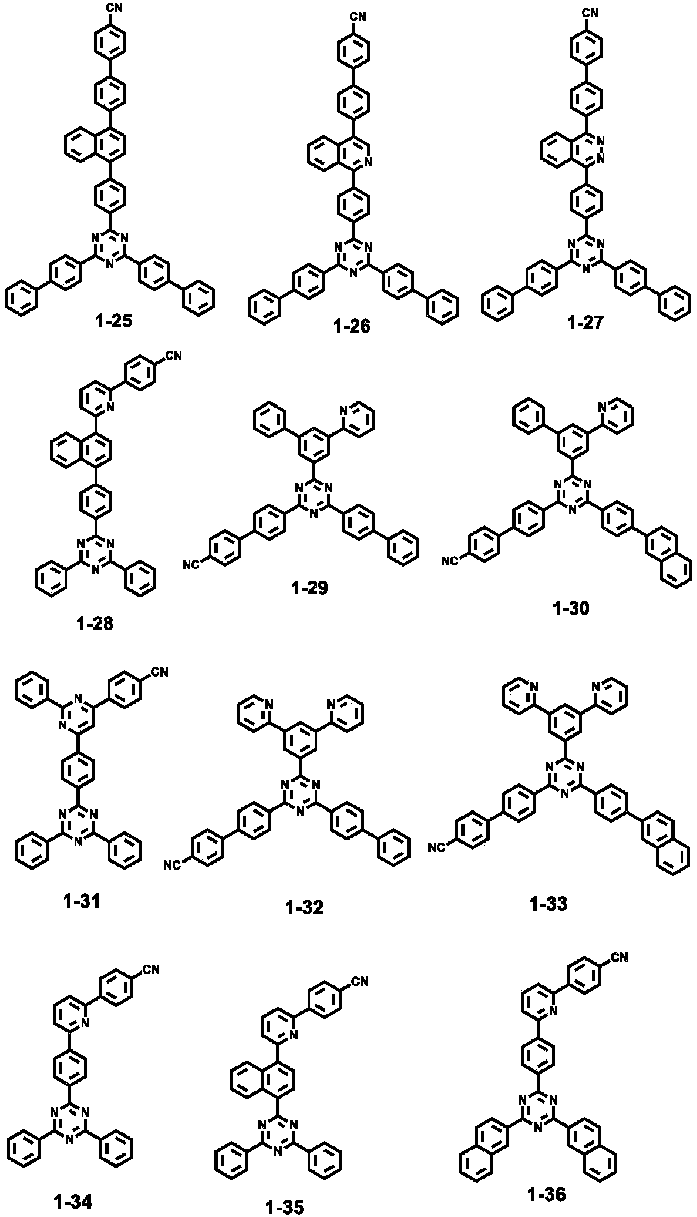

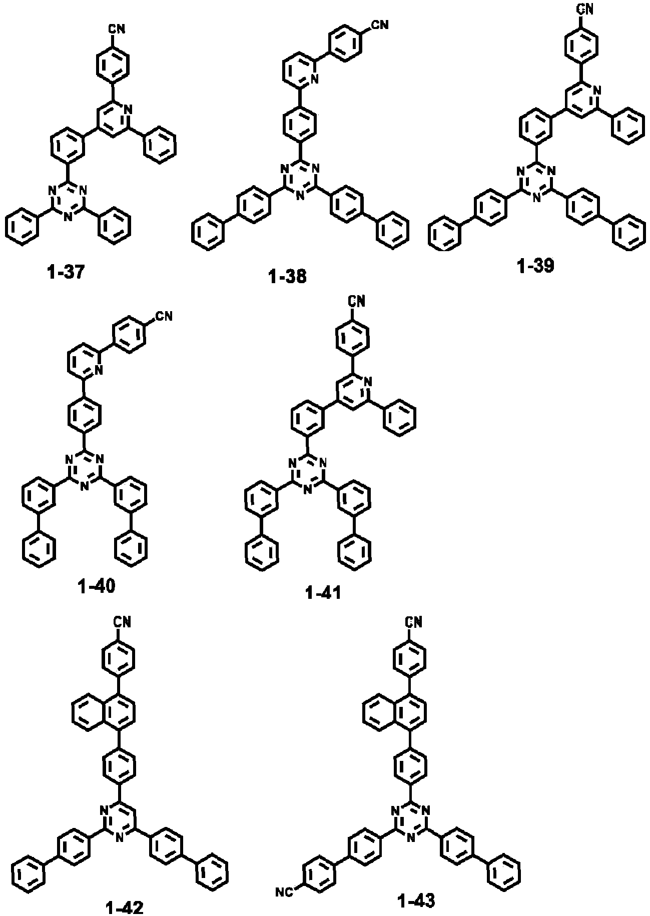

In an embodiment not forming part of the invention, the second compound may be represented by Formula 2.

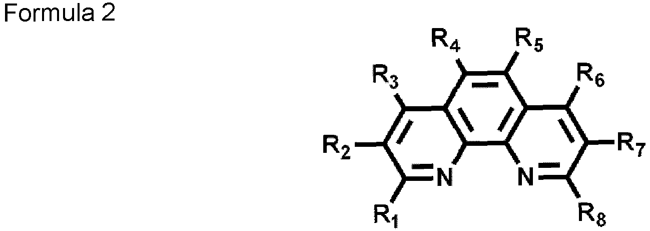

In Formula 2, R₁ to R₈ may each independently be a hydrogen atom, a deuterium atom, a substituted or unsubstituted amine group, a substituted or unsubstituted alkyl group having 1 to 20 carbons atoms, a substituted or unsubstituted alkenyl group having 2 to 20 carbon atoms, a substituted or unsubstituted hydrocarbon ring group having 5 to 20 or ring-forming carbon atoms, a substituted or unsubstituted aliphatic heterocyclic group having 2 to 30 ring-forming carbon atoms, a substituted or unsubstituted aryl group having 6 to 30 ring-forming carbon atoms, or a substituted or unsubstituted heteroaryl group having 2 to 30 ring-forming carbon atoms. In some embodiments, two adjacent substituents among R₁ to R₈ may be coupled to each other to form a ring. For example, R₁ to R₈ may each independently be a hydrogen atom, a deuterium atom, a substituted or unsubstituted amine group, a substituted or unsubstituted methyl group, a substituted or unsubstituted phenyl group, a substituted or unsubstituted naphthyl group, a substituted or unsubstituted pyrrole group, a substituted or unsubstituted pyrazole group, a substituted or unsubstituted imidazole group, a substituted or unsubstituted pyrrolidine group, a substituted or unsubstituted isoindoline group, a substituted or unsubstituted carbazole group, or a substituted or unsubstituted triazine group. Any one selected from among R₁ to R₈ may be a phenyl group substituted with a phenanthroline group, or a biphenyl group substituted with a phenanthroline group. In some embodiments, each of R₄ and Rs is a substituted or unsubstituted ethylene group, and R₄ and R₅ may be coupled to each other to form a condensed ring.

The second compound is represented by Formula 2-2.

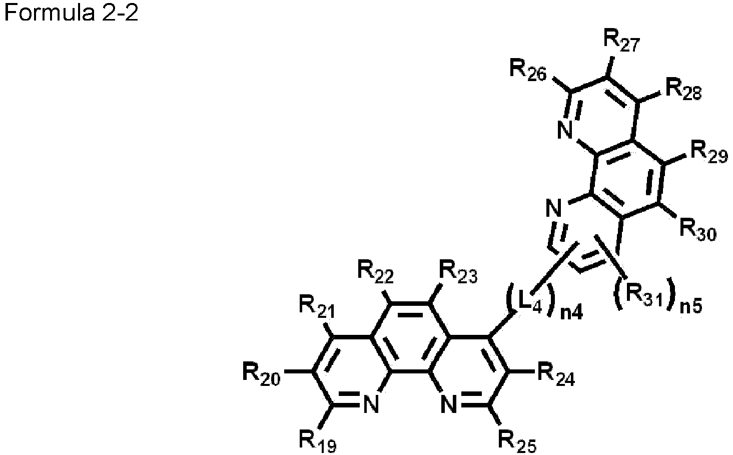

In 2-2, R₁₉ to R₃₁ are each independently a hydrogen atom, a deuterium atom, a substituted or unsubstituted amine group, a substituted or unsubstituted alkyl group having 1 to 20 carbons atoms, a substituted or unsubstituted alkenyl group having 2 to 20 carbon atoms, a substituted or unsubstituted hydrocarbon ring group having 5 to 20 or ring-forming carbon atoms, a substituted or unsubstituted aliphatic heterocyclic group having 2 to 30 ring-forming carbon atoms, a substituted or unsubstituted aryl group having 6 to 30 ring-forming carbon atoms, or a substituted or unsubstituted heteroaryl group having 2 to 30 ring-forming carbon atoms. R₁₉ to R₃₁ may each independently be a hydrogen atom, a deuterium atom, a substituted or unsubstituted amine group, a substituted or unsubstituted methyl group, a substituted or unsubstituted phenyl group, a substituted or unsubstituted naphthyl group, a substituted or unsubstituted pyrrole group, a substituted or unsubstituted pyrazole group, a substituted or unsubstituted imidazole group, a substituted or unsubstituted pyrrolidine group, a substituted or unsubstituted isoindoline group, a substituted or unsubstituted carbazole group, or a substituted or unsubstituted triazine group.

In Formula 2-2, L₄ is a substituted or unsubstituted phenylene group. For example, L₄ may be an unsubstituted phenylene group.

In Formula 2-2, n4 is an integer of 1 to 3. When n4 is an integer of 2 or greater, for example, when n4 is 2 or 3, L₄ provided in a plurality may all be the same, or at least one selected from among the plurality of L₄ may be different.

In Formula 2-2, n5 is an integer of 0 to 2. When n5 is 0, the second compound represented by Formula 2-2 may not be substituted with R₃₁. A case when n5 is 2 and each R₃₁ is a hydrogen atom may be the same as a case in which n5 is 0. When n5 is 2, each of R₃₁ provided in a plurality may be the same, or at least one selected from among the plurality of R₃₁ may be different.

In an embodiment not forming part of the invention, the second compound may be represented by Formula 2-3 or Formula 2-4.

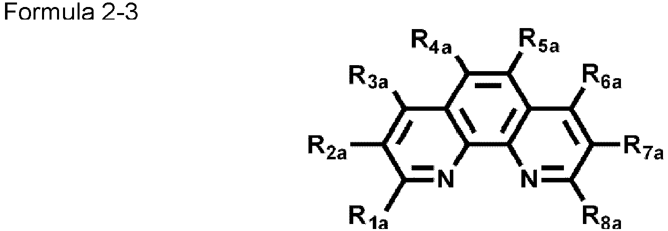

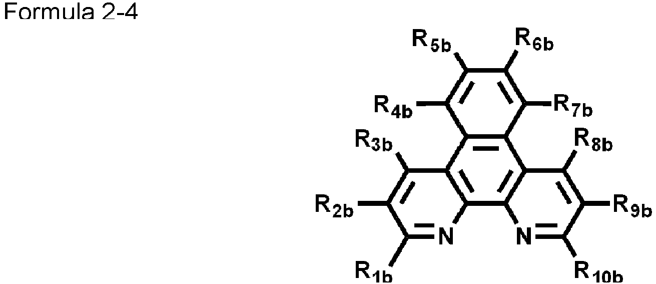

In Formula 2-3 and Formula 2-4, R₁ₐ to R₈ₐ, and R_{1b} to R_{10b} may each independently be a hydrogen atom, a deuterium atom, a substituted or unsubstituted amine group, a substituted or unsubstituted alkyl group having 1 to 20 carbons atoms, a substituted or unsubstituted alkenyl group having 2 to 20 carbon atoms, a substituted or unsubstituted hydrocarbon ring group having 5 to 20 or ring-forming carbon atoms, a substituted or unsubstituted aliphatic heterocyclic group having 2 to 30 ring-forming carbon atoms, a substituted or unsubstituted aryl group having 6 to 30 ring-forming carbon atoms, or a substituted or unsubstituted heteroaryl group having 2 to 30 ring-forming carbon atoms. For example, R₁ₐ to R₈ₐ, and R_{1b} to R_{10b} may each independently be a hydrogen atom, a deuterium atom, a substituted or unsubstituted amine group, a substituted or unsubstituted methyl group, a substituted or unsubstituted phenyl group, a substituted or unsubstituted naphthyl group, a substituted or unsubstituted pyrrole group, a substituted or unsubstituted pyrazole group, a substituted or unsubstituted imidazole group, a substituted or unsubstituted pyrrolidine group, a substituted or unsubstituted isoindoline group, a substituted or unsubstituted carbazole group, or a substituted or unsubstituted triazine group.

The second compound included in the mixed layer MEL according to the invention may be represented by one selected from among compounds 2-2, 2-19, 2-20, 2-21, 2-28 to 2-37, 2-40, 2-41 of Compound Group 2.

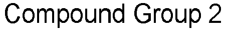

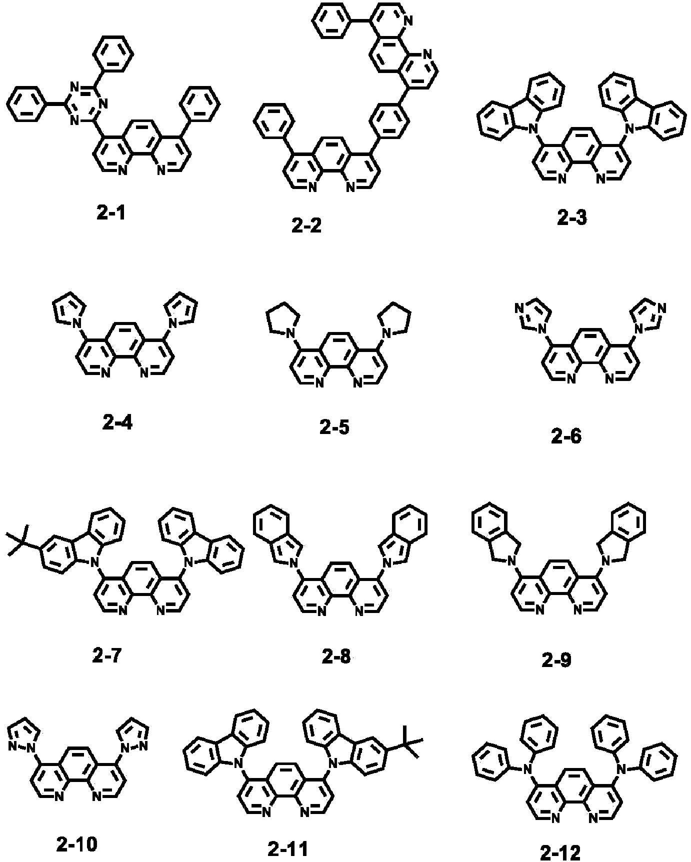

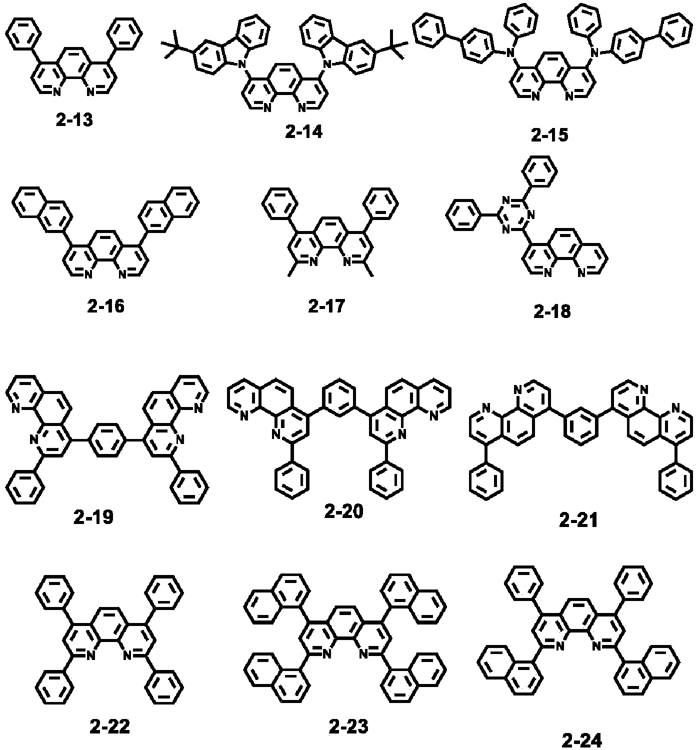

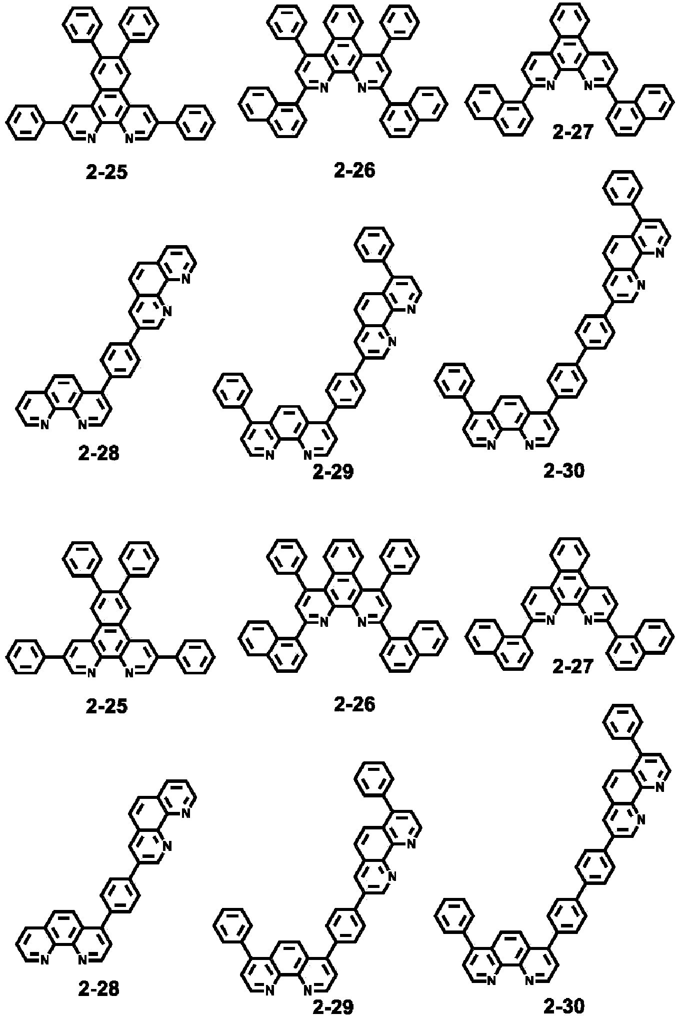

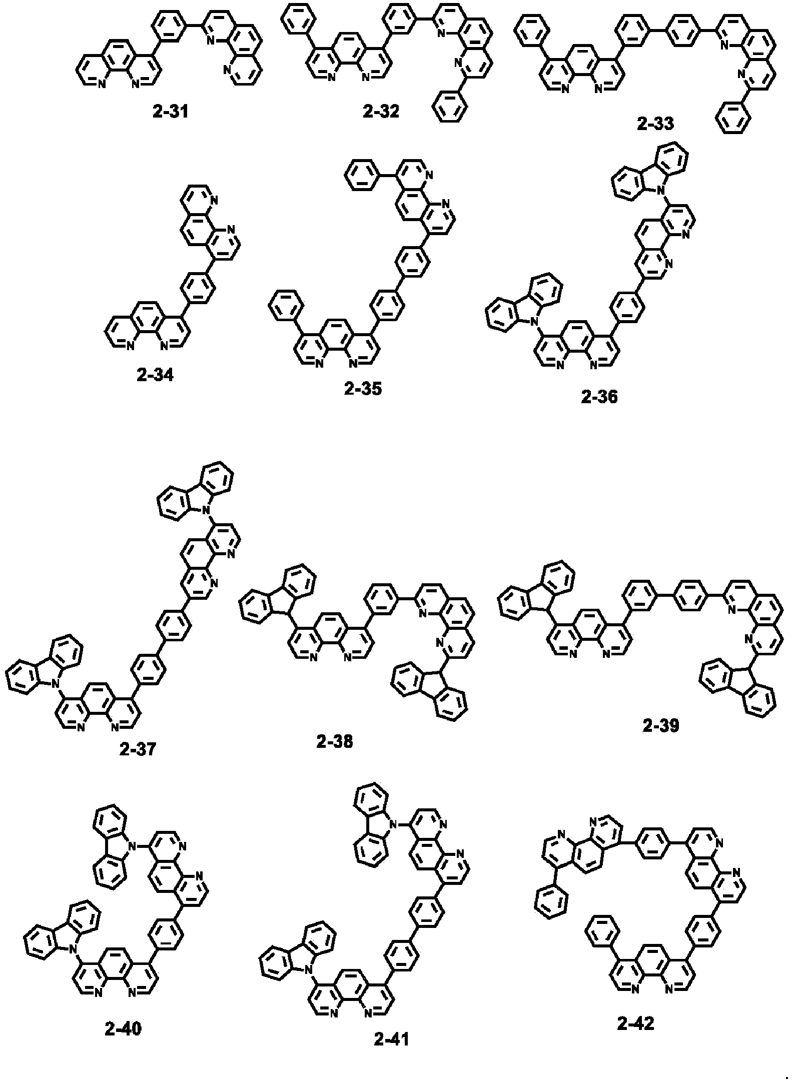

The mixed layer MEL included in the light emitting device ED according to one or more embodiments comprises a structure in which the first compound and the second compound are mixed, so that suitable high efficiency and suitable long lifespan of the light emitting device ED may be implemented.

The first compound included in the mixed layer MEL of one or more embodiments comprises a core having a nitrogen-containing hexagonal heteroaryl moiety, and a cyano group, wherein the core and the cyano group are connected to each other by a first linker comprising at least one aromatic ring. The first compound may have excellent or suitable electron transport capability by comprising the nitrogen-containing hexagonal heteroaryl moiety. In some embodiments, the first compound comprises the cyano group connected to the core through the first linker in the molecular structure, so that a dipole moment may occur in the molecular structure because the cyano group is included, and accordingly, electron carrier injection properties are enhanced or improved, so that a wide recombination zone may be formed due to non-polarization of a carrier biased in the light emitting layer EML. Therefore, the light emitting device ED to which the mixed layer MEL comprising the first compound is applied may have enhanced or improved light emitting efficiency and enhanced or improved lifespan.

The second compound included in the mixed layer MEL of one or more embodiments comprises at least two phenanthroline moieties in the molecular structure, so that migration and/or aggregation of a metal material included in an adjacent layer may be prevented or reduced, and thus, device stability may be enhanced or improved and device lifespan may be enhanced or improved. More specifically, because a "nitrogen atom-metal material-nitrogen atom" connection structure may be formed by nitrogen atoms of the phenanthroline moiety included in the second compound, migration of the metal material may be prevented or reduced, and in particular, aggregation of Ag and/or the like included in the second electrode EL2 and/or the like may be prevented or reduced, so that the light emitting device ED comprising the second compound in the mixed layer MEL may have enhanced or improved device stability, and enhanced or improved lifetime.

The mixed layer MEL may be composed of the first compound and the second compound. In the mixed layer MEL, the ratio of the weight of the first compound and the second compound relative to the total weight of a mixture of the first compound and the second compound may be about 5:95 to about 95:5. For example, in the mixed layer MEL, the ratio of the weight of the first compound and the second compound to the total weight of the first compound and the second compound may be about 3:7 to about 7:3.

The mixed layer MEL may have a smaller thickness than an adjacent electron transport layer ETL. In one or more embodiments, the thickness of the mixed layer MEL may be approximately about 1 Å to approximately about 30 Å.

As illustrated in FIG. 5, the electron transport region ETR may further comprise the additional layer AEL in the light emitting device ED of one or more embodiments. The additional layer AEL may be directly located on an upper surface of the mixed layer MEL. For example, the additional layer AEL is between the mixed layer MEL and the second electrode EL2, and the second electrode EL2 may be directly located on an upper surface of the additional layer AEL. In some embodiments, the additional layer AEL may be referred to as an "electron injection layer."

The additional layer AEL may comprise the second compound as described in more detail herein. For example, the additional layer AEL may comprise the second compound comprising a phenanthroline moiety in the molecular structure thereof. The additional layer AEL may comprise the second compound having a structure represented by Formula 2 described above. The additional layer AEL may be composed of the second compound.

The second compound included in the additional layer AEL and the second compound included in the mixed layer MEL may be the same as or different from each other. In one or more embodiments, the second compound included in the additional layer AEL and the second compound included in the mixed layer MEL may be substantially (e.g., completely), the same material. In some embodiments, each of the second compound included in the additional layer AEL and the second compound included in the mixed layer MEL may comprise a phenanthroline moiety, but may have different substituent structures and/or the like.

The electron transport region ETR may be formed utilizing one or more suitable methods such as vacuum deposition, spin coating, casting, Langmuir-Blodgett (LB), inkjet printing, laser printing, and/or laser induced thermal imaging (LITI).

In some embodiments, the electron transport region ETR may further comprise a suitable electron transport material and a suitable electron injection material.

The electron transport region ETR may comprise a compound represented by Formula ET-2.

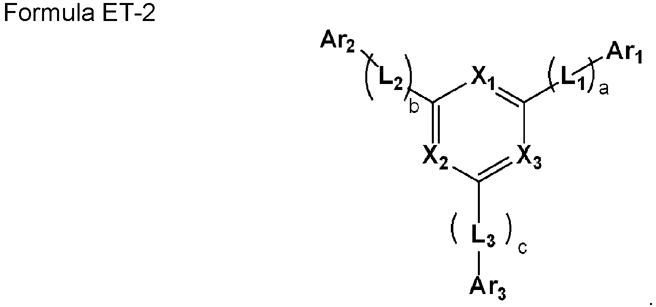

In Formula ET-2, at least one selected from among X₁ to X₃ is N, and the rest is CRₐ. Rₐ may be a hydrogen atom, a deuterium atom, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be a hydrogen atom, a deuterium atom, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a to c are each an integer of 2 or greater, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

The electron transport region ETR may comprise an anthracene-based compound. However, the embodiment of the present disclosure is not limited thereto. The electron transport region ETR may be, for example, Tris(8-hydroxyquinolinato)aluminum (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-Tri(1-phenyl-1H-benzo[d]imidazol-2-yl)benzene (TPBi), 2,9-Dimethyl-4,7-diphenyl-1,10-phenanthroline (BCP), 4,7-Diphenyl-1,10-phenanthroline (Bphen), 3-(4-Biphenylyl)-4-phenyl-5-tert-butylphenyl-1,2,4-triazole (TAZ), 4-(Naphthalen-1-yl)-3,5-diphenyl-4H-1,2,4-triazole (NTAZ), 2-(4-Biphenylyl)-5-(4-tert-butylphenyl)-1,3,4-oxadiazole (tBu-PBD), Bis(2-methyl-8-quinolinolato-N1,08)-(1,1'-Biphenyl-4-olato)aluminum (BAIq), berylliumbis(benzoquinolin-10-olate) (Bebq₂), 9,10-di(naphthalene-2-yl)anthracene (ADN), 1,3-Bis[3,5-di(pyridin-3-yl)phenyl]benzene (BmPyPhB), and/or a mixture thereof.

The electron transport region ETR may comprise at least one selected from among Compounds ET1 to ET36.

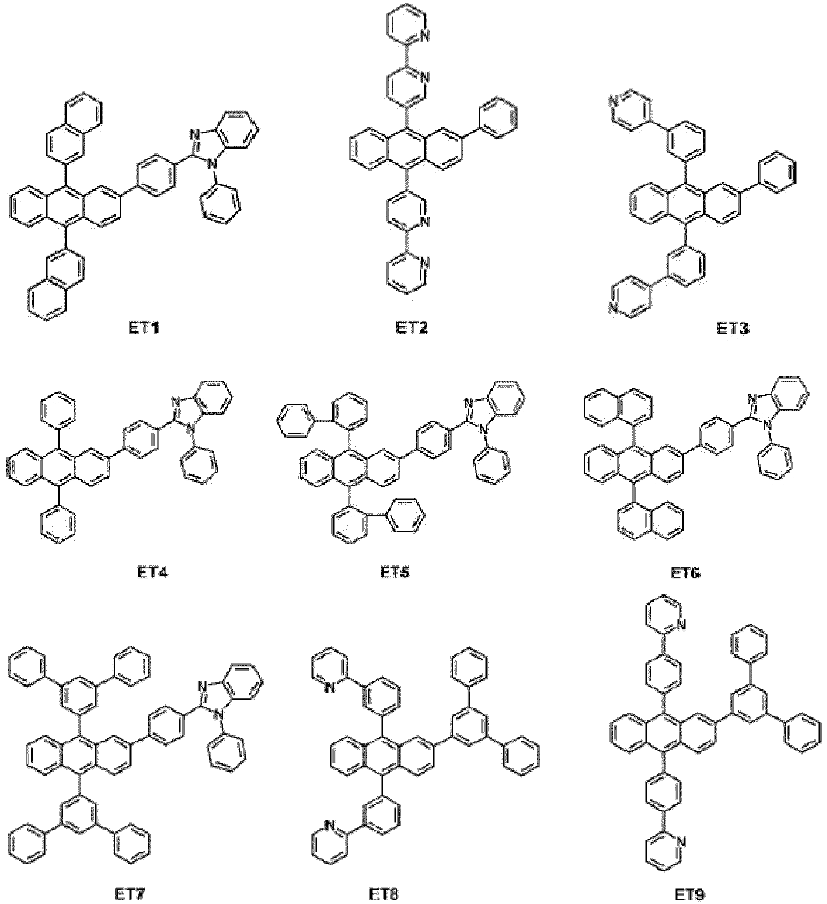

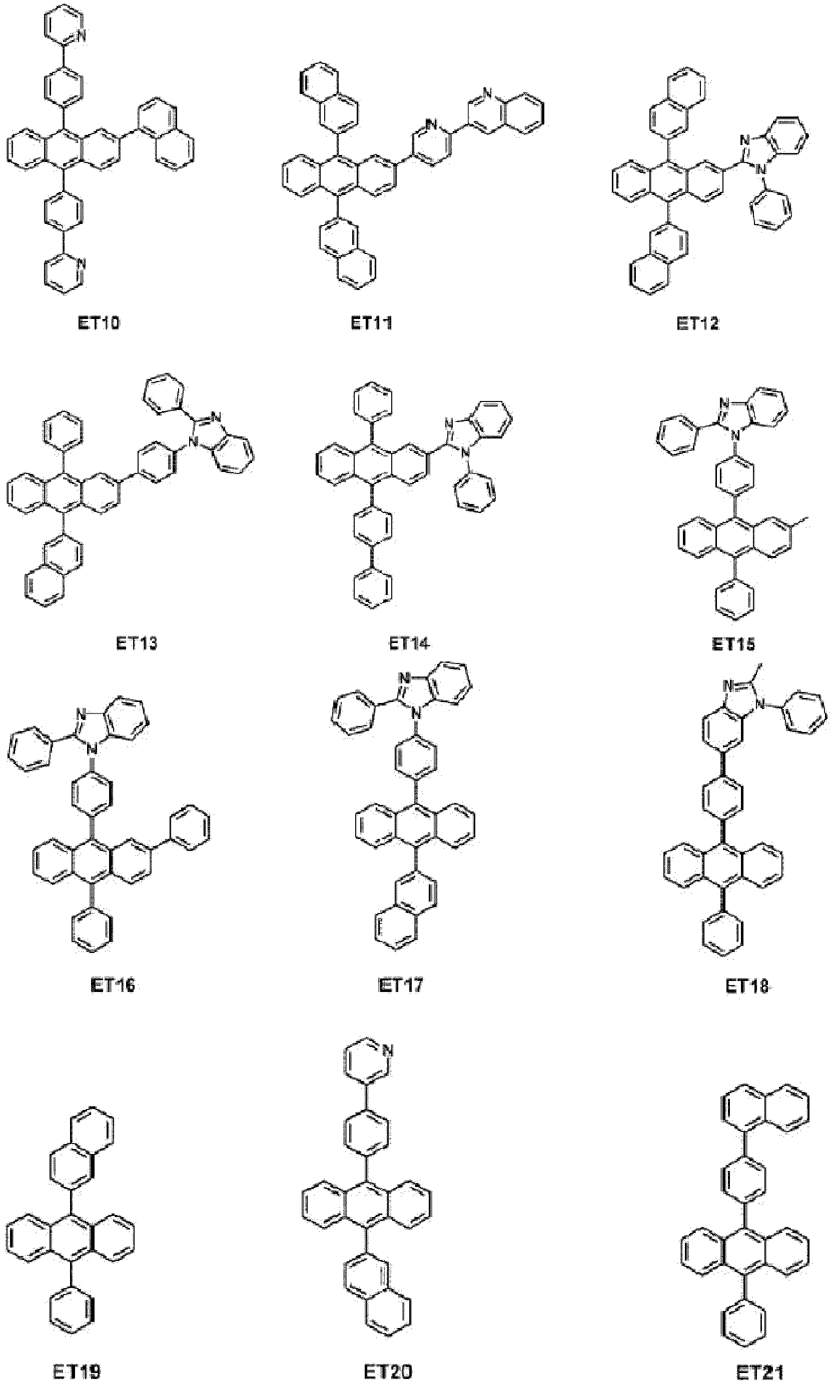

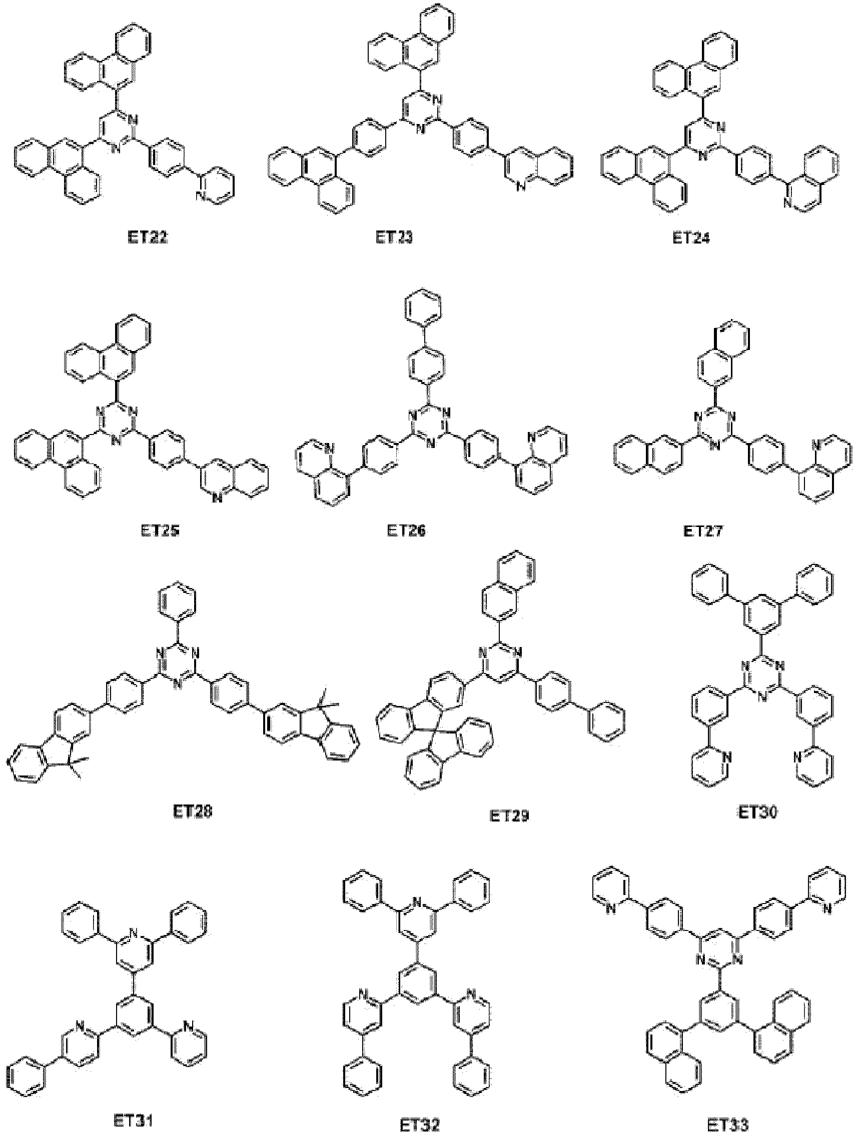

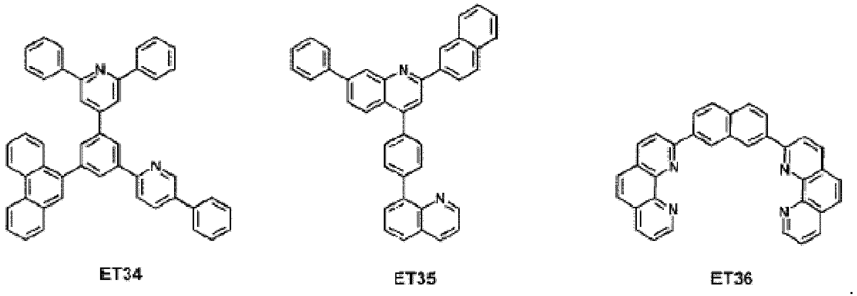

In some embodiments, the electron transport region ETR may comprise a halogenated metal such as LiF, NaCl, CsF, RbCl, Rbl, Cul, and/or KI, a lanthanum group metal such as Yb, or a co-deposition material of the halogenated metal and the lanthanum group metal. For example, the electron transport region ETR may comprise KI:Yb, RbI:Yb, LiF:Yb, and/or the like as the co-deposition material. In some embodiments, as the electron transport region ETR, a metal oxide such as Li₂O and/or BaO, or 8-hydroxyl-Lithium quinolate (Liq) and/or the like may be utilized, but the embodiment of the present disclosure is not limited thereto. The electron transport region ETR may also comprise (e.g., be composed of or consist essentially of) a mixture of an electron transport material and an insulating organo metal salt. The organo metal salt may be a material having an energy band gap of about 4 eV or greater. For example, the organo metal salt may comprise metal acetate, metal benzoate, metal acetoacetate, metal acetylacetonate, and/or metal stearate.

The electron transport region ETR may further comprise at least one selected from among 2,9-dimethyl-4,7-diphenyl-1,10-phenanthroline (BCP), diphenyl(4-(triphenylsilyl)phenyl)phosphine oxide (TSPO1), and/or 4,7-diphenyl-1,10-phenanthroline (Bphen), but the embodiment of the present disclosure is not limited thereto.

The electron transport region ETR may comprise any of the above-described compounds of the electron transport region in at least one selected from among the electron injection layer EIL, the electron transport layer ETL, and/or the hole blocking layer HBL.

When the electron transport region ETR comprises the electron transport layer ETL, the thickness of the electron transport layer ETL may be about 100 Å to about 1000 Å, for example, about 150 Å to about 500 Å. When the thickness of the electron transport layer ETL satisfies any of the above-described ranges, satisfactory or suitable electron transport properties may be obtained without a substantial increase in driving voltage. When the electron transport region ETR comprises the electron injection layer EIL, the thickness of the electron injection layer EIL may be about 1 Å to about 100 Å, or about 3 Å to about 90 Å. When the thickness of the electron injection layer EIL satisfies any of the above-described ranges, satisfactory or suitable electron injection properties may be obtained without a substantial increase in a driving voltage.

The second electrode EL2 is provided on the electron transport region ETR. The second electrode EL2 may be a common electrode. The second electrode EL2 may be a cathode or an anode, but the embodiment of the present disclosure is not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is a transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is a transflective electrode or reflective electrode, the second electrode EL2 may comprise Ag, Mg, Cu, Al, Pt, Pd, Au, Ni, Nd, Ir, Cr, Li, Ca, LiF/Ca, LiF/Al, Mo, Ti, Yb, W, a compound thereof, and/or a mixture thereof (for example, AgMg, AgYb, and/or MgYb). In some embodiments, the second electrode EL2 may have a multi-layered structure comprising a reflective film or transflective film formed of any of the above exemplified materials, and a transparent conductive film formed of indium tin oxide (ITO), indium zinc oxide (IZO), zinc oxide (ZnO), indium tin zinc oxide (ITZO), and/or the like. For example, the second electrode EL2 may comprise any one of the above-described metal materials, a combination of two or more selected from the above-described metal materials, an oxide of any one of the above-described metal materials, and/or the like.

In some embodiments, the second electrode EL2 may be connected to an auxiliary electrode. When the second electrode EL2 is connected to the auxiliary electrode, the resistance of the second electrode EL2 may be reduced.

In some embodiments, the capping layer CPL may be located on the second electrode EL2 of the light emitting device ED of one or more embodiments. The capping layer CPL may comprise multilayers, or a single layer.

In one or more embodiments, the capping layer CPL may be an organic layer, or an inorganic layer. For example, when the capping layer CPL comprises an inorganic substance, the inorganic substance may comprise an alkaline metal compound such as LiF, an alkaline earth metal compound such as MgF₂, SiON, SiNₓ, SiOy, and/or the like.

For example, when the capping layer CPL comprises an organic substance, the organic substance may comprise α-NPD, NPB, TPD, m-MTDATA, Alq₃, CuPc, N4,N4,N4',N4'-tetra (biphenyl-4-yl) biphenyl-4,4'-diamine (TPD15), 4,4',4"- Tris (carbazol-9-yl) triphenylamine (TCTA), and/or the like, and/or may comprise an epoxy resin, and/or an acrylate such as a methacrylate. However, the embodiment of the present disclosure is not limited thereto. The capping layer CPL may comprise at least one selected from among the following compounds P1 to P5.

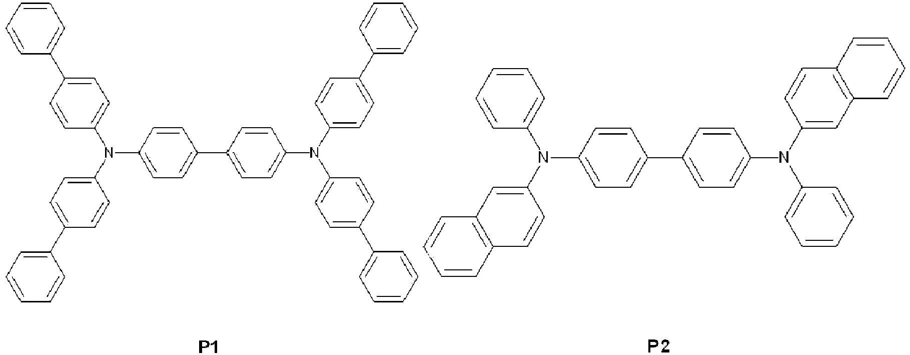

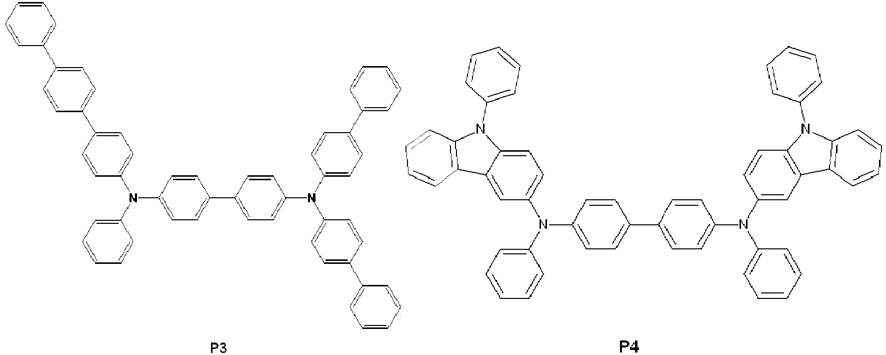

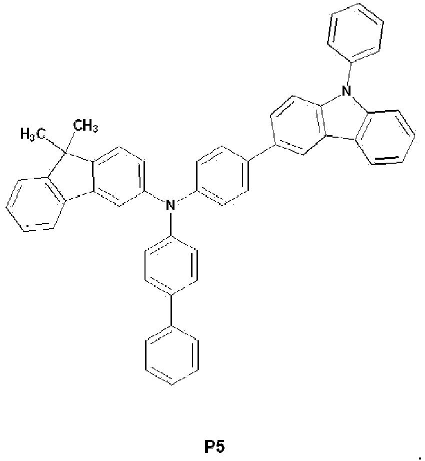

In some embodiments, the refractive index of the capping layer CPL may be about 1.6 or greater. For example, for light in a wavelength region of about 550 nm to about 660 nm, the refractive index of the capping layer CPL may be about 1.6 or greater.

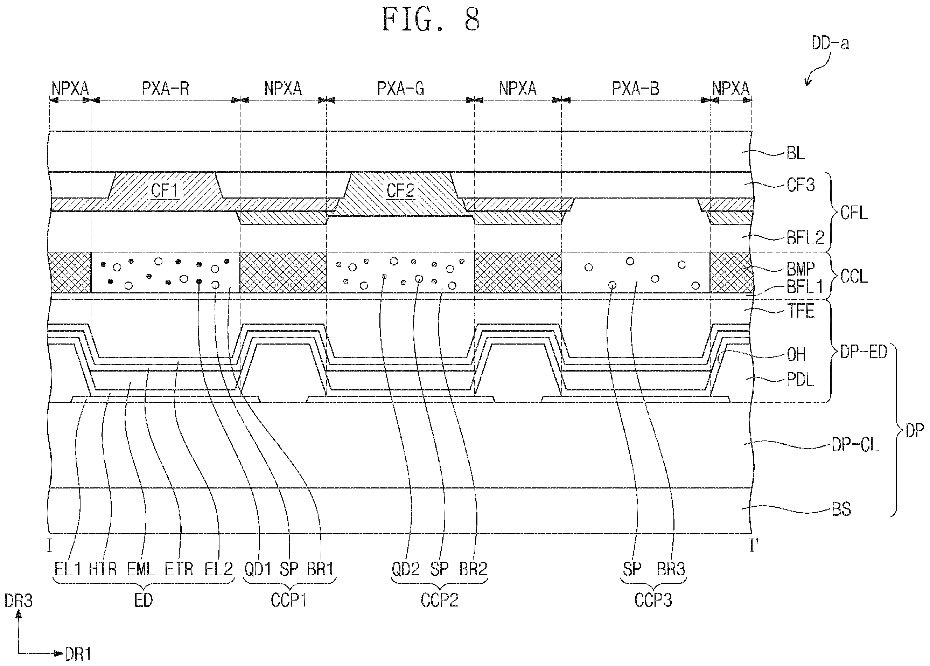

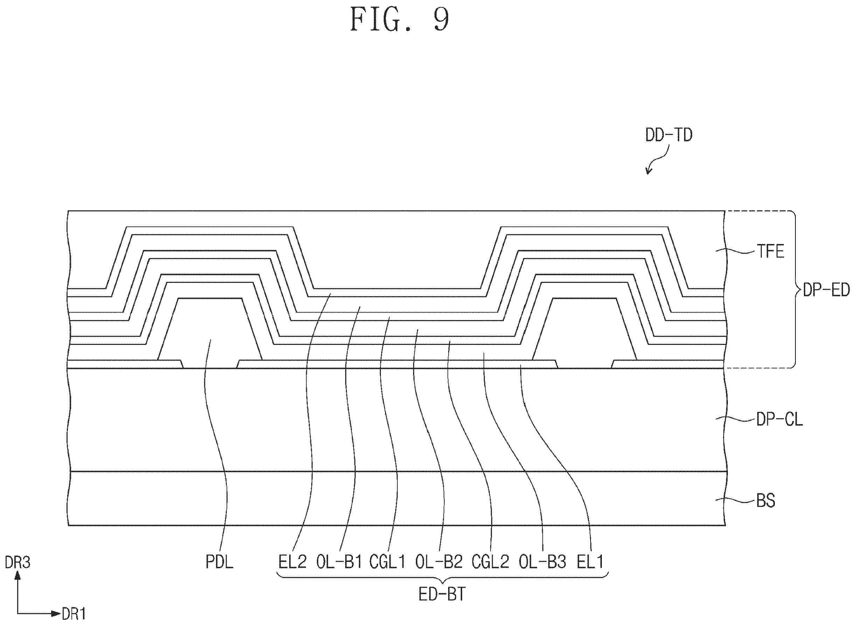

FIG. 8 and FIG. 9 are each a cross-sectional view of a display device according to one or more embodiments of the present disclosure. Hereinafter, in a description of a display device of one or more embodiments to be provided with reference to FIG. 8 and FIG. 9, the same contents as those described above with reference to FIG. 1 to FIG. 7 will not be repeated. Instead, the description will mainly focus on the differences.

Referring to FIG. 8, a display device DD-a according to one or more embodiments may comprise a display panel DP having a display element layer DP-ED, a light control layer CCL located at (e.g., on), the display panel DP, and a color filter layer CFL.

Referring to FIG. 8, the display panel DP may comprise a base layer BS, a circuit layer DP-CL located at (e.g., on), the base layer BS, and a display element layer DP-ED, and the display element layer DP-ED may comprise a light emitting device ED.

The light emitting device ED may comprise a first electrode EL1, a hole transport region HTR located at (e.g., on), the first electrode EL1, a light emitting layer EML located at (e.g., on), the hole transport region HTR, an electron transport region ETR located at (e.g., on), the light emitting layer EML, and a second electrode EL2 located at (e.g., on), the electron transport region ETR. In some embodiments, the description of the structure of the light emitting device of FIG. 3 to FIG. 7 provided above may be applied to the structure of the light emitting device ED illustrated in FIG. 8.

The electron transport region ETR of the light emitting device ED comprised in the display device DD-a according to one or more embodiments may comprise a mixed layer of one or more embodiments described above.

Referring to FIG. 8, the light emitting layer EML may be located at (e.g., in), an opening OH defined in a pixel definition film PDL. For example, the light emitting layer EML separated by the pixel definition film PDL and provided corresponding to each light emitting region PXA-R, PXA-G, and PXA-B may be to emit light of the same wavelength region. In one or more embodiments of the display device DD-a, the light emitting layer EML may be to emit blue light. In some embodiments, the light emitting layer EML may be provided as a common layer to (e.g., extending across) all of the light emitting regions PXA-R, PXA-G, and PXA-B.

The light control layer CCL may be located at (e.g., on), the display panel DP. The light control layer CCL may comprise a light converting body. The light converting body may be a quantum dot, a fluorescent body, and/or the like. The light converting body may wavelength-convert provided light and emit the converted light. For example, the light control layer CCL may be a layer comprising a quantum dot, and/or a layer comprising a fluorescent body.

The light control layer CCL may comprise a plurality of light control units CCP1, CCP2, and CCP3. The light control units CCP1, CCP2, and CCP3 may be spaced (e.g., spaced apart) from each other.

Referring to FIG. 8, a dividing pattern BMP may be located between the light control units CCP1, CCP2, and CCP3 that are spaced apart from each other, but the embodiment of the present disclosure is not limited thereto. In FIG. 8, the dividing pattern BMP is illustrated as not overlapping the light control units CCP1, CCP2, and CCP3, but in some embodiments, edges of the light control units CCP1, CCP2, and CCP3 may overlap at least a portion of the dividing pattern BMP.

The light control layer CCL may comprise a first light control unit CCP1 comprising a first quantum dot QD1 configured to convert a first color light provided from the light emitting device ED to a second color light, a second light control unit CCP2 comprising a second quantum dot QD2 configured to convert the first color light to a third color light, and a third light control unit CCP3 configured to transmit the first color light.

In one or more embodiments, the first light control unit CCP1 may provide red light, which is the second color light, and the second light control unit CCP2 may provide green light, which is the third color light. The third light control unit CCP3 may be to transmit and provide blue light which is the first color light provided from the light emitting device ED. For example, the first quantum dot QD1 may be a red quantum dot, and the second quantum dot QD2 may be a green quantum dot. The same descriptions as those provided herein in connection with quantum dots may be applied to the quantum dots QD1 and QD2.

In some embodiments, the light control layer CCL may further comprise a scattering body SP. The first light control unit CCP1 may comprise the first quantum dot QD1 and the scattering body SP, the second light control unit CCP2 may comprise the second quantum dot QD2 and the scattering body SP, and the third light control unit CCP3 may not comprise (e.g., may exclude) a (e.g., any) quantum dot but may comprise the scattering body SP.

The scattering body SP may be an inorganic particle. For example, the scattering body SP may comprise at least one selected from among TiO₂, ZnO, Al₂O₃, SiO₂, and/or hollow silica. The scattering body SP may comprise any one selected from among TiO₂, ZnO, Al₂O₃,SiO₂, and/or hollow silica, or may be a mixture of two or more materials selected from among TiO₂, ZnO, Al₂O₃, SiO₂, and/or hollow silica.

Each of the first light control unit CCP1, the second light control unit CCP2, and the third light control unit CCP3 may comprise base resins BR1, BR2, and BR3 which disperse the quantum dots QD1 and QD2 and the scattering body SP, respectively. In one or more embodiments, the first light control unit CCP1 may comprise the first quantum dot QD1 and the scattering body SP dispersed in a first base resin BR1, the second light control unit CCP2 may comprise the second quantum dot QD2 and the scattering body SP dispersed in a second base resin BR2, and the third light control unit CCP3 may comprise the scattering body SP dispersed in a third base resin BR3. The base resins BR1, BR2, and BR3 are media in which the quantum dots QD1 and QD2 and the scattering body SP are dispersed, and may be formed of one or more suitable resin compositions which may be generally referred to as a binder. For example, the base resins BR1, BR2, and BR3 may each be an acrylic resin, a urethane-based resin, a silicone-based resin, an epoxy resin, and/or the like. The base resins BR1, BR2, and BR3 may each be a transparent resin. In one or more embodiments, the first base resin BR1, the second base resin BR2, and the third base resin BR3 may be the same or different from each other.

The light control layer CCL may comprise a barrier layer BFL1. The barrier layer BFL1 may serve to prevent or reduce the penetration of moisture and/or oxygen (hereinafter, referred to as 'moisture/oxygen'). The barrier layer BFL1 may be disposed on the light control units CCP1, CCP2, and CCP3 and may block or reduce exposure of the light control units CCP1, CCP2, CCP3 to moisture/oxygen. In some embodiments, the barrier layer BFL1 may cover the light control units CCP1, CCP2, and CCP3. In some embodiments, a barrier layer BFL2 may be provided between the color filter layer CFL and the light control units CCP1, CCP2, CCP3.

The barrier layers BFL1 and BFL2 may comprise at least one inorganic layer. For example, the barrier layers BFL1 and BFL2 may be formed by including an inorganic material. For example, the barrier layers BFL1 and BFL2 may be formed by including silicon nitride, aluminum nitride, zirconium nitride, titanium nitride, hafnium nitride, tantalum nitride, silicon oxide, aluminum oxide, titanium oxide, tin oxide, cerium oxide and/or silicon oxynitride, a thin metal film having light transmittance, and/or the like. In some embodiments, the barrier layers BFL1 and BFL2 may further comprise an organic film. The barrier layers BFL1 and BFL2 may be formed of a single layer or a plurality of layers.

In the display device DD-a of one or more embodiments, the color filter layer CFL may be located on the light control layer CCL. For example, the color filter layer CFL may be directly on the light control layer CCL. In this case, the barrier layer BFL2 may not be provided (e.g., may be omitted).

The color filter layer CFL may comprise a light blocking part BM and filters CF1, CF2, and CF3. The color filter layer CFL may comprise a first filter CF1 for transmitting the second color light, a second filter CF2 for transmitting the third color light, and a third filter CF3 for transmitting the first color light. For example, the first filter CF may be a red filter, the second filter CF2 may be a green filter, and the third filter CF3 may be a blue filter. Each of the filters CF1, CF2, and CF3 may comprise a polymer photosensitive resin and a pigment and/or dye. In a non-limiting example, the first filter CF1 may comprise a red pigment and/or a red dye, the second filter CF2 may comprise a green pigment and/or a green dye, and the third filter CF3 may comprise a blue pigment and/or a blue dye. In one or more embodiments, the third filter CF3 may not comprise (e.g., may exclude) a (e.g., any) pigment or a dye. The third filter CF3 may comprise a polymer photosensitive resin but may not comprise (e.g., may exclude) a (e.g., any) pigment or a dye. The third filter CF3 may be transparent. The third filter CF3 may be formed of a transparent photosensitive resin.

In one or more embodiments, the first filter CF1 and the second filter CF2 may be a yellow filter. For example, the first filter CF1 and the second filter CF2 may be provided as one body (e.g., integrally with each other) without being distinguished from each other.

The light blocking part BM may be a black matrix. The light blocking part BM may be formed by including an organic light blocking material and/or an inorganic light blocking material which comprises a black pigment and/or a black dye. The light blocking part BM prevents or reduces a light leakage phenomenon and may distinguish boundaries between adjacent filters CF1, CF2, and CF3. In one or more embodiments, the light blocking part BM may be formed of a blue filter.

The first to third filters CF1, CF2, and CF3 may be configured or located corresponding to a red light emitting region PXA-R, a green light emitting region PXA-G, and a blue light emitting region PXA-B, respectively.

At (e.g., on), the color filter layer CFL, a base substrate BL may be located. The base substrate BL may be a member which provides a base surface on which the color filter layer CFL, the light control layer CCL, and/or the like are located. The base substrate BL may be a glass substrate, a metal substrate, a plastic substrate, and/or the like. However, the embodiment of the present disclosure is not limited thereto, and the base substrate BL may be an inorganic layer, an organic layer, or a composite material layer. In some embodiments, the base substrate BL may not be provided (e.g., may be omitted).

FIG. 9 is a cross-sectional view showing a portion of a display device according to one or more embodiments. In a display device DD-TD of one or more embodiments, a light emitting device ED-BT may comprise a plurality of light emitting structures OL-B1, OL-B2, and OL-B3. The light emitting device ED-BT may comprise a first electrode EL1 and a second electrode EL2 facing each other, and the plurality of light emitting structures OL-B1, OL-B2, and OL-B3 sequentially laminated and provided in a thickness direction of the display device between the first electrode EL1 and the second electrode EL2. Each of the light emitting structures OL-B1, OL-B2, and OL-B3 may comprise a hole transport region HTR and an electron transport region ETR, with the light emitting layer EML (see FIG. 8) located therebetween.

For example, the light emitting device ED-BT included in the display device DD-TD of one or more embodiments may be a light emitting device of a tandem structure comprising a plurality of light emitting layers.

In one or more embodiments illustrated in FIG. 9, the light emitted from each of the light emitting structures OL-B1, OL-B2, and OL-B3 may all be blue light. However, the embodiment of the present disclosure is not limited thereto. The wavelength region of light emitted from each of the light emitting structures OL-B1, OL-B2, and OL-B3 may be different from each other. For example, the light emitting device ED-BT comprising a plurality of light emitting structures OL-B1, OL-B2, and OL-B3 for emitting light of different wavelength regions may be to emit white light.

Between adjacent light emitting structures OL-B1, OL-B2, and OL-B3, a charge generation layer CGL1 and CGL2 may be located. The charge generation layer CGL1 and CGL2 may comprise a p-type charge generation layer and/or an n-type charge generation layer.

The mixed layer of one or more embodiments described above may be included in at least one selected from among the light emitting structures OL-B1, OL-B2, and OL-B3 included in the display device DD-TD of one or more embodiments. For example, at least one selected from among a plurality of electron transport regions included in a light emitting device ED-BT may include the mixed layer of one or more embodiments.

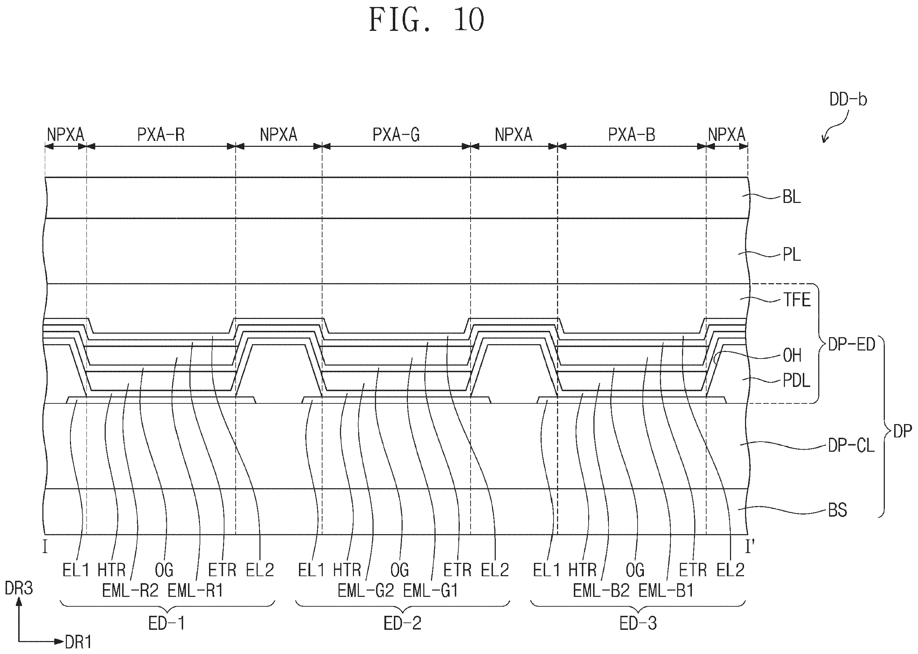

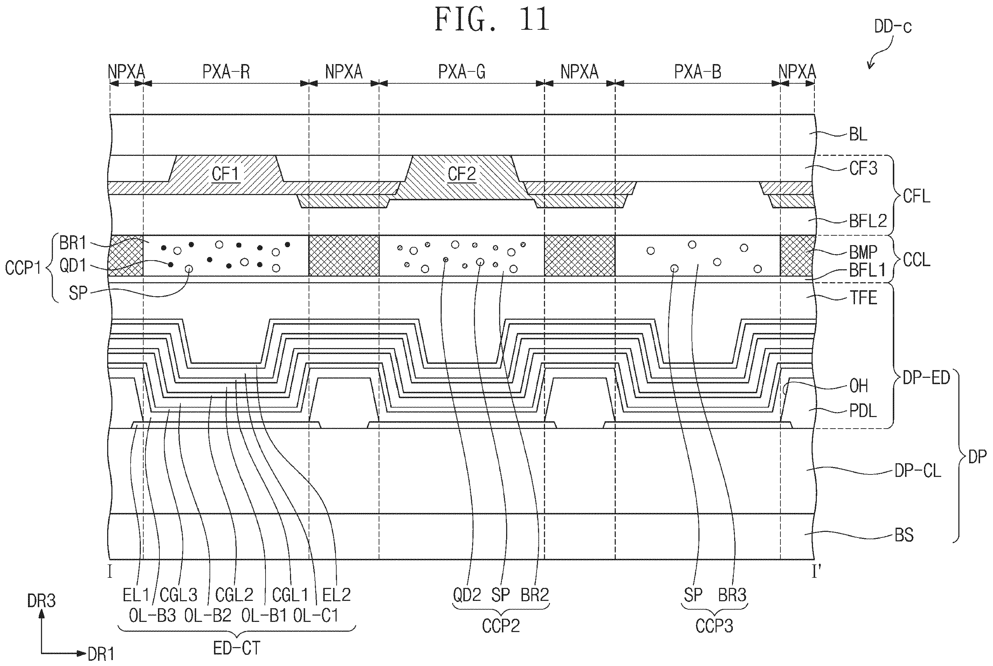

FIG. 10 is a cross-sectional view showing a display device according to one or more embodiments of the present disclosure. FIG. 11 is a cross-sectional view showing a display device according to one or more embodiments of the present disclosure.

Referring to FIG. 10, a display device DD-b according to one or more embodiments may comprise light emitting devices ED-1, ED-2, and ED-3 in which two light emitting layers are laminated. The embodiment illustrated in FIG. 10 differs from the display device DD of one or more embodiments illustrated in FIG. 2 in that first to third light emitting devices ED-1, ED-2, and ED-3 each comprise two light emitting layers laminated in a thickness direction of the display device. The two light emitting layers in each of the first to third light emitting devices ED-1, ED-2, and ED-3 may be to emit light of the same wavelength region.

The first light emitting device ED-1 may comprise a first red light emitting layer EML-R1 and a second red light emitting layer EML-R2. The second light emitting device ED-2 may comprise a first green light emitting layer EML-G1 and a second green light emitting layer EML-G2. In some embodiments, the third light emitting device ED-3 may comprise a first blue light emitting layer EML-B1 and a second blue light emitting layer EML-B2. Between the first red light emitting layer EML-R1 and the second red light emitting layer EML-R2, between the first green light emitting layer EML-G1 and the second green light emitting layer EML-G2, and between the first blue light emitting layer EML-B1 and the second blue light emitting layer EML-B2, a light emitting auxiliary unit OG may be located.

The light emitting auxiliary unit OG may comprise a single layer or multiple layers. The light emitting auxiliary unit OG may comprise a charge generation layer. For example, the light emitting auxiliary unit OG may comprise an electron transport region, the charge generation layer, and a hole transport region which are sequentially laminated. The light emitting auxiliary unit OG may be provided as a common layer to (e.g., extending across) all of the first to third light emitting devices ED-1, ED-2, and ED-3. However, the embodiment of the present disclosure is not limited thereto, and the light emitting auxiliary unit OG may be patterned and provided in an opening portion OH defined on a pixel definition film PDL.

The first red light emitting layer EML-R1, the first green light emitting layer EML-G1, and the first blue light emitting layer EML-B1 may be located between an electron transport region ETR and the light emitting auxiliary unit OG. The second red light emitting layer EML-R2, the second green light emitting layer EML-G2, and the second blue light emitting layer EML-B2 may be located between the light emitting auxiliary unit OG and a hole transport region HTR.

For example, the first light emitting device ED-1 may comprise a first electrode EL1, a hole transport region HTR, a second red light emitting layer EML-R2, a light emitting auxiliary unit OG, a first red light emitting layer EML-R1, an electron transport region ETR, and a second electrode EL2 which are sequentially laminated. The second light emitting device ED-2 may comprise a first electrode EL1, a hole transport region HTR, a second green light emitting layer EML-G2, a light emitting auxiliary unit OG, a first green light emitting layer EML-G1, an electron transport region ETR, and a second electrode EL2 which are sequentially laminated. The third light emitting device ED-3 may comprise a first electrode EL1, a hole transport region HTR, a second blue light emitting layer EML-B2, a light emitting auxiliary unit OG, a first blue light emitting layer EML-B1, an electron transport region ETR, and a second electrode EL2 which are sequentially laminated.

In some embodiments, on the display element layer DP-ED, an optical auxiliary layer PL may be located. The optical auxiliary layer PL may comprise a polarizing layer. The optical auxiliary layer PL may be located on the display panel DP to control reflective light in the display panel DP caused by external light. In a display device of one or more embodiments, the optical auxiliary layer PL may not be included (e.g., may be omitted).

At least one light emitting layer included in the display device DD-b of one or more embodiments illustrated in FIG. 10 may comprise the mixed layer of one or more embodiments. For example, in one or more embodiments, electron transport region may comprise the mixed layer.

Unlike the embodiments of FIG. 9 and FIG. 10, a display device DD-c of FIG. 11 is illustrated as comprising four light emitting structures OL-B1, OL-B2, OL-B3, and OL-C1. A light emitting device ED-CT may comprise a first electrode EL1 and a second electrode EL2 facing each other, and first to fourth light emitting structures OL-B1, OL-B2, OL-B3, and OL-C1 sequentially laminated in a thickness direction between the first electrode EL1 and the second electrode EL2. Charge generation layers CGL1, CGL2, and CGL3 may be located between the first to fourth light emitting structures OL-B1, OL-B2, OL-B3, and OL-C1. Among the four light emitting structures, the first to third light emitting structures OL-B1, OL-B2, and OL-B3 may be to emit blue light, and the fourth light emitting structure OL-C1 may be to emit green light. However, the embodiment of the present disclosure is not limited thereto, and the first to fourth light emitting structures OL-B1, OL-B2, OL-B3, and OL-C1 may be to emit light of different wavelength regions.

The charge generation layers CGL1, CGL2, and CGL3 located between adjacent light emitting structures OL-B1, OL-B2, OL-B3, and OL-C1 may comprise a p-type charge generation layer and/or an n-type charge generation layer.

The mixed layer of one or more embodiments, respectively, may be included in at least one selected from among the light emitting structures OL-B1, OL-B2, OL-B3, and OL-C1 included in the display device DD-c of one or more embodiments. For example, in one or more embodiments, at least one selected from among the first to third light emitting structures OL-B1, OL-B2, and OL-B3 may comprise the mixed layer of one or more embodiments.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein comprise and are intended to disclose all subsumed sub-ranges of the same numerical precision. For example, a range of "1.0 to 10.0" comprises all subranges having a minimum value equal to or greater than 1.0 and a maximum value equal to or less than 10.0, such as, for example, 2.4 to 7.6. Applicant therefore reserves the right to amend this specification, comprising the claims, to expressly recite any sub-range subsumed within the ranges expressly recited herein.

The light emitting device, the display device and/or any other relevant devices or components according to embodiments of the present disclosure described herein may be implemented utilizing any suitable hardware, firmware (e.g., an application-specific integrated circuit), software, or a combination of software, firmware, and hardware. For example, the various components of the light emitting device and/or the display device may be formed on one integrated circuit (IC) chip or on separate IC chips. Further, the various components of the devices may be implemented on a flexible printed circuit film, a tape carrier package (TCP), a printed circuit board (PCB), or formed on one substrate. Further, the various components of the devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Hereinafter, referring to Examples and Comparative Examples, the mixed layer according to one or more embodiments of the present disclosure and the light emitting device of one or more embodiments will be described in more detail. In some embodiments, Examples shown below are for illustrative purposes only to facilitate the understanding of the present disclosure, and thus, the scope of the present disclosure is not limited thereto.

### EXAMPLES

### 1. Manufacturing and evaluation of light emitting device including Example compounds

A light emitting device of one or more embodiments comprising the first compound and the second compound in a mixed layer of an electron transport region was manufactured by the following method. Light emitting devices of Example 1 to Example 26 were manufactured respectively utilizing Compound 1-1, Compound 1-2, Compound 1-12, Compound 1-28, Compound 1-42, and Compound 1-43 as the first compounds, and Compound 2-1, Compound 2-2, Compound 2-3, Compound 2-21, and Compound 2-41 as the second compounds, as materials for the mixed layer. The devices of Examples 5, 6, 8, 10, 12, 14, 18, 19, 20, 25, and 26 correspond to light emitting devices further comprising an additional layer on the mixed layer. The devices of Comparative Example 1 and Comparative Example 5 correspond to light emitting devices which do not comprise a mixed layer in an electron transport region, and the devices of Comparative Example 2 to Comparative Example 4 correspond to light emitting devices in which a layer corresponding to the mixed layer is formed of a single material. In the device of Comparative Example 2, the following Comparative Example compound C1 is utilized as a material for forming the layer corresponding to the mixed layer.

### Example compounds and reference compounds 2-1 and 2-3

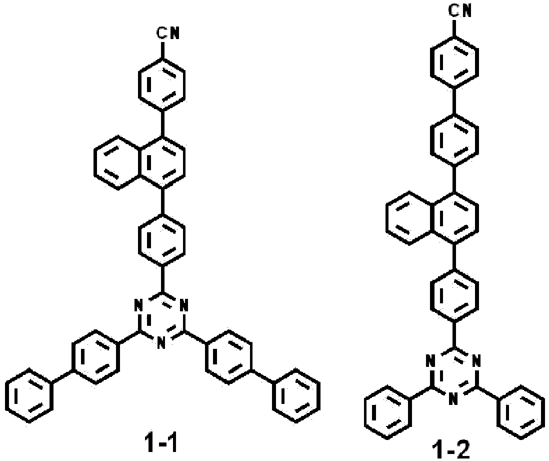

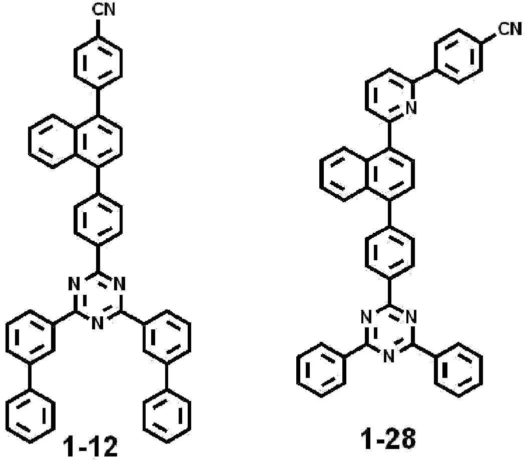

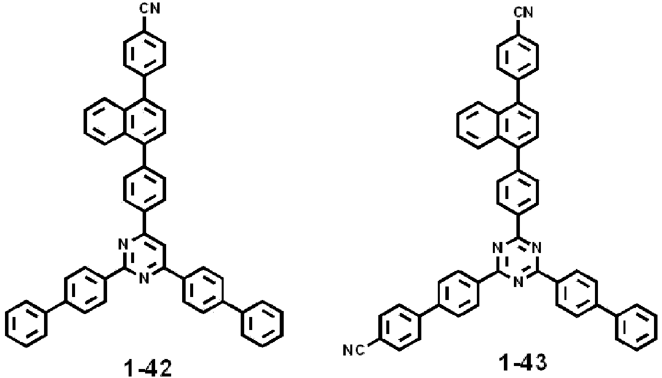

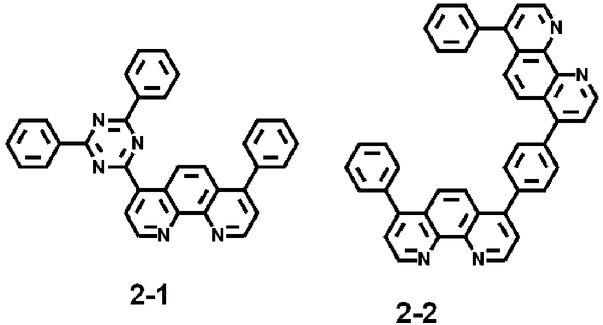

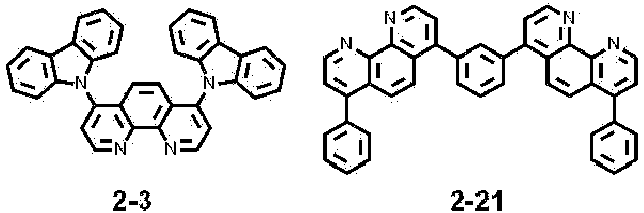

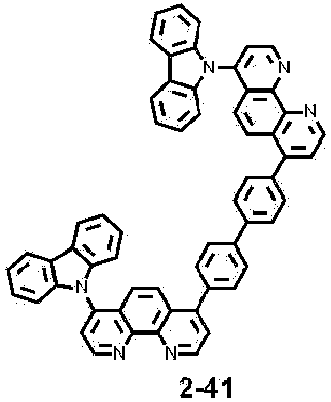

### Comparative Example compounds

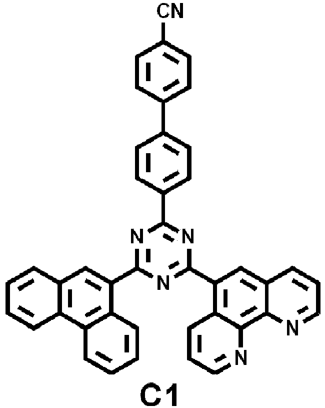

### Manufacturing of light emitting device of Reference Example 1

In the light emitting device of Example 1, a glass substrate (manufactured by Corning Inc.) having an ITO electrode of 15 Ω/cm² (1200 Å) as an anode was cut to a size of 50mm x 50mm x 0.5 mm, ultrasonically cleaned for 5 minutes utilizing isopropyl alcohol and pure water, and then irradiated with ultraviolet rays for 30 minutes and exposed to ozone to be cleaned, and then mounted on a vacuum deposition apparatus.

In an upper portion of the anode, HT-01 was deposited to form a hole injection layer having a thickness of 200 Å, and then HT-02 was deposited in an upper portion of the hole injection layer to form a hole transport layer having a thickness of 600 Å, followed by depositing CzSi in an upper portion of the hole transport layer to form a light emitting auxiliary layer having a thickness of 100 Å.

Thereafter, EML-1-01, EML-2-01, and PD-01 were co-deposited at a weight ratio of 50:35:15 to form a light emitting layer having a thickness of 400 Å, and then an electron transport layer ETL and 8-hydroxyl-Lithium quinolate (Liq) were co-deposited in an upper portion of the light emitting layer to form an electron transport layer having a thickness of 300 Å, followed by co-depositing Compound 1-1 and Compound 2-1 in an upper portion of the electron transport layer at a weight ratio of 50:50 to form a mixed layer having a thickness of 20 Å. Next, Mg and Ag were co-deposited in an upper portion of the mixed layer at a weight ratio of 90:10 to provide a cathode having a thickness of 3000 Å. HT-01 was deposited in an upper portion of the electrode to form a capping layer having a thickness of 700 Å. Each layer was formed by vacuum deposition.

### Manufacturing of light emitting device of Example 2

When compared to the light emitting device of Example 1, a light emitting device was manufactured in substantially the same manner as the manner in which the light emitting device of Example 1 was manufactured, except that Compound 2-2 was utilized instead of Compound 2-1 when forming a mixed layer.

### Manufacturing of light emitting device of Reference Example 3

When compared to the light emitting device of Example 1, a light emitting device was manufactured in substantially the same manner as the manner in which the light emitting device of Example 1 was manufactured, except that Compound 1-2 was utilized instead of Compound 1-1 when forming a mixed layer.

### Manufacturing of light emitting device of Example 4

When compared to the light emitting device of Example 1, a light emitting device was manufactured in substantially the same manner as the manner in which the light emitting device of Example 1 was manufactured, except that Compound 1-2 was utilized instead of Compound 1-1, and Compound 2-2 was utilized instead of Compound 2-1 when forming a mixed layer.

### Manufacturing of light emitting device of Reference Example 5

When compared to the light emitting device of Example 1, a light emitting device was manufactured in substantially the same manner as the manner in which the light emitting device of Example 1 was manufactured, except that after a mixed layer was formed, an additional layer having a thickness of 10 Å was formed on the mixed layer utilizing Compound 2-1.

### Manufacturing of light emitting device of Example 6

When compared to the light emitting device of Example 5, a light emitting device was manufactured in substantially the same manner as the manner in which the light emitting device of Example 5 was manufactured, except that Compound 1-2 was utilized instead of Compound 1-1, Compound 2-2 was utilized instead of Compound 2-1, and Compound 2-2 was utilized instead of Compound 2-1 when forming an additional layer.

### Manufacturing of light emitting device of Reference Example 7

When compared to the light emitting device of Example 1, a light emitting device was manufactured in substantially the same manner as the manner in which the light emitting device of Example 1 was manufactured, except that Compound 1-12 was utilized instead of Compound 1-1 when forming a mixed layer.

### Manufacturing of light emitting device of Reference Example 8

When compared to the light emitting device of Example 5, a light emitting device was manufactured in substantially the same manner as the manner in which the light emitting device of Example 5 was manufactured, except that Compound 1-12 was utilized instead of Compound 1-1 when forming a mixed layer.

### Manufacturing of light emitting device of Example 9

When compared to the light emitting device of Example 1, a light emitting device was manufactured in substantially the same manner as the manner in which the light emitting device of Example 1 was manufactured, except that Compound 1-28 was utilized instead of Compound 1-1, and Compound 2-2 was utilized instead of Compound 2-1 when forming a mixed layer.

### Manufacturing of light emitting device of Example 10

When compared to the light emitting device of Example 5, a light emitting device was manufactured in substantially the same manner as the manner in which the light emitting device of Example 5 was manufactured, except that Compound 1-28 was utilized instead of Compound 1-1, Compound 2-2 was utilized instead of Compound 2-1, and Compound 2-2 was utilized instead of Compound 2-1 when forming an additional layer.

### Manufacturing of light emitting device of Reference Example 11

When compared to the light emitting device of Example 1, a light emitting device was manufactured in substantially the same manner as the manner in which the light emitting device of Example 1 was manufactured, except that Compound 2-3 was utilized instead of Compound 2-1 when forming a mixed layer.

### Manufacturing of light emitting device of Reference Example 12

When compared to the light emitting device of Example 5, a light emitting device was manufactured in substantially the same manner as the manner in which the light emitting device of Example 5 was manufactured, except that Compound 2-3 was utilized instead of Compound 2-1 when forming a mixed layer, and Compound 2-3 was utilized instead of Compound 2-1 when forming an additional layer.

### Manufacturing of light emitting device of Example 13

When compared to the light emitting device of Example 1, a light emitting device was manufactured in substantially the same manner as the manner in which the light emitting device of Example 1 was manufactured, except that Compound 1-2 was utilized instead of Compound 1-1, and Compound 2-21 was utilized instead of Compound 2-1 when forming a mixed layer.

### Manufacturing of light emitting device of Example 14

When compared to the light emitting device of Example 5, a light emitting device was manufactured in substantially the same manner as the manner in which the light emitting device of Example 5 was manufactured, except that Compound 1-2 was utilized instead of Compound 1-1, and Compound 2-21 was utilized instead of Compound 2-1 when forming a mixed layer, and Compound 2-21 was utilized instead of Compound 2-1 when forming an additional layer.

### Manufacturing of light emitting device of Reference Example 15

When compared to the light emitting device of Example 1, a light emitting device was manufactured in substantially the same manner as the manner in which the light emitting device of Example 1 was manufactured, except that Compound 1-42 was utilized instead of Compound 1-1 when forming a mixed layer.

### Manufacturing of light emitting device of Reference Example 16

When compared to the light emitting device of Example 1, a light emitting device was manufactured in substantially the same manner as the manner in which the light emitting device of Example 1 was manufactured, except that Compound 1-43 was utilized instead of Compound 1-1 when forming a mixed layer.

### Manufacturing of light emitting device of Example 17

When compared to the light emitting device of Example 1, a light emitting device was manufactured in substantially the same manner as the manner in which the light emitting device of Example 1 was manufactured, except that Compound 2-42 was utilized instead of Compound 2-1 when forming a mixed layer.

### Manufacturing of light emitting device of Reference Example 18

When compared to the light emitting device of Example 5, a light emitting device was manufactured in substantially the same manner as the manner in which the light emitting device of Example 5 was manufactured, except that Compound 1-42 was utilized instead of Compound 1-1 when forming a mixed layer.

### Manufacturing of light emitting device of Reference Example 19

When compared to the light emitting device of Example 5, a light emitting device was manufactured in substantially the same manner as the manner in which the light emitting device of Example 5 was manufactured, except that Compound 1-43 was utilized instead of Compound 1-1 when forming a mixed layer.

### Manufacturing of light emitting device of Example 20

When compared to the light emitting device of Example 5, a light emitting device was manufactured in substantially the same manner as the manner in which the light emitting device of Example 5 was manufactured, except that Compound 2-42 was utilized instead of Compound 2-1 when forming a mixed layer, and Compound 2-42 was utilized instead of Compound 2-1 when forming an additional layer.

### Manufacturing of light emitting device of Reference Example 21

In the light emitting device of Example 21, a glass substrate (manufactured by Corning Inc.) having an ITO electrode of 15 Ω/cm² (1200 Å) as an anode was cut to a size of 50 mm x 50 mm x 0.5 mm, ultrasonically cleaned for 5 minutes utilizing isopropyl alcohol and pure water, and then irradiated with ultraviolet rays for 30 minutes and exposed to ozone to be cleaned, and then mounted on a vacuum deposition apparatus.

In an upper portion of the anode, HT-01 was deposited to form a hole injection layer having a thickness of 200 Å, and then HT-02 was deposited in an upper portion of the hole injection layer to form a hole transport layer having a thickness of 600 Å, followed by depositing CzSi in an upper portion of the hole transport layer to form a light emitting auxiliary layer having a thickness of 100 Å.

Thereafter, EML-1-01, EML-2-01, PD-01, and TD-01 were co-deposited at a weight ratio of 50:30:15:5 to form a light emitting layer having a thickness of 400 Å, and then ETL and Liq were co-deposited in an upper portion of the light emitting layer to form an electron transport layer having a thickness of 300 Å, followed by co-depositing Compound 1-1 and Compound 2-1 in an upper portion of the electron transport layer at a weight ratio of 50:50 to form a mixed layer having a thickness of 20 Å. Next, MgAg was deposited in an upper portion of the mixed layer at a weight ratio of 90:10 to provide a cathode having a thickness of 3000 Å. HT-01 was deposited in an upper portion of the electrode to form a capping layer having a thickness of 700 Å. Each layer was formed by vacuum deposition.

### Manufacturing of light emitting device of Example 22

When compared to the light emitting device of Example 21, a light emitting device was manufactured in substantially the same manner as the manner in which the light emitting device of Example 21 was manufactured, except that Compound 2-2 was utilized instead of Compound 2-1 when forming a mixed layer.

### Manufacturing of light emitting device of Reference Example 23

When compared to the light emitting device of Example 21, a light emitting device was manufactured in substantially the same manner as the manner in which the light emitting device of Example 21 was manufactured, except that Compound 1-2 was utilized instead of Compound 1-1 when forming a mixed layer.

### Manufacturing of light emitting device of Example 24

When compared to the light emitting device of Example 21, a light emitting device was manufactured in substantially the same manner as the manner in which the light emitting device of Example 21 was manufactured, except that Compound 1-2 was utilized instead of Compound 1-1, and Compound 2-2 was utilized instead of Compound 2-1 when forming a mixed layer.

### Manufacturing of light emitting device of Reference Example 25

When compared to the light emitting device of Example 21, a light emitting device was manufactured in substantially the same manner as the manner in which the light emitting device of Example 21 was manufactured, except that after a mixed layer was formed, an additional layer having a thickness of 10 Å was formed on the mixed layer utilizing Compound 2-1.

### Manufacturing of light emitting device of Example 26

When compared to the light emitting device of Example 25, a light emitting device was manufactured in substantially the same manner as the manner in which the light emitting device of Example 25 was manufactured, except that Compound 1-2 was utilized instead of Compound 1-1, Compound 2-2 was utilized instead of Compound 2-1, and Compound 2-2 was utilized instead of Compound 2-1 when forming an additional layer.

### Manufacturing of light emitting device of Comparative Example 1

In the light emitting device of Comparative Example 1, a glass substrate (manufactured by Corning Inc.) having an ITO electrode of 15 Ω/cm² (1200 Å) as an anode was cut to a size of 50mm x 50mm x 0.5 mm, ultrasonically cleaned for 5 minutes utilizing isopropyl alcohol and pure water, and then irradiated with ultraviolet rays for 30 minutes and exposed to ozone to be cleaned, and then mounted on a vacuum deposition apparatus.

In an upper portion of the anode, HT-01 was deposited to form a hole injection layer having a thickness of 200 Å, and then HT-02 was deposited in an upper portion of the hole injection layer to form a hole transport layer having a thickness of 600 Å, followed by depositing CzSi in an upper portion of the hole transport layer to form a light emitting auxiliary layer having a thickness of 100 Å.

Thereafter, EML-1-01, EML-2-01, and PD-01 were co-deposited at a weight ratio of 50:35:15 to form a light emitting layer having a thickness of 400 Å, and then ETL and Liq were co-deposited in an upper portion of the light emitting layer to form an electron transport layer having a thickness of 300 Å, followed by depositing Yb in an upper portion of the electron transport layer to form an electron injection layer having a thickness of 20 Å. Next, MgAg was deposited in an upper portion of the electron injection layer at a weight ratio of 90:10 to provide a cathode having a thickness of 3000 Å. HT-01 was deposited in an upper portion of the electrode to form a capping layer having a thickness of 700 Å. Each layer was formed by vacuum deposition.

### Manufacturing of light emitting device of Comparative Example 2

When compared to the light emitting device of Comparative Example 1, a light emitting device was manufactured in substantially the same manner as the manner in which the light emitting device of Comparative Example 1 was manufactured, except that an electron transport layer was formed, and then a layer corresponding to a mixed layer having a thickness of 20 Å was formed on the electron transport layer utilizing Comparative Example Compound C1, and the electron injection layer was not formed.

### Manufacturing of light emitting device of Comparative Example 3

When compared to the light emitting device of Comparative Example 1, a light emitting device was manufactured in substantially the same manner as the manner in which the light emitting device of Comparative Example 1 was manufactured, except that an electron transport layer was formed, and then a layer corresponding to a mixed layer having a thickness of 20 Å was formed on the electron transport layer utilizing Compound 1-1, and the electron injection layer was not formed.

### Manufacturing of light emitting device of Comparative Example 4

When compared to the light emitting device of Comparative Example 1, a light emitting device was manufactured in substantially the same manner as the manner in which the light emitting device of Comparative Example 1 was manufactured, except that an electron transport layer was formed, and then a layer corresponding to a mixed layer having a thickness of 20 Å was formed on the electron transport layer utilizing Compound 2-1, and the electron injection layer was not formed.

### Manufacturing of light emitting device of Comparative Example 5

In the light emitting device of Comparative Example 5, a glass substrate (manufactured by Corning Inc.) having an ITO electrode of 15 Ω/cm² (1200 Å) as an anode was cut to a size of 50mm x 50mm x 0.5 mm, ultrasonically cleaned for 5 minutes utilizing isopropyl alcohol and pure water, and then irradiated with ultraviolet rays for 30 minutes and exposed to ozone to be cleaned, and then mounted on a vacuum deposition apparatus.

In an upper portion of the anode, HT-01 was deposited to form a hole injection layer having a thickness of 200 Å, and then HT-02 was deposited in an upper portion of the hole injection layer to form a hole transport layer having a thickness of 600 Å, followed by depositing CzSi in an upper portion of the hole transport layer to form a light emitting auxiliary layer having a thickness of 100 Å.

Thereafter, EML-1-01, EML-2-01, PD-01, and TD-01 were co-deposited at a weight ratio of 50:30:15:5 to form a light emitting layer having a thickness of 400 Å, and then ETL and Liq were co-deposited in an upper portion of the light emitting layer to form an electron transport layer having a thickness of 300 Å, followed by depositing Yb in an upper portion of the electron transport layer to form an electron injection layer having a thickness of 20 Å. Next, MgAg was deposited in an upper portion of the electron injection layer at a weight ratio of 90:10 to provide a cathode having a thickness of 3000 Å. HT-01 was deposited in an upper portion of the electrode to form a capping layer having a thickness of 700 Å. Each layer was formed by vacuum deposition.

The compounds utilized in the manufacturing of the light emitting devices of Examples and Comparative Examples are disclosed below. The following materials are commercially available products which were purified by sublimation and utilized for the manufacturing of the devices.

### Compound structure

| | |
|---|---|
| HT-01 | 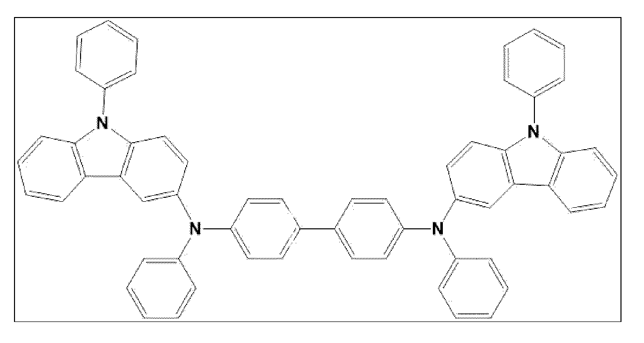 |
| HT-02 | 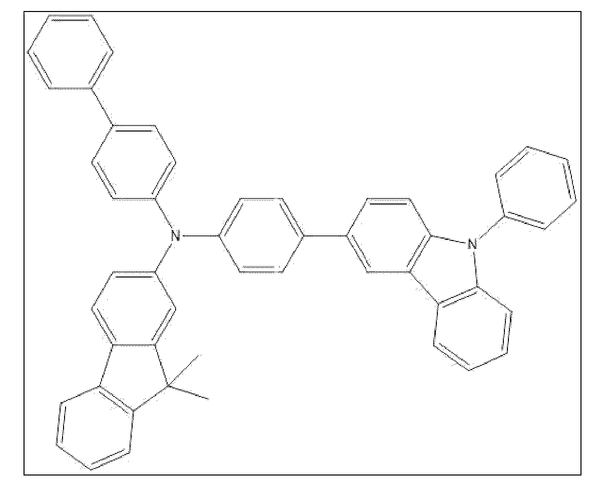 |
| CzSi | 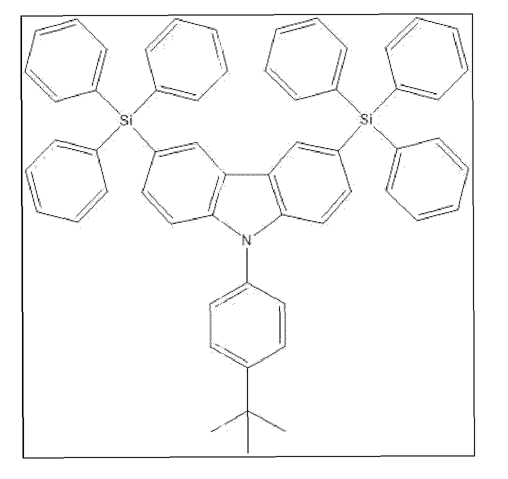 |
| EML-1-01 | 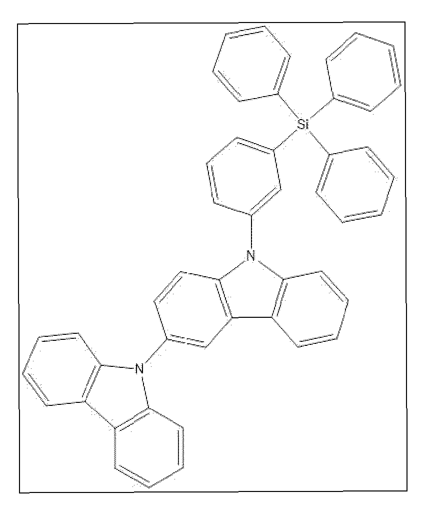 |
| EML-2-01 | 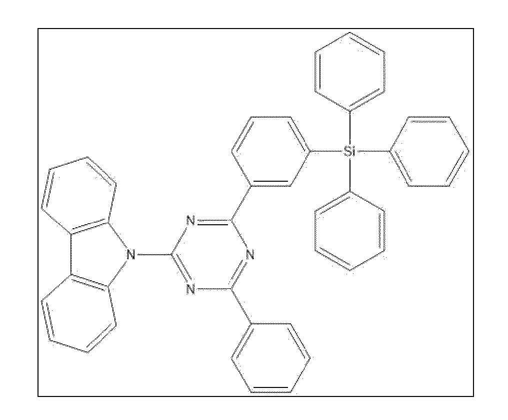 |
| PD-01 | 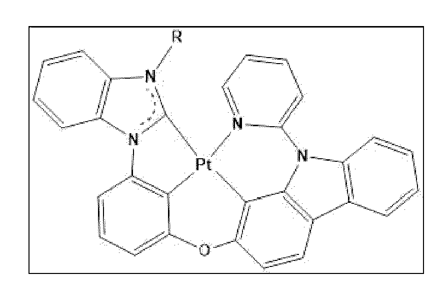 |
| TD-01 | 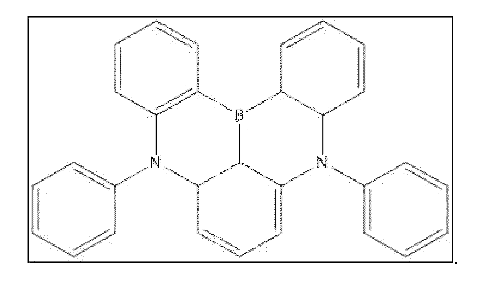 |

### Evaluation of properties of light emitting device

The device efficiency and device lifespan of the light emitting devices manufactured according to the above-described device manufacturing examples were evaluated. Table 1 shows evaluation results of the light emitting devices of Example 1 to Example 20, and Comparative Example 1 to Comparative Example 4. Table 2 shows evaluation results of the light emitting devices of Example 21 to 26, and Comparative Example 5. Properties of the light emitting devices manufactured in Examples 1 to 20, and Comparative Examples 1 to 4 are shown in Table 1 by calculating relative efficiency and relative lifespan with respect to the device of Comparative Example 1. Properties of the light emitting devices manufactured in Examples 21 to 26, and Comparative Examples 5 are shown in Table 2 by calculating relative efficiency and relative lifespan with respect to the device of Comparative Example 5. In some embodiments, the light emitting efficiency reported as candela per ampere (Cd/A) of the light emitting devices at 1000 cd/m², and the lifespan thereof were measured utilizing Keithley SMU 236 and luminance meters SR3AR and PR650, and the lifespan was measured as the time required for the luminance to reach 90% of the initial luminance.

**Table 1**

| | **Mixed layer** | **Additional layer (Electron injection layer)** | **Efficiency (%)** | **Lifespan ratio (%)** |
|---|---|---|---|---|
| Example 1 | Compound 1-1 | X | 106 | 112 |
| | Compound 2-1 | | | |
| Example 2 | Compound 1-1 | X | 105 | 109 |
| | Compound 2-2 | | | |
| Example 3 | Compound 1-2 | X | 105 | 107 |
| | Compound 2-1 | | | |
| Example 4 | Compound 1-2 | X | 107 | 110 |
| | Compound 2-2 | | | |
| Example 5 | Compound 1-1 | Compound 2-1 | 106 | 117 |
| | Compound 2-1 | | | |
| Example 6 | Compound 1-2 | Compound 2-2 | 107 | 114 |
| | Compound 2-2 | | | |
| Example 7 | Compound 1-12 | X | 104 | 109 |
| | Compound 2-1 | | | |
| Example 8 | Compound 1-12 | Compound 2-1 | 104 | 113 |
| | Compound 2-1 | | | |
| Example 9 | Compound 1-28 | X | 104 | 107 |
| | Compound 2-2 | | | |
| Example 10 | Compound 1-28 | Compound 2-2 | 105 | 109 |
| | Compound 2-2 | | | |
| Example 11 | Compound 1-1 | X | 105 | 110 |
| | Compound 2-3 | | | |
| Example 12 | Compound 1-1 | Compound 2-3 | 105 | 115 |
| | Compound 2-3 | | | |
| Example 13 | Compound 1-2 | X | 105 | 112 |
| | Compound 2-21 | | | |
| Example 14 | Compound 1-2 | Compound 2-21 | 107 | 119 |
| | Compound 2-21 | | | |
| Example 15 | Compound 1-42 | X | 104 | 111 |
| | Compound 2-1 | | | |
| Example 16 | Compound 1-43 | X | 104 | 109 |
| | Compound 2-1 | | | |
| Example 17 | Compound 1-1 | X | 105 | 114 |
| | Compound 2-42 | | | |
| Example 18 | Compound 1-42 | Compound 2-1 | 105 | 118 |
| | Compound 2-1 | | | |
| Example 19 | Compound 1-43 | Compound 2-1 | 104 | 115 |
| | Compound 2-1 | | | |
| Example 20 | Compound 1-1 | Compound 2-42 | 105 | 119 |
| | Compound 2-42 | | | |
| Comparative Example 1 | X | Yb | 100 | 100 |
| Comparative Example 2 | Comparative Example compound C1 | X | 100 | 101 |
| Comparative Example 3 | Compound 1-1 | X | 102 | 83 |
| Comparative Example 4 | Compound 2-1 | X | 95 | 102 |

**Table 2**

| | **Mixed layer** | **Additional layer (Electron injection layer)** | **Efficiency (%)** | **Lifespan ratio (%)** |
|---|---|---|---|---|
| Example 21 | Compound 1-1 | X | 104 | 114 |
| | Compound 2-1 | | | |
| Example 22 | Compound 1-1 | X | 104 | 116 |
| | Compound 2-2 | | | |
| Example 23 | Compound 1-2 | X | 104 | 107 |
| | Compound 2-1 | | | |
| Example 24 | Compound 1-2 | X | 103 | 111 |
| | Compound 2-2 | | | |
| Example 25 | Compound 1-1 | Compound 2-1 | 105 | 119 |
| | Compound 2-1 | | | |
| Example 26 | Compound 1-2 | Compound 2-2 | 106 | 116 |
| | Compound 2-2 | | | |
| Comparative Example 5 | X | Yb | 100 | 100 |

Referring to the results of Table 1 and Table 2, in the case of Examples of the light emitting devices comprising the mixed layer of the first compound and the second compound in the electron transport region, according to one or more embodiments of the present disclosure, the light emitting efficiency and lifespan properties are enhanced or improved compared to those of Comparative Examples. For example, it is believed that in addition to having enhanced or improved light emitting efficiency and lifespan properties compared to the devices of Comparative Example 1 and Comparative Example 5, which do not comprise a mixed layer, the light emitting devices of Examples have enhanced or improved light emitting efficiency and lifespan properties compared to the devices of Comparative Example 2 to Comparative Example 4 in which the layer corresponding to the mixed layer is formed of a single material.

The light emitting devices of Examples comprise the first compound in the mixed layer, wherein the first compound comprises a cyano group, so that a dipole moment may occur in the molecular structure, and accordingly, electron carrier injection properties are improved, so that a wide recombination zone may be formed due to non-polarization of a carrier biased in the light emitting layer. The light emitting devices of Examples further comprise the second compound in the mixed layer, wherein the second compound comprises a phenanthroline moiety, so that migration and aggregation of a metal material included in an adjacent layer may be prevented or reduced. Accordingly, the light emitting devices of Examples which comprise the mixed layer may have excellent or suitable light emitting efficiency and device lifespan.

A light emitting device of one or more embodiments may exhibit enhanced or improved device properties with high efficiency and long lifespan.

A display device of one or more embodiments may comprise a light emitting device with excellent or suitable efficiency and lifespan.

Although the present disclosure has been described with reference to embodiments of the present disclosure, it will be understood by those skilled in the art that one or more suitable changes in form and details may be made therein without departing from the scope of the present disclosure as set forth in the following claims.

Accordingly, the technical scope of the present disclosure is not intended to be limited to the contents set forth in the detailed description of the specification, but is intended to be defined by the appended claims.

## Claims

1. A light emitting device (ED) comprising:
a first electrode (EL1);
a hole transport region (HTR) on the first electrode;
a light emitting layer (EML) on the hole transport region;
an electron transport region (ETR) on the light emitting layer; and
a second electrode (EL2) on the electron transport region,
**characterised in that** the electron transport region comprises:
a mixed layer (MEL) comprising a first compound represented by Formula 1 and a second compound different from the first compound and represented by Formula 2-2: 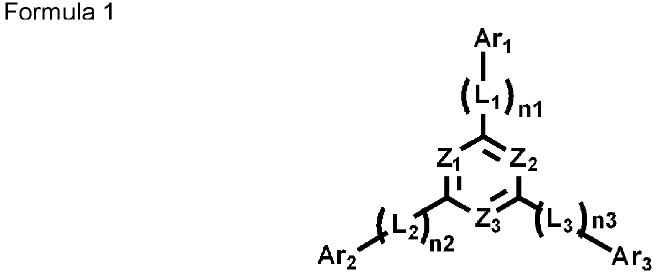 wherein, in Formula 1,
Z₁ to Z₃ are each independently CRₐ or N,
wherein at least one selected from among Z₁ to Z₃ is N, and
Rₐ is a hydrogen atom, a deuterium atom, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms,
Ar₁ to Ar₃ are each independently a substituted or unsubstituted aryl group having 6 to 30 ring-forming carbon atoms, or a substituted or unsubstituted heteroaryl group having 2 to 30 ring-forming carbon atoms, wherein at least one selected from among Ar₁ to Ar₃ is substituted with a cyano group,
L₁ to L₃ are each independently a direct linkage, a substituted or unsubstituted arylene group having 6 to 30 ring-forming carbon atoms, or a substituted or unsubstituted heteroarylene group having 2 to 30 ring-forming carbon atoms, and
n1 to n3 are each independently an integer of 1 to 3, wherein when each of n1 to n3 is independently an integer of 2 or greater, the plurality of L₁ to L₃ are each independently a substituted or unsubstituted arylene group having 6 to 30 ring-forming carbon atoms, or a substituted or unsubstituted heteroarylene group having 2 to 30 ring-forming carbon atoms: 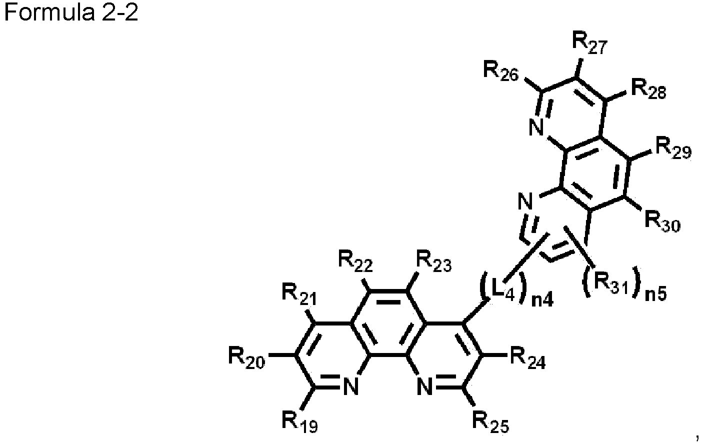 and
wherein, in Formula 2-2,
R₁₉ to R₃₁ are each independently a hydrogen atom, a deuterium atom, a substituted or unsubstituted amine group, a substituted or unsubstituted methyl group, a substituted or unsubstituted phenyl group, a substituted or unsubstituted naphthyl group, a substituted or unsubstituted pyrrole group, a substituted or unsubstituted pyrazole group, a substituted or unsubstituted imidazole group, a substituted or unsubstituted pyrrolidine group, a substituted or unsubstituted isoindoline group, a substituted or unsubstituted carbazole group, or a substituted or unsubstituted triazine group,
L₄ is a substituted or unsubstituted phenylene group,
n4 is an integer of 1 to 3, and
n5 is an integer of 0 to 2.

2. The light emitting device of claim 1, wherein in the mixed layer, a weight ratio of the first compound and the second compound is 5:95 to 95:5.

3. The light emitting device of claim 1 or claim 2, wherein the electron transport region comprises:
an electron transport layer (ETL) on the light emitting layer; and
the mixed layer on the electron transport layer.

4. The light emitting device of claim 3, wherein the electron transport region further comprises an additional layer (AEL) between the mixed layer and the second electrode.

5. The light emitting device of claim 4, wherein the additional layer comprises the second compound represented by Formula 2-2.

6. The light emitting device of claim 4, wherein:
the mixed layer is directly on the electron transport layer; and
the additional layer is directly on the mixed layer.

7. The light emitting device of any one of claims 1 to 6, wherein the mixed layer is composed of the first compound and the second compound.

8. The light emitting device of any one of claims 1 to 7, wherein a thickness of the mixed layer is approximately 1 angstrom (Å) to approximately 30 Å.

9. The light emitting device of any one of claims 1 to 8, wherein the first compound is represented by Formula 1-1: 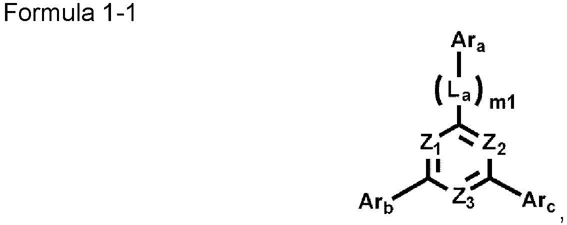 and
wherein, in Formula 1-1,
Arₐ to Ar_{c} are each independently a substituted or unsubstituted phenyl group, a substituted or unsubstituted naphthyl group, a substituted or unsubstituted biphenyl group, a substituted or unsubstituted phenylnaphthyl group, or a substituted or unsubstituted phenylpyridine group, wherein at least one selected from among Arₐ to Ar_{c} is substituted with a cyano group,
Lₐ is a direct linkage, a substituted or unsubstituted phenylene group, a substituted or unsubstituted divalent naphthyl group, a substituted or unsubstituted divalent pyridine group, a substituted or unsubstituted divalent isoquinoline group, or a substituted or unsubstituted divalent phthalazine group,
m1 is an integer of 1 to 3, wherein when m1 is an integer of 2 or greater, a plurality of Lₐ is each independently a substituted or unsubstituted phenylene group, a substituted or unsubstituted divalent naphthyl group, a substituted or unsubstituted divalent pyridine group, a substituted or unsubstituted divalent isoquinoline group, or a substituted or unsubstituted divalent phthalazine group, and
Z₁ to Z₃ are as described in Formula 1.

10. The light emitting device of any one of claims 1 to 8, wherein
in Formula 1, any one selected from among Ar₁ to Ar₃ is a phenyl group substituted with a cyano group, and remaining ones selected from among Ar₁ to Ar₃ are each independently an unsubstituted aryl group having 6 to 30 ring-forming carbon atoms, or an unsubstituted heteroaryl group having 2 to 30 ring-forming carbon atoms.

11. The light emitting device of any one of claims 1 to 10, wherein the first compound comprises at least one selected from among compounds of Compound Group 1:

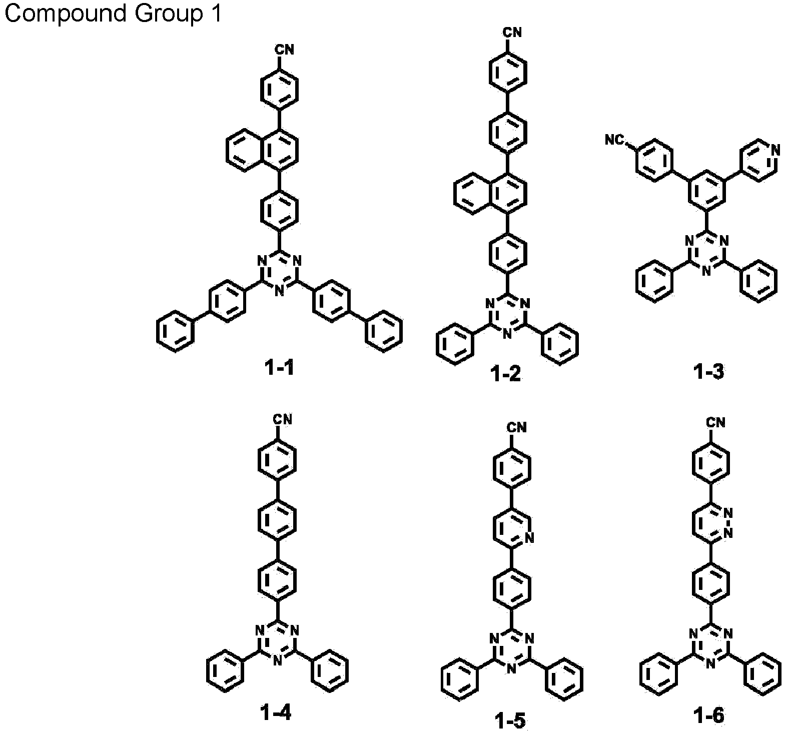

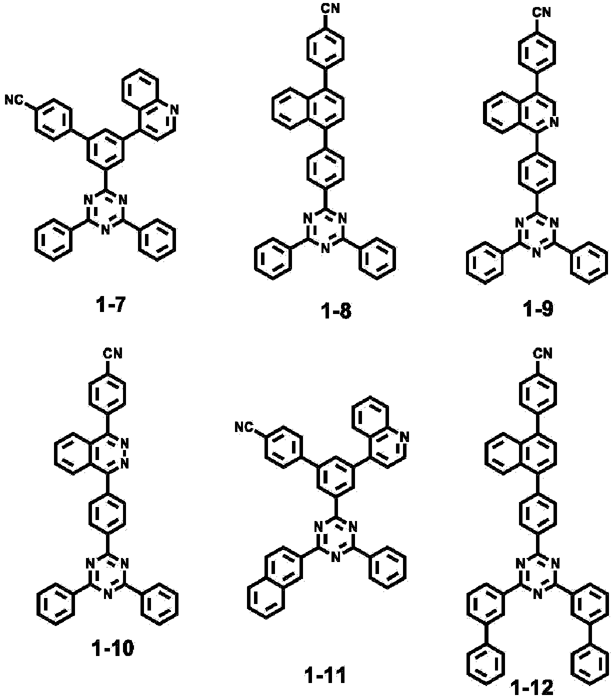

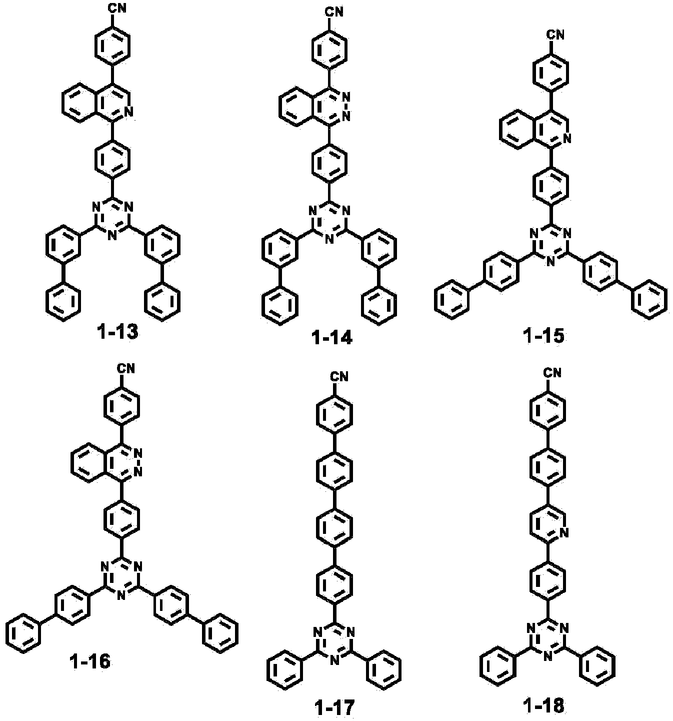

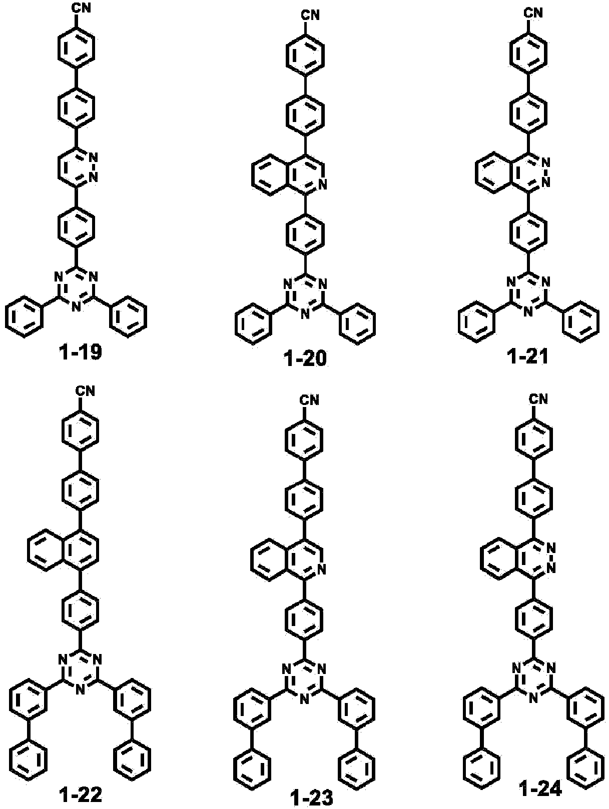

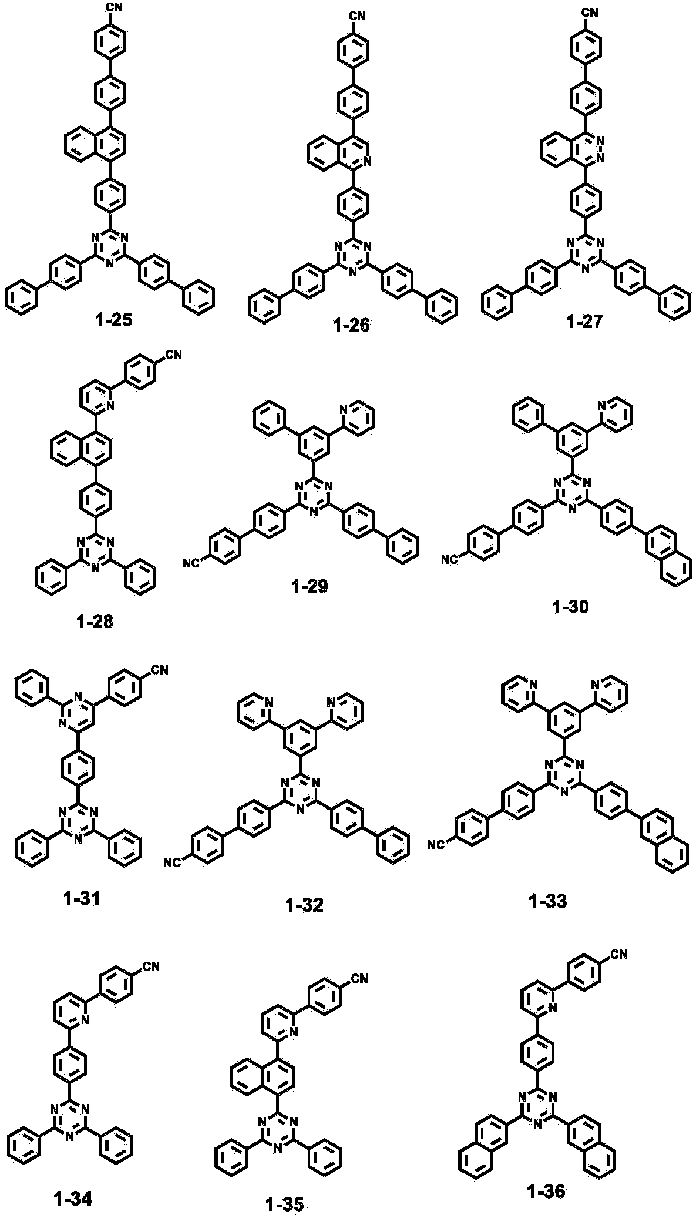

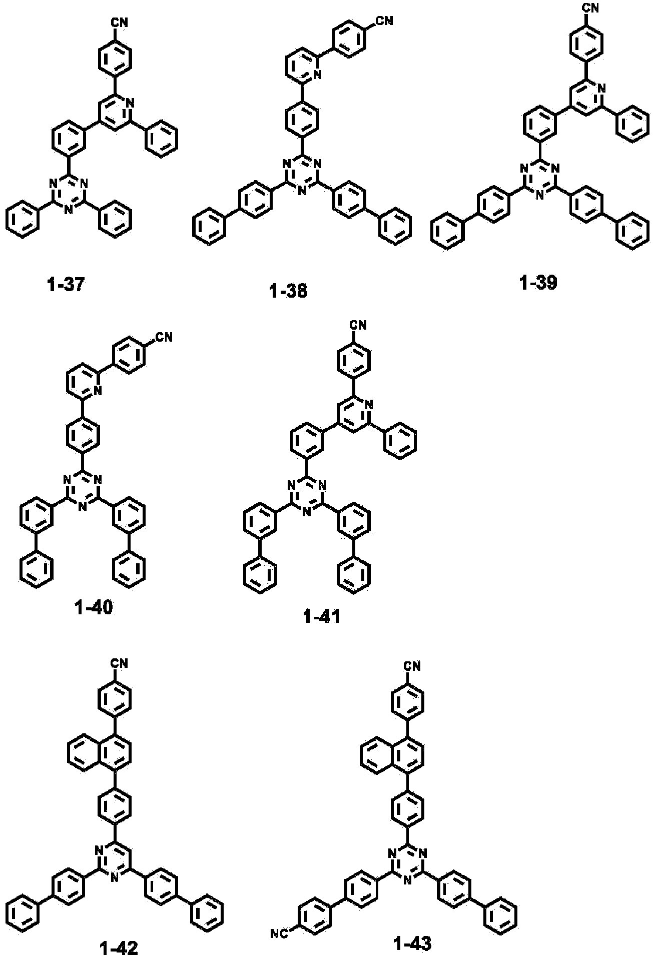

12. The light emitting device of any one of claims 1 to 11, wherein the second compound comprises at least one selected from among compounds of Compound Group 2:

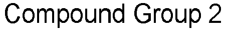

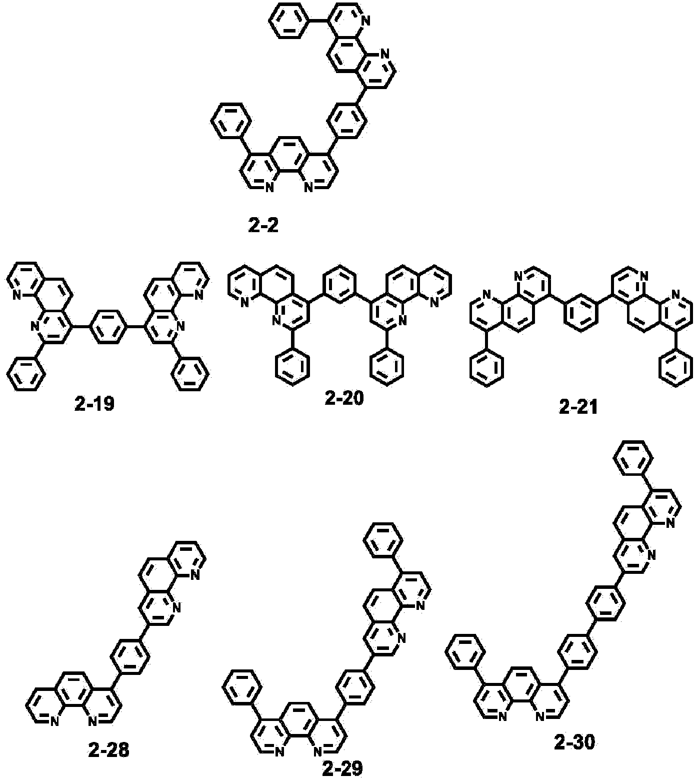

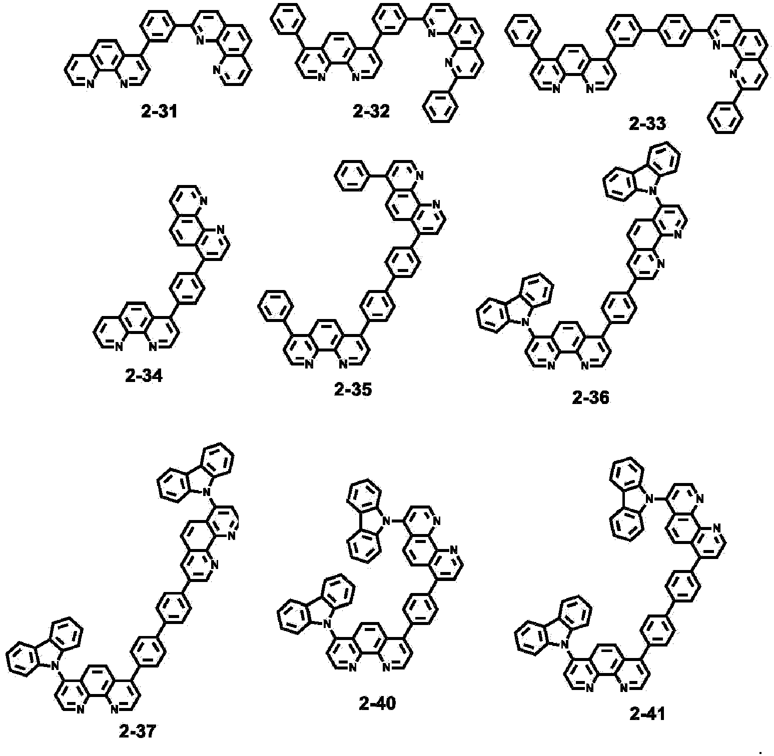

13. A display device (DD) comprising:
a base layer (BS) comprising a plurality of light emitting regions (PXA), and a non-light emitting region (NPXA) adjacent to the plurality of light emitting regions; and a plurality of light emitting devices according to any one of claims 1 to 12 on the base layer and respectively corresponding to the plurality of light emitting regions.

## Patentansprüche

1. Lichtemittierende Vorrichtung (ED), umfassend:
eine erste Elektrode (EL1);
eine Lochleitungsregion (HTR) auf der ersten Elektrode;
eine lichtemittierende Schicht (EML) auf der Lochleitungsregion;
eine Elektronenleitungsregion (ETR) auf der lichtemittierenden Schicht; und
eine zweite Elektrode (EL2) auf der Elektronenleitungsregion,
**dadurch gekennzeichnet, dass**
die Elektronenleitungsregion Folgendes umfasst:
eine Mischschicht (MEL), die eine erste Verbindung, die durch Formel 1 dargestellt ist, und eine zweite Verbindung, die sich von der ersten Verbindung unterscheidet und durch Formel 2-2 dargestellt ist, umfasst: 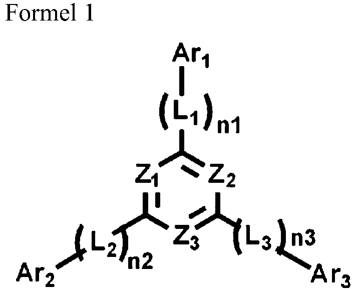 wobei, in Formel 1,
Z₁ bis Z₃ jeweils unabhängig CRₐ oder N sind,
wobei mindestens eines, das ausgewählt ist aus Z₁ bis Z₃, N ist und
Rₐ ein Wasserstoffatom, ein Deuteriumatom, eine substituierte oder unsubstituierte Alkylgruppe mit 1 bis 20 Kohlenstoffen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist,
Ar₁ bis Ar₃ jeweils unabhängig eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind, wobei mindestens eines, das ausgewählt ist aus Ar₁ bis Ar₃, mit einer Cyanogruppe substituiert ist,
L₁ bis L₃ jeweils unabhängig eine direkte Bindung, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen sind und
n1 bis n3 jeweils unabhängig eine ganze Zahl von 1 bis 3 sind, wobei, wenn jedes von n1 bis n3 unabhängig eine ganze Zahl von 2 oder größer ist, die Vielzahl von L₁ bis L₃ jeweils unabhängig eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen sind: 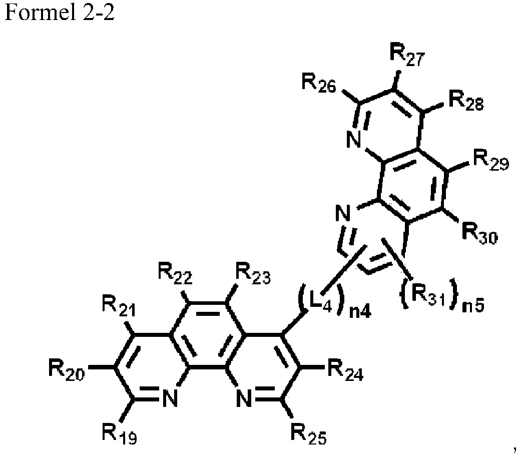 und
wobei, in Formel 2-2,
R₁₉ bis R₃₁ jeweils unabhängig ein Wasserstoffatom, ein Deuteriumatom, eine substituierte oder unsubstituierte Amingruppe, eine substituierte oder unsubstituierte Methylgruppe, eine substituierte oder unsubstituierte Phenylgruppe, eine substituierte oder unsubstituierte Naphthylgruppe, eine substituierte oder unsubstituierte Pyrrolgruppe, eine substituierte oder unsubstituierte Pyrazolgruppe, eine substituierte oder unsubstituierte Imidazolgruppe, eine substituierte oder unsubstituierte Pyrrolidingruppe, eine substituierte oder unsubstituierte Isoindolingruppe, eine substituierte oder unsubstituierte Carbazolgruppe oder eine substituierte oder unsubstituierte Triazingruppe sind,
L₄ eine substituierte oder unsubstituierte Phenylengruppe ist,
n4 eine ganze Zahl von 1 bis 3 ist und
n5 eine ganze Zahl von 0 bis 2 ist.

2. Lichtemittierende Vorrichtung nach Anspruch 1, wobei in der Mischschicht ein Gewichtsverhältnis der ersten Verbindung und der zweiten Verbindung 5:95 bis 95:5 beträgt.

3. Lichtemittierende Vorrichtung nach Anspruch 1 oder Anspruch 2, wobei die Elektronenleitungsregion Folgendes umfasst:
eine Elektronenleitungsschicht (ETL) auf der lichtemittierenden Schicht; und
die Mischschicht auf der Elektronenleitungsschicht.

4. Lichtemittierende Vorrichtung nach Anspruch 3, wobei die Elektronenleitungsregion ferner eine zusätzliche Schicht (AEL) zwischen der Mischschicht und der zweiten Elektrode umfasst.

5. Lichtemittierende Vorrichtung nach Anspruch 4, wobei die zusätzliche Schicht die zweite Verbindung umfasst, die durch die Formel 2-2 dargestellt ist.

6. Lichtemittierende Vorrichtung nach Anspruch 4, wobei:
die Mischschicht direkt auf der Elektronenleitungsschicht liegt; und
die zusätzliche Schicht direkt auf der Mischschicht liegt.

7. Lichtemittierende Vorrichtung nach einem der Ansprüche 1 bis 6, wobei die Mischschicht aus der ersten Verbindung und der zweiten Verbindung zusammengesetzt ist.

8. Lichtemittierende Vorrichtung nach einem der Ansprüche 1 bis 7, wobei eine Dicke der Mischschicht etwa 1 Angström (Å) bis etwa 30 Å beträgt.

9. Lichtemittierende Vorrichtung nach einem der Ansprüche 1 bis 8, wobei die erste Verbindung dargestellt ist durch Formel 1-1: 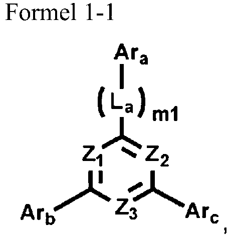 und
wobei, in Formel 1-1,
Arₐ bis Ar_{c} jeweils unabhängig eine substituierte oder unsubstituierte Phenylgruppe, eine substituierte oder unsubstituierte Naphthylgruppe, eine substituierte oder unsubstituierte Biphenylgruppe, eine substituierte oder unsubstituierte Phenylnaphthylgruppe oder eine substituierte oder unsubstituierte Phenylpyridingruppe sind, wobei mindestens eines, das ausgewählt ist aus Arₐ bis Ar_{c}, mit einer Cyanogruppe substituiert ist,
Lₐ eine direkte Bindung, eine substituierte oder unsubstituierte Phenylengruppe, eine substituierte oder unsubstituierte zweiwertige Naphthylgruppe, eine substituierte oder unsubstituierte zweiwertige Pyridingruppe, eine substituierte oder unsubstituierte zweiwertige Isochinolingruppe oder eine substituierte oder unsubstituierte zweiwertige Phthalazingruppe ist;
m1 eine ganze Zahl von 1 bis 3 ist, wobei, wenn m1 eine ganze Zahl von 2 oder größer ist, eine Vielzahl von Lₐ jeweils unabhängig eine substituierte oder unsubstituierte Phenylengruppe, eine substituierte oder unsubstituierte zweiwertige Naphthylgruppe, eine substituierte oder unsubstituierte zweiwertige Pyridingruppe, eine substituierte oder unsubstituierte zweiwertige Isochinolingruppe oder eine substituierte oder unsubstituierte zweiwertige Phthalazingruppe ist und
Z₁ bis Z₃ wie in Formel 1 beschrieben sind.

10. Lichtemittierende Vorrichtung nach einem der Ansprüche 1 bis 8, wobei
in Formel 1 ein Beliebiges, das ausgewählt ist aus Ar₁ bis Ar₃, eine Phenylgruppe ist, die mit einer Cyanogruppe substituiert ist, und die Verbleibenden, die ausgewählt sind aus Ar₁ bis Ar₃, jeweils unabhängig eine unsubstituierte Arylgruppe mit 6 bis 30 ringbildenden Kohlenstoffatomen oder eine unsubstituierte Heteroarylgruppe mit 2 bis 30 ringbildenden Kohlenstoffatomen sind.

11. Lichtemittierende Vorrichtung nach einem der Ansprüche 1 bis 10, wobei die erste Verbindung mindestens eine umfasst, die ausgewählt ist aus Verbindungen der Verbindungsgruppe 1:

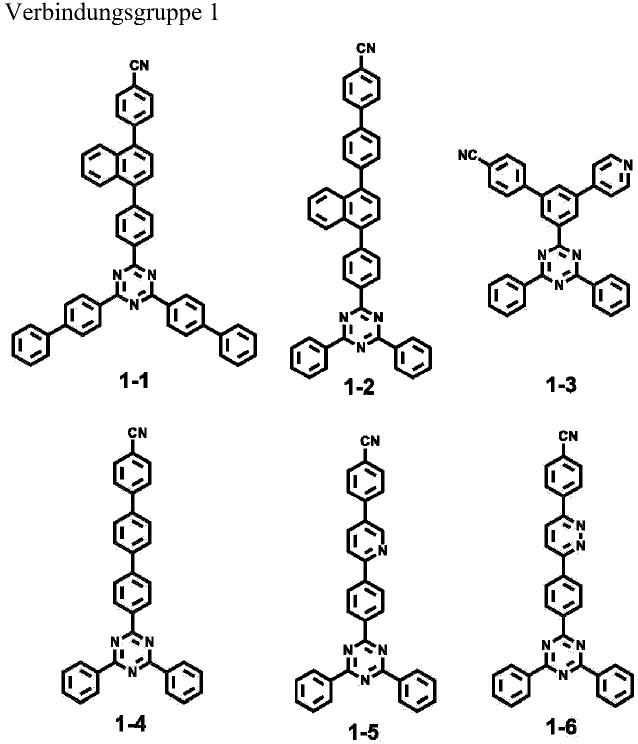

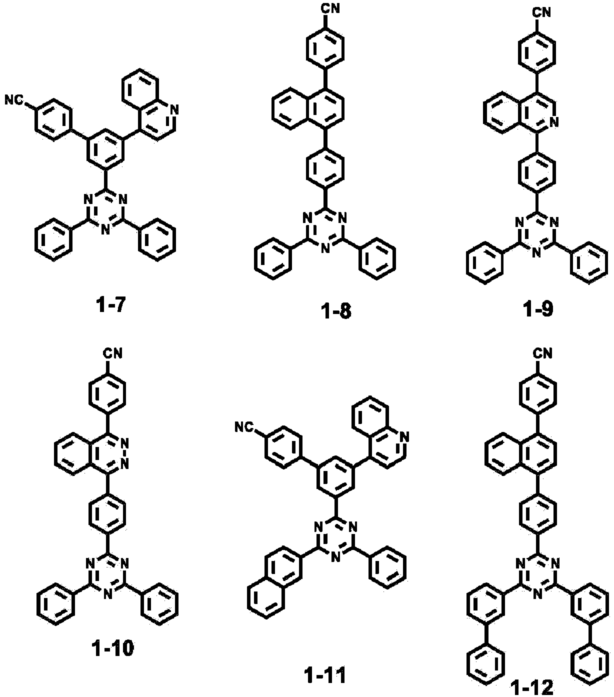

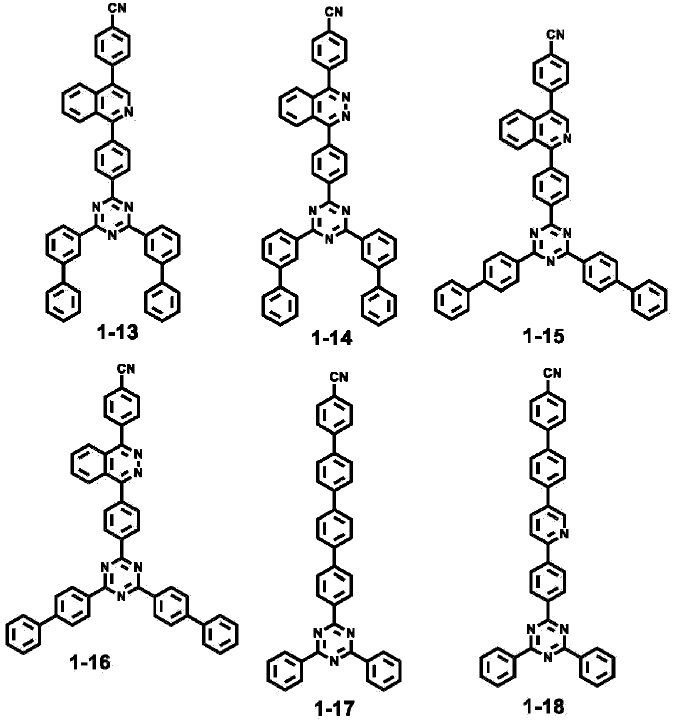

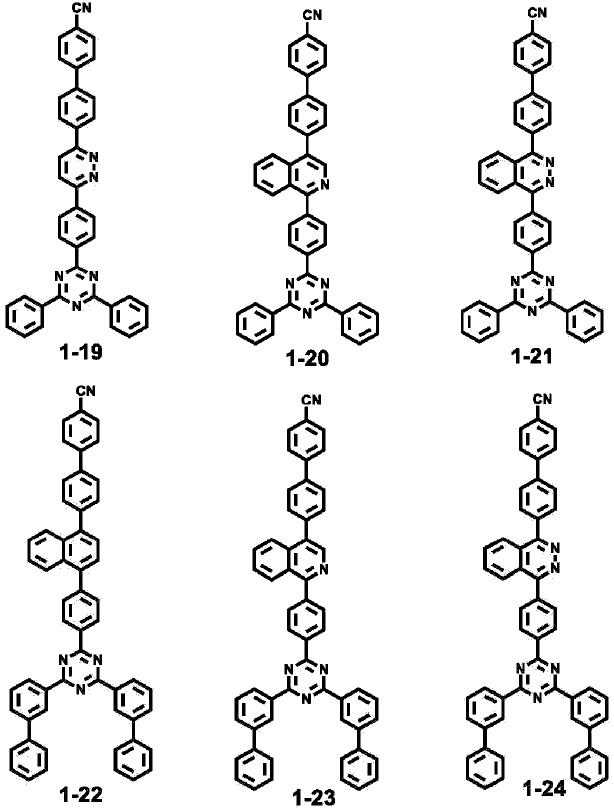

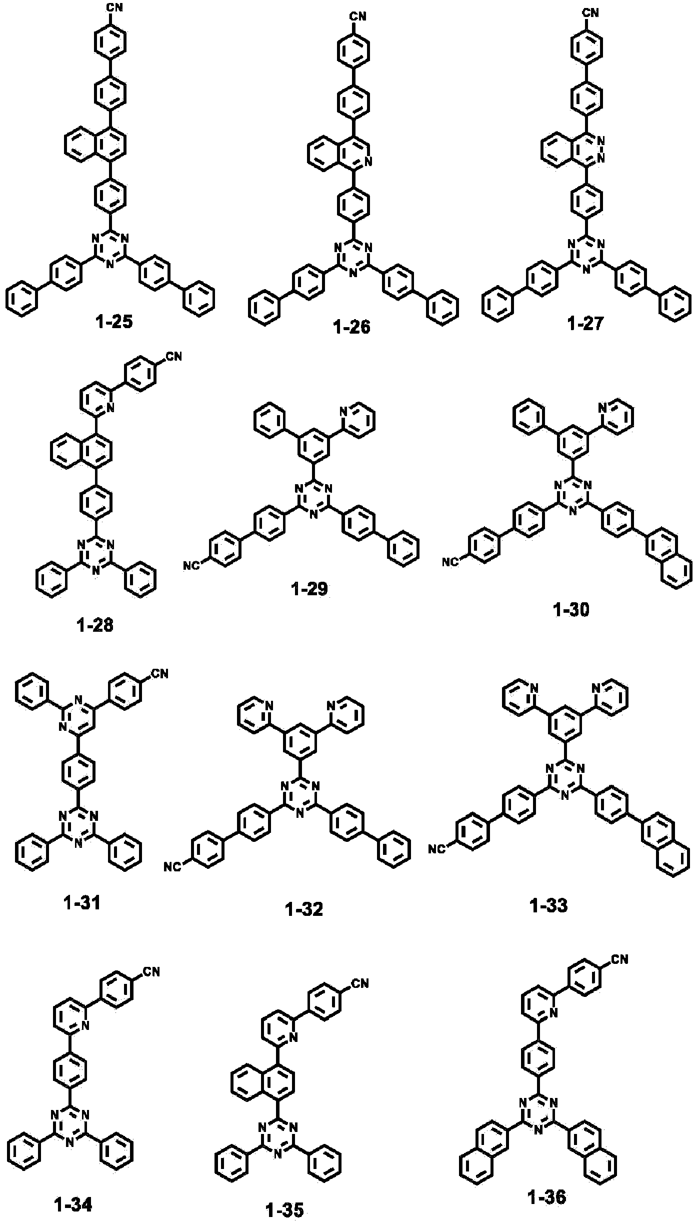

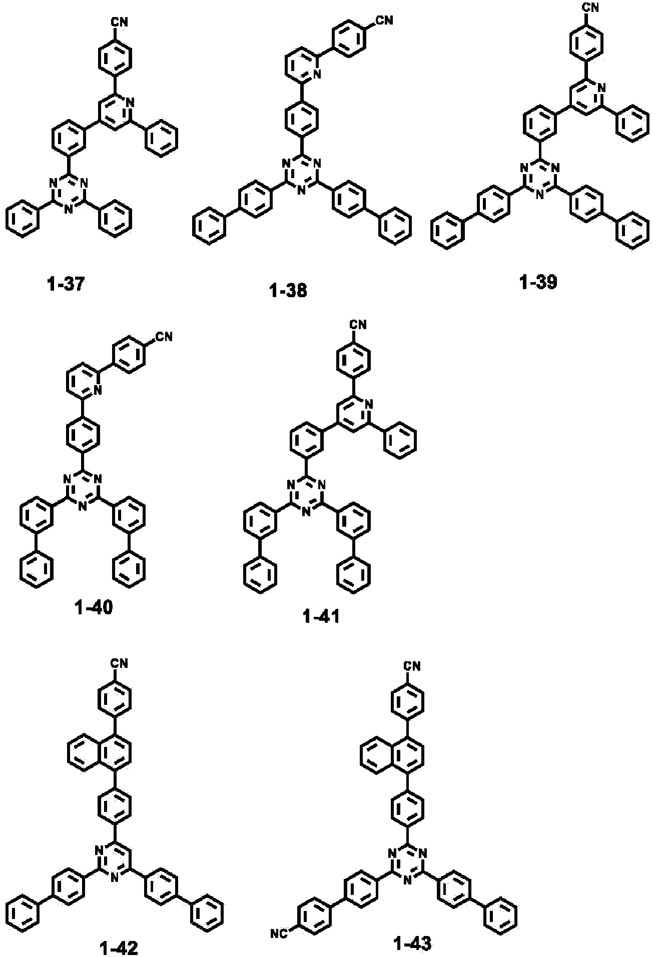

12. Lichtemittierende Vorrichtung nach einem der Ansprüche 1 bis 11, wobei die zweite Verbindung mindestens eine umfasst, die ausgewählt ist aus Verbindungen der Verbindungsgruppe 2:

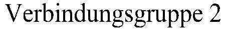

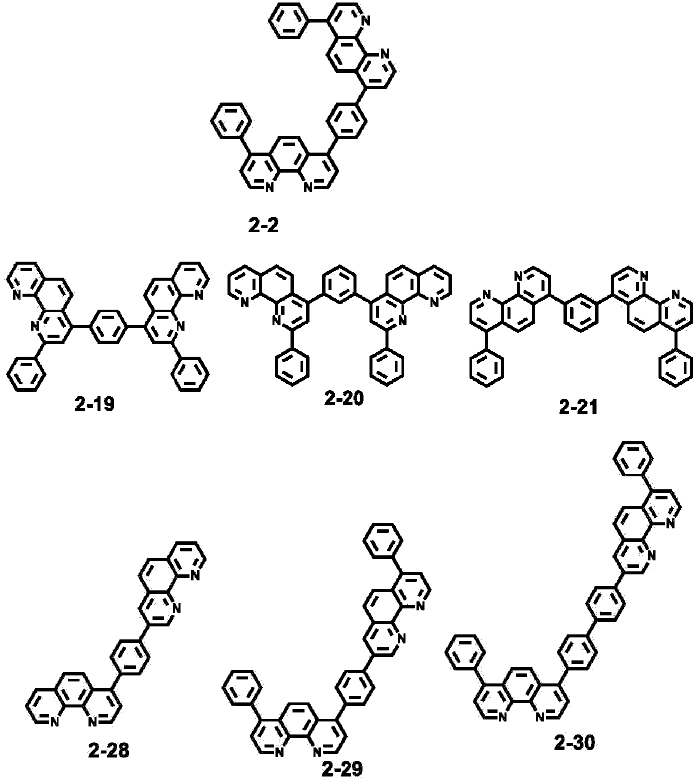

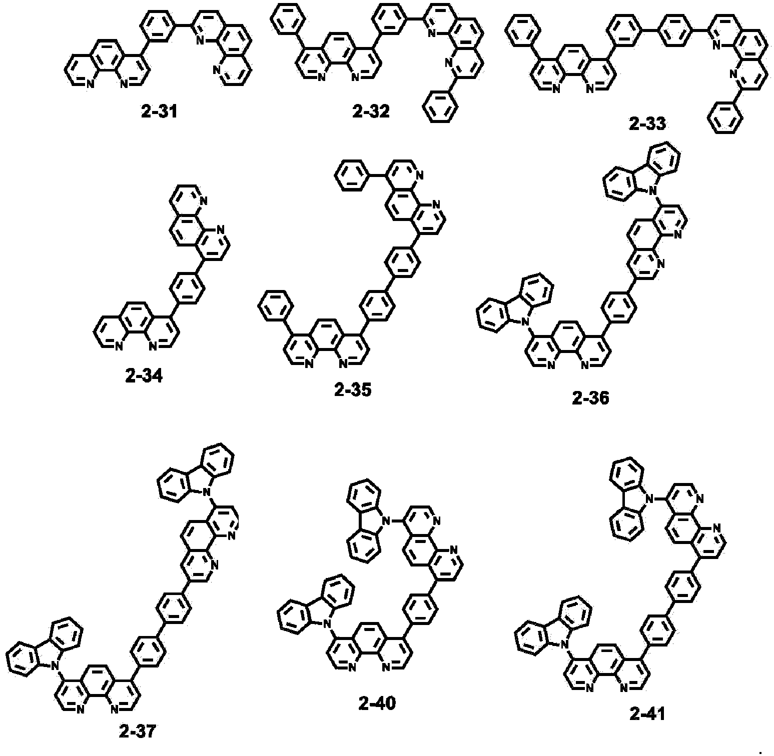

13. Anzeigevorrichtung (DD), umfassend:
eine Basisschicht (BS), die eine Vielzahl von lichtemittierenden Regionen (PXA) und eine nicht lichtemittierende Region (NPXA) benachbart zu der Vielzahl von lichtemittierenden Regionen umfasst; und eine Vielzahl von lichtemittierenden Vorrichtungen nach einem der Ansprüche 1 bis 12 auf der Basisschicht, jeweils der Vielzahl von lichtemittierenden Regionen entsprechend.

## Revendications

1. Dispositif électroluminescent (ED) comprenant :
une première électrode (EL1) ;
une région de transport de trous (HTR) sur la première électrode ;
une couche électroluminescente (EML) sur la région de transport de trous ;
une région de transport d'électrons (ETR) sur la couche électroluminescente ; et
une seconde électrode (EL2) sur la région de transport d'électrons,
**caractérisé en ce que**
la région de transport d'électrons comprend :
une couche mixte (MEL) comprenant un premier composé représenté par la Formule 1 et un second composé différent du premier composé et représenté par la Formule 2-2 : 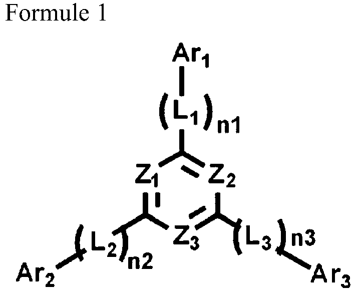 dans lequel, dans la Formule 1,
Z₁ à Z₃ sont chacun indépendamment CRₐ ou N,
dans lequel au moins l'un choisi parmi Z₁ à Z₃ est N, et
Rₐ est un atome d'hydrogène, un atome de deutérium, un groupe alkyle substitué ou non substitué comportant 1 à 20 atomes de carbone, un groupe aryle substitué ou non substitué comportant 6 à 30 atomes de carbone formant un cycle, ou un groupe hétéroaryle substitué ou non substitué comportant 2 à 30 atomes de carbone formant un cycle,
Ar₁ à Ar₃ sont chacun indépendamment un groupe aryle substitué ou non substitué comportant 6 à 30 atomes de carbone formant un cycle, ou un groupe hétéroaryle substitué ou non substitué comportant 2 à 30 atomes de carbone formant un cycle, dans lequel au moins l'un choisi parmi Ar₁ à Ar₃ est substitué par un groupe cyano,
L₁ à L₃ sont chacun indépendamment une liaison directe, un groupe arylène substitué ou non substitué comportant 6 à 30 atomes de carbone formant un cycle, ou un groupe hétéroarylène substitué ou non substitué comportant 2 à 30 atomes de carbone formant un cycle, et
n1 à n3 sont chacun indépendamment un entier de 1 à 3, dans lequel lorsque chacun de n1 à n3 est indépendamment un entier supérieur ou égal à 2, la pluralité de L₁ à L₃ sont chacun indépendamment un groupe arylène substitué ou non substitué comportant 6 à 30 atomes de carbone formant un cycle, ou un groupe hétéroarylène substitué ou non substitué comportant 2 à 30 atomes de carbone formant un cycle : 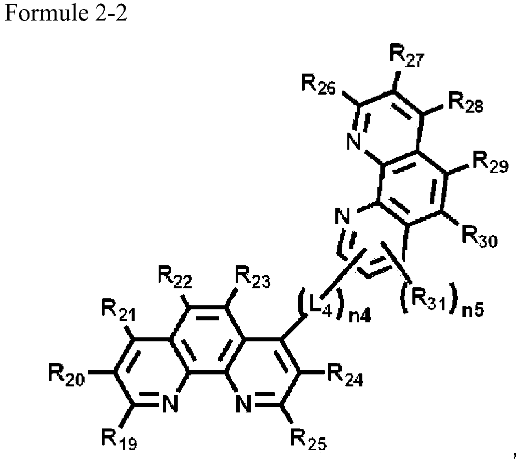 et
dans lequel, dans la Formule 2-2,
R₁₉ à R₃₁ sont chacun indépendamment un atome d'hydrogène, un atome de deutérium, un groupe amine substitué ou non substitué, un groupe méthyle substitué ou non substitué, un groupe phényle substitué ou non substitué, un groupe naphtyle substitué ou non substitué, un groupe pyrrole substitué ou non substitué, un groupe pyrazole substitué ou non substitué, un groupe imidazole substitué ou non substitué, un groupe pyrrolidine substitué ou non substitué, un groupe isoindoline substitué ou non substitué, un groupe carbazole substitué ou non substitué ou un groupe triazine substitué ou non substitué,
L₄ est un groupe phénylène substitué ou non substitué,
n4 est un entier de 1 à 3, et
n5 est un entier de 0 à 2.

2. Dispositif électroluminescent de la revendication 1, dans lequel dans la couche mixte, un rapport pondéral du premier composé et du second composé est de 5:95 à 95:5.

3. Dispositif électroluminescent de la revendication 1 ou la revendication 2, dans lequel la région de transport d'électrons comprend :
une couche de transport d'électrons (ETL) sur la couche électroluminescente ; et
la couche mixte sur la couche de transport d'électrons.

4. Dispositif électroluminescent de la revendication 3, dans lequel la région de transport d'électrons comprend en outre une couche supplémentaire (AEL) entre la couche mixte et la seconde électrode.

5. Dispositif électroluminescent de la revendication 4, dans lequel la couche supplémentaire comprend le second composé représenté par la Formule 2-2.

6. Dispositif électroluminescent de la revendication 4, dans lequel ;
la couche mixte se trouve directement sur la couche de transport d'électrons ; et
la couche supplémentaire se trouve directement sur la couche mixte.

7. Dispositif électroluminescent de l'une quelconque des revendications 1 à 6, dans lequel la couche mixte est composée du premier composé et du second composé.

8. Dispositif électroluminescent de l'une quelconque des revendications 1 à 7, dans lequel l'épaisseur de la couche mixte est d'environ 1 angström (Å) à environ 30 Å.

9. Dispositif électroluminescent de l'une quelconque des revendications 1 à 8, dans lequel le premier composé est représenté par la Formule 1-1 : 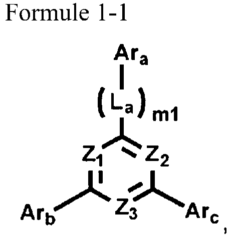 et dans lequel, dans la Formule 1-1,
Arₐ à Ar_{c} sont chacun indépendamment un groupe phényle substitué ou non substitué, un groupe naphtyle substitué ou non substitué, un groupe biphényle substitué ou non substitué, un groupe phénylnaphtyle substitué ou non substitué ou un groupe phénylpyridine substitué ou non substitué, dans lequel au moins l'un choisi parmi Arₐ à Ar_{c} est substitué par un groupe cyano,
Lₐ est une liaison directe, un groupe phénylène substitué ou non substitué, un groupe naphtyle divalent substitué ou non substitué, un groupe pyridine divalent substitué ou non substitué, un groupe isoquinoléine divalent substitué ou non substitué ou un groupe phtalazine divalent substitué ou non substitué,
m1 est un entier de 1 à 3, dans lequel lorsque m1 est un entier supérieur ou égal à 2, une pluralité de Lₐ est chacun indépendamment un groupe phénylène substitué ou non substitué, un groupe naphtyle divalent substitué ou non substitué, un groupe pyridine divalent substitué ou non substitué, un groupe isoquinoléine divalent substitué ou non substitué ou un groupe phtalazine divalent substitué ou non substitué, et
Z₁ à Z₃ sont tels que décrits dans la Formule 1.

10. Dispositif électroluminescent de l'une quelconque des revendications 1 à 8, dans lequel
dans la Formule 1, l'un quelconque choisi parmi Ar₁ à Ar₃ est un groupe phényle substitué par un groupe cyano, et les autres choisis parmi Ar₁ à Ar₃ sont chacun indépendamment un groupe aryle non substitué comportant 6 à 30 atomes de carbone formant un cycle, ou un groupe hétéroaryle non substitué comportant 2 à 30 atomes de carbone formant un cycle.

11. Dispositif électroluminescent de l'une quelconque des revendications 1 à 10, dans lequel le premier composé comprend au moins l'un choisi parmi les composés du Groupe 1 de composés :

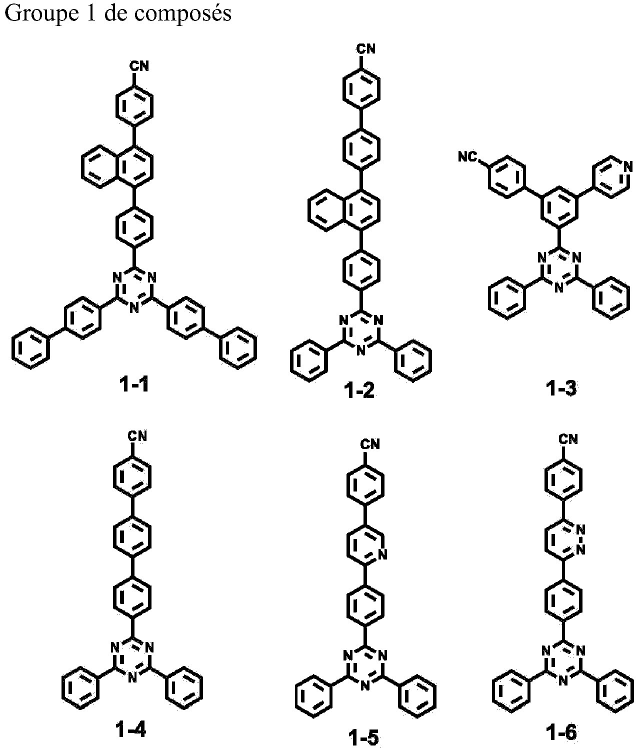

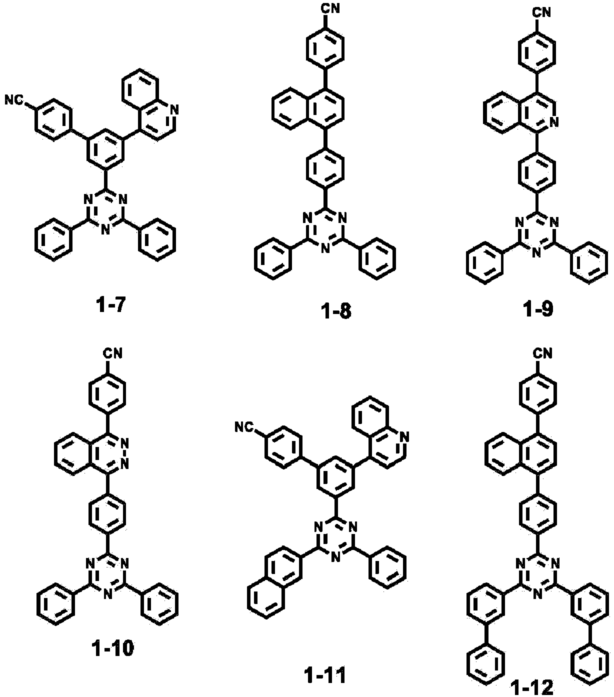

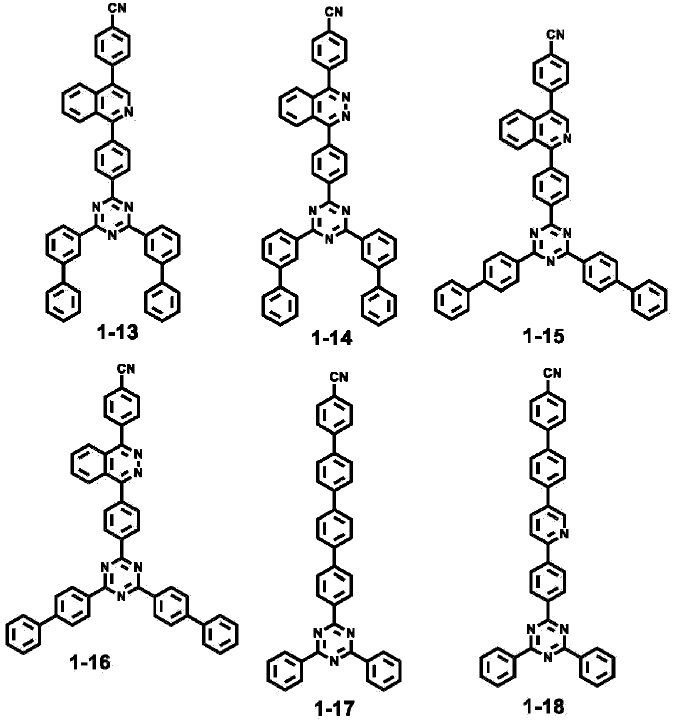

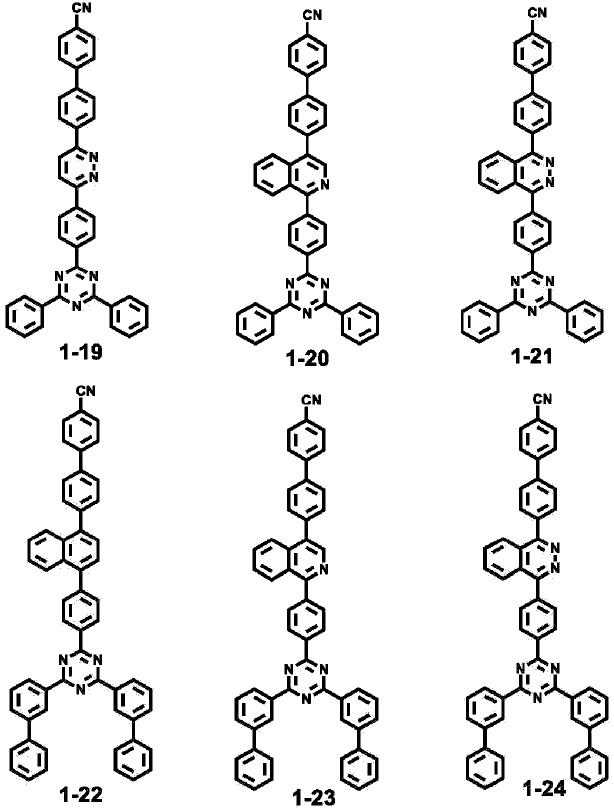

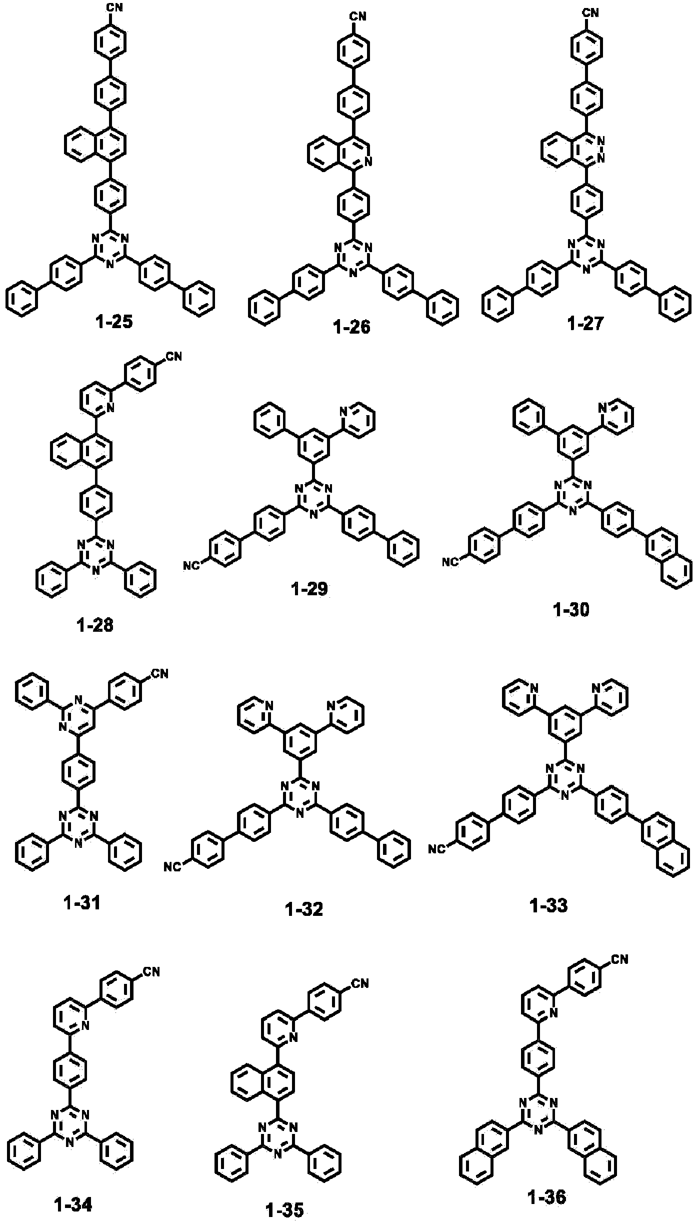

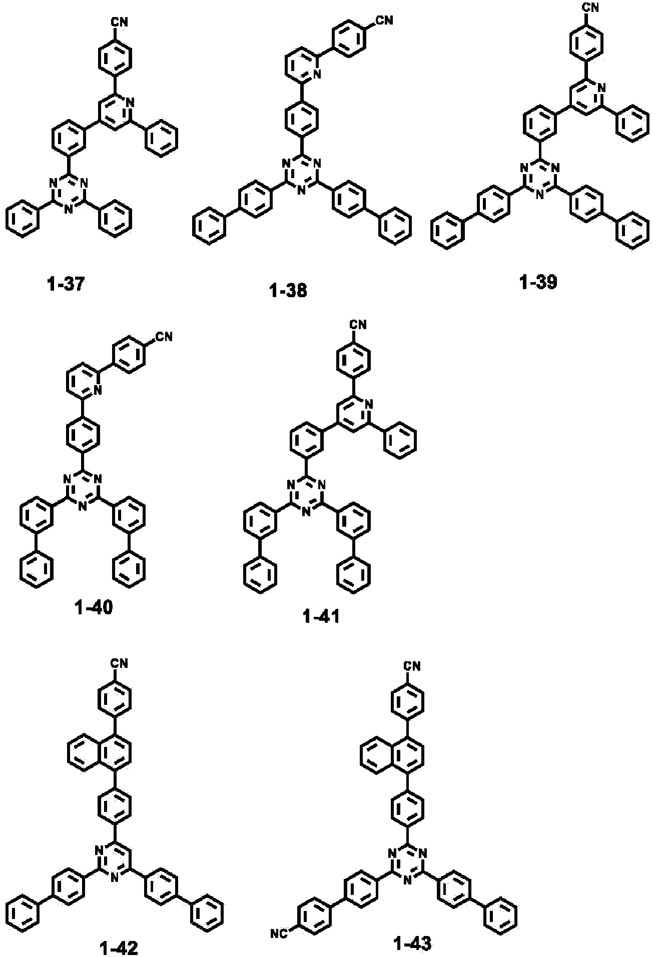

12. Dispositif électroluminescent de l'une quelconque des revendications 1 à 11, dans lequel le second composé comprend au moins l'un choisi parmi les composés du Groupe 2 de composés :

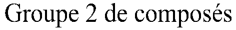

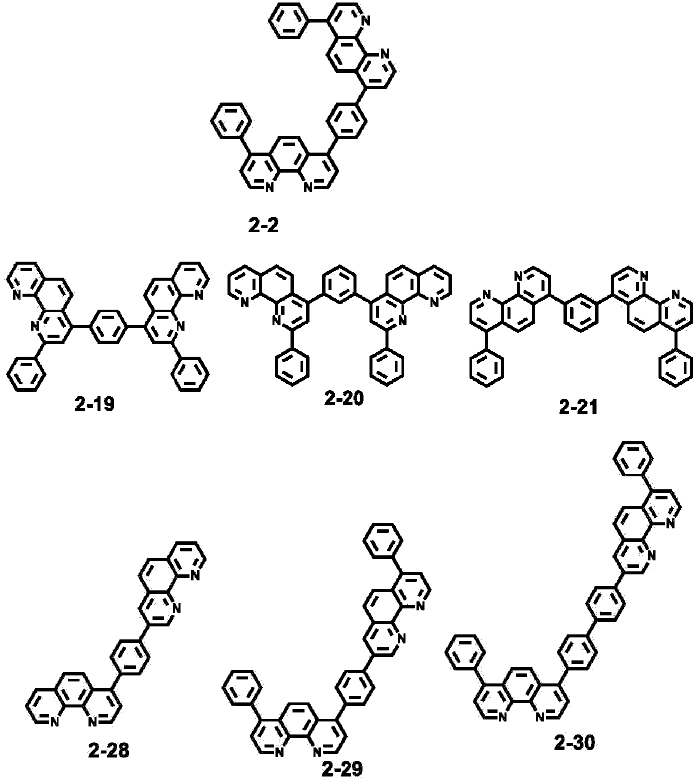

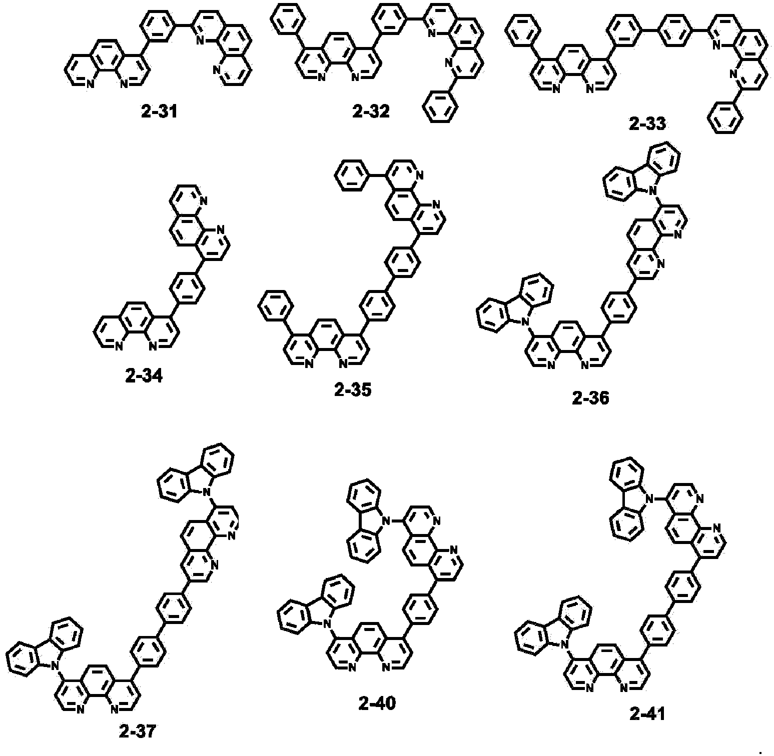

13. Dispositif d'affichage (DD), comprenant :
une couche de base (BS) comprenant une pluralité de régions électroluminescentes (PXA), et une région non électroluminescente (NPXA) adjacente à la pluralité de régions électroluminescentes ; et une pluralité de dispositifs électroluminescents selon l'une quelconque des revendications 1 à 12 sur la couche de base et correspondant respectivement à la pluralité de régions électroluminescentes.
